# EUROPEAN PATENT APPLICATION

(11) **EP 4 660 989 A1**
(43) Date of publication of application: **10.12.2025**
(21) Application number: 24864375.1
(22) Date of filing: 15.08.2024
(51) Int. Cl.: G09G 3/20, G09G 3/3266

(54) **DRIVING CIRCUIT AND DISPLAY APPARATUS**

(30) Priority: 11.09.2023 CN 202311170623
(71) Applicant: Boe Technology Group Co., Ltd., Beijing 100015 (CN)
(72) Inventor: ZHAO, Xiyu, Beijing 100176 (CN); SUN, Tuo, Beijing 100176 (CN); WANG, Li, Beijing 100176 (CN); LIU, Hao, Beijing 100176 (CN)
(74) Representative: Isarpatent
(86) International application number: PCT/CN2024/112223
(87) International publication number: WO 2025/055652

(57) **Abstract**

The present disclosure provides a driving circuit and a display device. The driving circuit includes a driving signal generation circuit, a control signal generation circuit and a control circuit; the driving signal generation circuit generates and outputs an nth stage of driving signal through an nth stage of driving signal output terminal under the control of a first clock signal and a second clock signal; n is a positive integer; the control signal generation circuit is configured to output a control signal to the control signal terminal according to an enable signal; the control circuit outputs a signal to the nth stage of driving output terminal under the control of the control signal. The present disclosure can accurately output an nth stage of driving signal or an invalid voltage signal to the nth stage of driving output terminal, so as to accurately perform partial refresh.

## Description

### CROSS-REFERENCE TO RELATED APPLICATION

The present disclosure claims the priority of the Chinese Application No. 202311170623.9 filed on September 11, 2023, which is incorporated herein by reference in its entirety.

### TECHNICAL FIELD

The present disclosure relates to the field of display technology, in particular to a driving circuit and a display device.

### BACKGROUND

In the related art, the driving circuit usually includes a driving signal generation circuit and a control circuit directly controlled by an enable signal. When the pulse width of the nth stage of driving signal provided by the driving signal generation circuit is 1H (1H is a row of scanning time), the control circuit directly controlled by the enable signal can be configured to control to output the nth stage of driving signal or an invalid voltage signal. However, with the development of pixels, the signals for controlling pixels are diversified, and the pulse width of the nth stage of driving signal will exceed 1H, resulting in the nth stage of driving signal waveform crossing the change edge (rising edge or falling edge) of the enable signal, resulting in only part of the nth stage of driving signal being output, which will cause abnormal pixel operation.

### SUMMARY

In one aspect, the present disclosure provides in some embodiments a driving circuit, including a driving signal generation circuit, a control signal generation circuit and a control circuit; wherein the driving signal generation circuit is electrically connected to a first clock signal line and a second clock signal line respectively, and is configured to generate and output an nth stage of driving signal through an nth stage of driving signal output terminal under the control of a first clock signal provided by the first clock signal line and a second clock signal provided by the second clock signal line; n is a positive integer; the control signal generation circuit is electrically connected to an enable signal line and a control signal terminal respectively, and is configured to output a control signal to the control signal terminal according to an enable signal provided by the enable signal line; the control circuit is electrically connected with the control signal terminal and the nth stage of driving output terminal respectively, and is configured to output a signal to the nth stage of driving output terminal under the control of the control signal.

Optionally, the driving circuit further includes an output inverting circuit; wherein the output inverting circuit is electrically connected to the nth stage of driving signal output terminal, and is configured to invert the nth stage of driving signal to obtain and output an nth stage of inverted driving signal through an nth stage of inverted signal output terminal.

Optionally, the control circuit comprises a first control circuit, a second control circuit and a first energy storage circuit;
the first control circuit is electrically connected to the control signal terminal, the nth stage of driving signal output terminal, a first control voltage line, a second control voltage line and a control output terminal respectively, and is configured to control the connection or disconnection between the control output terminal and the first control voltage line under the control of the control signal, control the connection or disconnection between the control output terminal and the first control voltage line under the control of the nth stage of driving signal output by the nth stage of driving signal output terminal, and control the connection or disconnection between the control output terminal and the second control voltage line under the control of the nth stage of driving signal and the control signal;
the second control circuit is electrically connected to the control output terminal, the nth stage of driving output terminal, a first voltage line and a second voltage line respectively, and is configured to control the connection or disconnection between the nth stage of driving output terminal and the first voltage line, and control the connection or disconnection between the nth stage of driving output terminal and the second voltage line under the control of a potential of the control output terminal;
the first energy storage circuit is electrically connected to the control output terminal and is configured to maintain the potential of the control output terminal.

Optionally, the control circuit further comprises a second energy storage circuit;
the second energy storage circuit is electrically connected to the control signal terminal and is configured to maintain the potential of the control signal terminal.

Optionally, the control signal generation circuit is also electrically connected to an (n-1)th stage of driving signal output terminal, an (n-1)th stage of inverted signal output terminal, the nth stage of driving signal output terminal and the nth stage of inverted signal output terminal, respectively, and is configured to control the connection or disconnection between the enable signal line and the control signal terminal under the control of an (n-1)th stage of driving signal, an (n-1)th stage of inverted driving signal, an (n-1)th stage of driving signal and an nth stage of inverted driving signal.

Optionally, the control signal generation circuit is configured to invert the enable signal to generate an inverted enable signal, and output the inverted enable signal through the control signal terminal.

Optionally, the first control circuit includes a first control transistor, a second control transistor, a third control transistor and a fourth control transistor; the second control circuit includes a fifth control transistor and a sixth control transistor; the first energy storage circuit includes a first capacitor; the first control voltage line is a first voltage line, the second control voltage line is a second voltage line;
a gate electrode of the first control transistor is electrically connected to the nth stage of driving signal output terminal, a first electrode of the first control transistor is electrically connected to the first control voltage line, and a second electrode of the first control transistor is electrically connected to the control output terminal;
a gate electrode of the second control transistor is electrically connected to the control signal terminal, a first electrode of the second control transistor is electrically connected to a second electrode of the fourth control transistor, and a second electrode of the second control transistor is electrically connected to the second control voltage line;
a gate electrode of the third control transistor is electrically connected to the control signal terminal, a first electrode of the third control transistor is electrically connected to the first control voltage line, and a second electrode of the third control transistor is electrically connected to the control output terminal;
a gate electrode of the fourth control transistor is electrically connected to the nth stage of driving signal output terminal, and a first electrode of the fourth control transistor is electrically connected to the control output terminal;
a gate electrode of the fifth control transistor is electrically connected to the control output terminal, a first electrode of the fifth control transistor is electrically connected to the first voltage line, and a second electrode of the fifth control transistor is electrically connected to the nth stage of driving output terminal;
a gate electrode of the sixth control transistor is electrically connected to the control output terminal, a first electrode of the sixth control transistor is electrically connected to the nth stage of driving output terminal, and a second electrode of the sixth control transistor is electrically connected to the second voltage line;
a first terminal of the first capacitor is electrically connected to the control output terminal, and a second terminal of the first capacitor is electrically connected to the second voltage line.

Optionally, the first control circuit includes a first control transistor, a second control transistor, a third control transistor and a fourth control transistor; the second control circuit includes a fifth control transistor and a sixth control transistor; the first energy storage circuit includes a first capacitor; the first control voltage line is a second voltage line, and the second control voltage line is a first voltage line;
a gate electrode of the first control transistor is electrically connected to the control signal terminal, a first electrode of the first control transistor is electrically connected to a second electrode of the third control transistor, and a second electrode of the first control transistor is electrically connected to the control output terminal;
a gate electrode of the second control transistor is electrically connected to the control signal terminal, a first electrode of the second control transistor is electrically connected to the control output terminal, and a second electrode of the second control transistor is electrically connected to the second voltage line;
a gate electrode of the third control transistor is electrically connected to the nth stage of driving signal output terminal, and the first electrode of the third control transistor is electrically connected to the first voltage line;
a gate electrode of the fourth control transistor is electrically connected to the nth stage of driving signal output terminal, a first electrode of the fourth control transistor is electrically connected to the control output terminal, and a second electrode of the fourth control transistor is electrically connected to the second voltage line;
a gate electrode of the fifth control transistor is electrically connected to the control output terminal, a first electrode of the fifth control transistor is electrically connected to the first voltage line, and a second electrode of the fifth control transistor is electrically connected to the nth stage of driving output terminal;
a gate electrode of the sixth control transistor is electrically connected to the control output terminal, a first electrode of the sixth control transistor is electrically connected to the nth stage of driving output terminal, and a second electrode of the sixth control transistor is electrically connected to the second voltage line;
a first terminal of the first capacitor is electrically connected to the control output terminal, and a second terminal of the first capacitor is electrically connected to the second voltage line.

Optionally, the second energy storage circuit comprises a second capacitor;
a first terminal of the second capacitor is electrically connected to the control signal terminal, and a second terminal of the second capacitor is electrically connected to the second voltage line.

Optionally, the control signal generation circuit includes a seventh control transistor, an eighth control transistor, a ninth control transistor and a tenth control transistor;
a gate electrode of the seventh control transistor is electrically connected to the (n-1)th stage of driving signal output terminal, a first electrode of the seventh control transistor is electrically connected to the enable signal line, and a second electrode of the seventh control transistor is electrically connected to a first electrode of the tenth control transistor;
a gate electrode of the eighth control transistor is electrically connected to the (n-1)th stage of inverted signal output terminal, a first electrode of the eighth control transistor is electrically connected to the enable signal line, and a second electrode of the eighth control transistor is electrically connected to a first electrode of the ninth control transistor;
a gate electrode of the ninth control transistor is electrically connected to the nth stage of driving signal output terminal, the first electrode of the ninth control transistor is electrically connected to a first electrode of the tenth control transistor, and a second electrode of the ninth control transistor is electrically connected to the control signal terminal;
a gate electrode of the tenth control transistor is electrically connected to the nth stage of inverted signal output terminal, and a second electrode of the tenth control transistor is electrically connected to the control signal terminal;
the seventh control transistor and the tenth control transistor are both n-type transistors, and the eighth control transistor and the ninth control transistor are both p-type transistors; or,
the seventh control transistor and the tenth control transistor are both p-type transistors, and the eighth control transistor and the ninth control transistor are both n-type transistors.

Optionally, the control signal generation circuit comprises a seventh control transistor and an eighth control transistor;
a gate electrode of the seventh control transistor is electrically connected to the enable signal line, a first electrode of the seventh control transistor is electrically connected to the first voltage line, and a second electrode of the seventh control transistor is electrically connected to the control signal terminal;
a gate electrode of the eighth control transistor is electrically connected to the enable signal line, a first electrode of the eighth control transistor is electrically connected to the control signal terminal, and a second electrode of the eighth control transistor is electrically connected to the second voltage line;
the seventh control transistor is a p-type transistor, and the eighth control transistor is an n-type transistor; or, the seventh control transistor is an n-type transistor, and the eighth control transistor is a p-type transistor.

Optionally, the output inverting circuit comprises an eleventh control transistor and a twelfth control transistor;
a gate electrode of the eleventh control transistor is electrically connected to the nth stage of driving signal output terminal, a first electrode of the eleventh control transistor is electrically connected to the nth stage of inverted signal output terminal, and a second electrode of the eleventh control transistor is electrically connected to the second voltage line;
a gate electrode of the twelfth control transistor is electrically connected to the nth stage of driving signal output terminal, a first electrode of the twelfth control transistor is electrically connected to the first voltage line, and a second electrode of the twelfth control transistor is electrically connected to the nth stage of inverted signal output terminal.

Optionally, the driving signal generation circuit includes a first node control circuit, a second node control circuit, a first output node control circuit, a second output node control circuit, a potential maintaining circuit and an output circuit; the first clock signal line includes a first first clock signal line, and the second clock signal line includes a first second clock signal line;
the first node control circuit is electrically connected to a first node, the first first clock signal line, a second voltage line, and a second output node, respectively, and is configured to control the connection between the first node and the second voltage line under the control of a first clock signal provided by the first first clock signal line, and to control the connection or disconnection between the first node and the first first clock signal line under the control of a potential of the second output node;
the second node control circuit is electrically connected to the first node, a first intermediate node, a first voltage line, a first second clock signal line, a second node, an input terminal and a second voltage line respectively, and is configured to control the first intermediate node to be connected to the first voltage line under the control of the potential of the first node, control the first intermediate node to be connected to the first second clock signal line under the control of a potential of the second node, and control the potential of the second node according to the potential of the first intermediate node, and control the input terminal to be connected to the second node under the control of the second clock signal provided by the first second clock signal line and the second voltage signal provided by the second voltage line;
the first output node control circuit is electrically connected to a first output node, the first node, the first second clock signal line, a second intermediate node, a second output node and a first voltage line respectively, and is configured to control the second intermediate node to be connected to the first second clock signal line under the control of the potential of the first node, control the potential of the second intermediate node according to the potential of the first node, control the second intermediate node to be connected to the first output node under the control of the second clock signal provided by the first second clock signal line, and control the first output node to be connected to the first voltage line under the control of the potential of the second output node;
the second output node control circuit is electrically connected to the first second clock signal line, the input terminal, the control voltage line, the first voltage line, the second node, and the second output node, respectively, and is configured to control the second output node to be connected to the input terminal under the control of the second clock signal provided by the first second clock signal line, control the potential of the second output node according to the potential of the second node, and control the second output node to be connected to the first voltage line under the control of the control voltage provided by the control voltage line;
the potential maintaining circuit is electrically connected to the first output node, and is configured to maintain the potential of the first output node;
the output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and control the connection between the nth stage of driving signal output terminal and the second voltage line under the control of the potential of the second output node.

Optionally, the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the first first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the first first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the first first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
the second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the first second clock signal line, and a second electrode of the eighth transistor is electrically connected to the first intermediate node;
a gate electrode of the ninth transistor is electrically connected to the second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the first first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
the first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the first second clock signal line, and a second electrode of the twelfth transistor is electrically connected to the second intermediate node;
a gate electrode of the thirteenth transistor is electrically connected to the first second clock signal line, a first electrode of the thirteenth transistor is electrically connected to the second intermediate node, and a second electrode of the thirteenth transistor is electrically connected to the first output node;
a gate electrode of the fourteenth transistor is electrically connected to the first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and a second electrode plate of the fourth capacitor is electrically connected to the second intermediate node;
the potential maintaining circuit includes a fifth capacitor;
a first electrode plate of the fifth capacitor is electrically connected to the first output node, and a second electrode plate of the fifth capacitor is electrically connected to the first voltage line;
the output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
a gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

Optionally, the driving signal generation circuit includes a first node control circuit, a second node control circuit, a first output node control circuit, a second output node control circuit, a potential maintaining circuit and an output circuit; the first clock signal line includes a second first clock signal line, and the second clock signal line includes a second second clock signal line;
the first node control circuit is electrically connected to the first node, the second first clock signal line, the second voltage line, and the second output node, respectively, and is configured to control the connection between the first node and the second voltage line under the control of the first clock signal provided by the second first clock signal line, and to control the connection or disconnection between the first node and the second first clock signal line under the control of the potential of the second output node;
the second node control circuit is electrically connected to the first node, the first intermediate node, the first voltage line, the second second clock signal line, the second node, the input terminal and the second voltage line respectively, and is configured to control the connection between the first intermediate node and the first voltage line under the control of the potential of the first node, control the connection between the first intermediate node and the second second clock signal line under the control of the potential of the second node, and control the potential of the second node according to the potential of the first intermediate node, and control the connection between the input terminal and the second node under the control of the second clock signal provided by the second second clock signal line and the second voltage signal provided by the second voltage line;
the first output node control circuit is electrically connected to the first output node, the first node, the second second clock signal line, the second intermediate node, the second output node and the first voltage line respectively, and is configured to control the second intermediate node to be connected to the second second clock signal line under the control of the potential of the first node, control the potential of the second intermediate node according to the potential of the first node, control the second intermediate node to be connected to the first output node under the control of the second clock signal provided by the second second clock signal line, and control the first output node to be connected to the first voltage line under the control of the potential of the second output node;
the second output node control circuit is electrically connected to the second second clock signal line, the input terminal, the control voltage line, the first voltage line, the second node, and the second output node, respectively, and is configured to control the second output node to be connected to the input terminal under the control of the second clock signal provided by the second second clock signal line, control the potential of the second output node according to the potential of the second node, and control the second output node to be connected to the first voltage line under the control of the control voltage provided by the control voltage line;
the potential maintaining circuit is electrically connected to the first output node, and is configured to maintain the potential of the first output node;
the output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

Optionally, the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the second first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the second first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the second first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
the second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the second second clock signal line, and a second electrode of the eighth transistor is electrically connected to the first intermediate node;
a gate electrode of the ninth transistor is electrically connected to a second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the second first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
the first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the second second clock signal line, and a second electrode of the twelfth transistor is electrically connected to the second intermediate node;
a gate electrode of the thirteenth transistor is electrically connected to the second second clock signal line, a first electrode of the thirteenth transistor is electrically connected to the second intermediate node, and a second electrode of the thirteenth transistor is electrically connected to the first output node;
a gate electrode of the fourteenth transistor is electrically connected to a first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and the second electrode plate of the fourth capacitor is electrically connected to the second intermediate node;
the potential maintaining circuit includes a fifth capacitor;
a first electrode plate of the fifth capacitor is electrically connected to the first output node, and a second electrode plate of the fifth capacitor is electrically connected to the first voltage line;
the output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
a gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

Optionally, the driving signal generation circuit includes a first output node control circuit, a second output node control circuit, a third energy storage circuit and an output circuit; the first clock signal line includes a third first clock signal line, and the second clock signal line includes a third second clock signal line;
the first output node control circuit is electrically connected to the third first clock signal line, the second voltage line and the second output node respectively, and is configured to control the first output node to be connected to the second voltage line under the control of the first clock signal provided by the third first clock signal line, and to control the first output node to be connected to the third first clock signal line under the control of the potential of the second output node, and to maintain the potential of the first output node;
the second output node control circuit is electrically connected to the second output node, the third first clock signal line, the input terminal, the third second clock signal line, the first output node and the first voltage line respectively, and is configured to control the second output node to be connected to the input terminal under the control of the first clock signal, and to control the second output node to be connected to the first voltage line under the control of the potential of the first output node and the second clock signal provided by the third second clock signal line;
a first terminal of the third energy storage circuit is electrically connected to the second output node, a second terminal of the third energy storage circuit is electrically connected to the nth stage of driving signal output terminal, and the third energy storage circuit is configured to store electric energy;
the output circuit is electrically connected to the first output node, the second output node, the first voltage line, the second clock signal and the nth stage of driving signal output terminal, respectively, and is configured to control the connection between the nth stage of driving signal output terminal and the first voltage line under the control of the potential of the first output node, and to control the connection between the nth stage of driving signal output terminal and the third second clock signal line under the control of the potential of the second output node.

Optionally, the first output node control circuit includes a seventeenth transistor, an eighteenth transistor and a sixth capacitor;
a gate electrode of the seventeenth transistor is electrically connected to the third first clock signal line, a first electrode of the seventeenth transistor is electrically connected to the second voltage line, and a second electrode of the seventeenth transistor is electrically connected to the first output node;
a gate electrode of the eighteenth transistor is electrically connected to the second output node, a first electrode of the eighteenth transistor is electrically connected to the third first clock signal line, and a second electrode of the eighteenth transistor is electrically connected to the first output node;
a first electrode plate of the sixth capacitor is electrically connected to the first output node, and a second electrode plate of the sixth capacitor is electrically connected to the first voltage line;
the second output node control circuit includes a nineteenth transistor, a twentieth transistor, and a twenty first transistor; the third energy storage circuit includes a seventh capacitor;
a gate electrode of the nineteenth transistor is electrically connected to the third first clock signal line, a first electrode of the nineteenth transistor is electrically connected to the input terminal, and a second electrode of the nineteenth transistor is electrically connected to the second output node;
a gate electrode of the twentieth transistor is electrically connected to the first output node, a first electrode of the twentieth transistor is electrically connected to the first voltage line, and a second electrode of the twentieth transistor is electrically connected to a first electrode of the twenty first transistor;
a gate electrode of the twenty first transistor is electrically connected to the third second clock signal line, and a second electrode of the twenty first transistor is electrically connected to the second output node;
a first electrode plate of the seventh capacitor is electrically connected to the second output node, and a second electrode plate of the seventh capacitor is electrically connected to the nth stage of driving signal output terminal;
the output circuit includes a twenty second transistor and a twenty third transistor;
a gate electrode of the twenty second transistor is electrically connected to the first output node, a first electrode of the twenty second transistor is electrically connected to the first voltage line, and a second electrode of the twenty second transistor is electrically connected to the nth stage of driving signal output terminal;
a gate electrode of the twenty third transistor is electrically connected to the second output node, a first electrode of the twenty third transistor is electrically connected to the nth stage of driving signal output terminal, and a second electrode of the twenty third transistor is electrically connected to the third second clock signal line;
the driving circuit further includes a twenty fourth transistor;
a second electrode of the twenty first transistor is electrically connected to the second output node through the twenty fourth transistor; a gate electrode of the twenty fourth transistor is electrically connected to the second voltage line, a first electrode of the twenty fourth transistor is electrically connected to a second electrode of the twenty first transistor, and a second electrode of the twenty fourth transistor is electrically connected to the second output node.

In at least one embodiment of the present disclosure, the display substrate includes a base substrate and the driving circuit arranged on the base substrate;
The display substrate includes a display area and a peripheral area; the driving circuit is arranged in the peripheral area.

Optionally, the driving circuit further includes an output inverting circuit;
The output inverting circuit is electrically connected to the nth stage of driving signal output terminal and the nth stage of inverted signal output terminal respectively, and is configured to invert the nth stage of driving signal to obtain and output the nth stage of inverted driving signal through the nth stage of inverted signal output terminal;
The control signal generation circuit is also electrically connected to the (n-1)th stage of driving signal output terminal, the (n-1)th stage of inverted signal output terminal, the nth stage of driving signal output terminal and the nth stage of inverted signal output terminal respectively, and is configured to generate a control signal according to an enable signal provided by an enable signal line under the control of the (n-1)th stage of driving signal, the (n-1)th stage of inverted signal, the nth stage of driving signal and the nth stage of inverted signal;
The (n-1)th stage of driving signal output terminal is configured to provide the (n-1)th stage of driving signal, and the (n-1)th stage of inverted signal output terminal is configured to provide the (n-1)th stage of inverted signal;
The control signal generation circuit is arranged on a side of the driving signal generation circuit close to the display area.

Optionally, the control circuit in the driving circuit includes a first control circuit, a second control circuit and a first energy storage circuit; the control circuit is arranged on a side of the driving signal generation circuit close to the display area;
The first control circuit is electrically connected to the control signal terminal, the nth driving signal output terminal, the first control voltage line, the second control voltage line and the control output terminal respectively, and is configured to control the control output terminal to be connected to the first control voltage line under the control of the control signal, to control the control output terminal to be connected or disconnected from the first control voltage line under the control of the nth stage of driving signal, and to control the control output terminal to be connected or disconnected from the second control voltage line under the control of the nth stage of driving signal and the control signal;
The second control circuit is electrically connected to the control output terminal, the nth stage of driving output terminal, the first voltage line and the second voltage line respectively, and is configured to control the connection or disconnection between the nth stage of driving output terminal and the first voltage line, and control the connection or disconnection between the nth stage of driving output terminal and the second voltage line under the control of the potential of the control output terminal;
The first energy storage circuit is electrically connected to the control output terminal and is configured to maintain the potential of the control output terminal;
The first control voltage line is the first voltage line, and the second control voltage line is the second voltage line; or, the first control voltage line is the second voltage line, and the second control voltage line is the first voltage line.

Optionally, the control circuit further includes a second energy storage circuit;
The second energy storage circuit is electrically connected to the control signal terminal and is configured to maintain the potential of the control signal terminal;
The second energy storage circuit is arranged on a side of the second control circuit away from the display area.

Optionally, the driving signal generation circuit includes a first node control circuit, a second node control circuit, a first output node control circuit, a second output node control circuit, a potential maintaining circuit and an output circuit;
The first node control circuit is electrically connected to the first node, the first first clock signal line, the second voltage line, and the second output node, respectively, and is configured to control the connection between the first node and the second voltage line under the control of the first clock signal provided by the first first clock signal line, and to control the connection or disconnection between the first node and the first first clock signal line under the control of the potential of the second output node;
The second node control circuit is electrically connected to the first node, the first intermediate node, the first voltage line, the first second clock signal line, the second node, the input terminal and the second voltage line respectively, and is configured to control the first intermediate node to be connected to the first voltage line under the control of the potential of the first node, control the first intermediate node to be connected to the first second clock signal line under the control of the potential of the second node, and control the potential of the second node according to the potential of the first intermediate node, and control the input terminal to be connected to the second node under the control of the second clock signal provided by the first second clock signal line and the second voltage signal provided by the second voltage line;
The first output node control circuit is electrically connected to the first output node, the first node, the first second clock signal line, the second intermediate node, the second output node and the first voltage line respectively, and is configured to control the second intermediate node to be connected to the first second clock signal line under the control of the potential of the first node, control the potential of the second intermediate node according to the potential of the first node, control the second intermediate node to be connected to the first output node under the control of the second clock signal provided by the first second clock signal line, and control the first output node to be connected to the first voltage line under the control of the potential of the second output node;
The second output node control circuit is electrically connected to the first second clock signal line, the input terminal, the control voltage line, the first voltage line, the second node, and the second output node, respectively, and is configured to control the second output node to be connected to the input terminal under the control of the second clock signal provided by the first second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

Optionally, the driving signal generation circuit includes a first node control circuit, a second node control circuit, a first output node control circuit, a second output node control circuit, a potential maintaining circuit and an output circuit;
The first node control circuit is electrically connected to the first node, the second first clock signal line, the second voltage line, and the second output node, respectively, and is configured to control the connection between the first node and the second voltage line under the control of the first clock signal provided by the second first clock signal line, and to control the connection or disconnection between the first node and the second first clock signal line under the control of the potential of the second output node;
The second node control circuit is electrically connected to the first node, the first intermediate node, the first voltage line, the second second clock signal line, the second node, the input terminal and the second voltage line respectively, and is configured to control the connection between the first intermediate node and the first voltage line under the control of the potential of the first node, control the connection between the first intermediate node and the second second clock signal line under the control of the potential of the second node, and control the potential of the second node according to the potential of the first intermediate node, and control the connection between the input terminal and the second node under the control of the second clock signal provided by the second second clock signal line and the second voltage signal provided by the second voltage line;
The first output node control circuit is electrically connected to the first output node, the first node, the second second clock signal line, the second intermediate node, the second output node and the first voltage line respectively, and is configured to control the second intermediate node to be connected to the second second clock signal line under the control of the potential of the first node, control the potential of the second intermediate node according to the potential of the first node, control the second intermediate node to be connected to the first output node under the control of the second clock signal provided by the second second clock signal line, and control the first output node to be connected to the first voltage line under the control of the potential of the second output node;
The second output node control circuit is electrically connected to the second second clock signal line, the input terminal, the control voltage line, the first voltage line, the second node, and the second output node, respectively, and is configured to control the second output node to be connected to the input terminal under the control of the second clock signal provided by the second second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

Optionally, the driving signal generation circuit includes a first output node control circuit, a second output node control circuit, a third energy storage circuit and an output circuit; the driving signal generation circuit is arranged on a side of the control signal generation circuit included in the driving circuit away from the display area; the transistors in the output circuit are arranged on a side of the transistors included in the driving signal generation circuit except the transistors in the output circuit close to the display area;
The first output node control circuit is electrically connected to the third first clock signal line, the second voltage line and the second output node respectively, and is configured to control the first output node to be connected to the second voltage line under the control of the first clock signal provided by the third first clock signal line, and to control the first output node to be connected to the third first clock signal line under the control of the potential of the second output node, and to maintain the potential of the first output node;
The second output node control circuit is electrically connected to the second output node, the third first clock signal line, the input terminal, the third second clock signal line, the first output node and the first voltage line respectively, and is configured to control the second output node to be connected to the input terminal under the control of the first clock signal, and to control the second output node to be connected to the first voltage line under the control of the potential of the first output node and the second clock signal provided by the third second clock signal line;
The first terminal of the third energy storage circuit is electrically connected to the second output node, the second terminal of the third energy storage circuit is electrically connected to the nth stage of driving signal output terminal, and the third energy storage circuit is configured to store electric energy;
The output circuit is electrically connected to the first output node, the second output node, the first voltage line, the second clock signal and the nth stage of driving signal output terminal, respectively, and is configured to control the connection between the nth stage of driving signal output terminal and the first voltage line under the control of the potential of the first output node, and to control the connection between the nth stage of driving signal output terminal and the third second clock signal line under the control of the potential of the second output node.

Optionally, the first voltage line includes a first first voltage line and a second first voltage line sequentially arranged in a direction away from the display area, and the second voltage line includes a first second voltage line and a second second voltage line sequentially arranged in a direction away from the display area;
An orthographic projection of the active pattern of at least part of the transistors included in the second control circuit on the base substrate at least partially overlaps the orthographic projection of the first first voltage line on the base substrate;
An orthographic projection of the active pattern of the at least part of transistors included in the second control circuit on the base substrate at least partially overlaps the orthographic projection of the first second voltage line on the base substrate;
An orthographic projection of the first second voltage line on the base substrate at least partially overlaps the orthographic projection of the electrode plate of the capacitor included in the first energy storage circuit on the base substrate;
An orthographic projection of the enable signal line on the base substrate at least partially overlaps an orthographic projection of active patterns of at least a portion of transistors included in the control signal generation circuit on the base substrate.

Optionally, the orthographic projection of the first second voltage line on the base substrate at least partially overlaps the orthographic projection of the electrode plate of the capacitor included in the second energy storage circuit on the base substrate;
An orthographic projection of the second second voltage line on the base substrate at least partially overlaps an orthographic projection of active patterns of at least part of transistors included in the control signal generation circuit on the base substrate.
the orthographic projection of the second first voltage line on the base substrate at least partially overlaps the orthographic projection of the active pattern of at least part of the transistors included in the first control circuit on the base substrate;
An orthographic projection of the enable signal line on the base substrate at least partially overlaps the orthographic projection of the electrode plate of the capacitor included in the second energy storage circuit on the base substrate;
An orthographic projection of the second second voltage line on the base substrate at least partially overlaps the orthographic projection of the electrode plate of the capacitor included in the second energy storage circuit on the base substrate;
An orthographic projection of the second second voltage line on the base substrate at least partially overlaps an orthographic projection of active patterns of at least part of transistors included in the control signal generation circuit on the base substrate.

Optionally, the orthographic projection of the second first voltage line on the base substrate at least partially overlaps the orthographic projection of the active pattern of at least part of the transistors included in the first control circuit on the base substrate;
The orthographic projection of the second second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the active pattern of at least part of the transistor included in the first control circuit on the base substrate;
The orthographic projection of the second first voltage line on the base substrate at least partially overlaps the orthographic projection of the active pattern of at least part of the transistor included in the first control circuit on the base substrate;
An orthographic projection of the second first voltage line on the base substrate at least partially overlaps an orthographic projection of active patterns of at least part of transistors included in the control signal generation circuit on the base substrate.

Optionally, the first first voltage line, the second first voltage line, the first second voltage line, the second second voltage line and the enable signal line all extend along a first direction;
The width of the first first voltage line along the second direction is greater than the width of the second first voltage line along the second direction;
The width of the first second voltage line along the second direction is greater than the width of the second second voltage line along the second direction;
The first direction intersects the second direction.

Optionally, the transistor included in the second control circuit is arranged on a side of the transistor included in the first control circuit close to the display area;
The transistor included in the control signal generation circuit is arranged on a side of the second control circuit away from the display area.

Optionally, an orthographic projection of the enable signal line on the base substrate at least partially overlaps an orthographic projection of an active pattern of at least one transistor included in the output inverting circuit on the base substrate.

Optionally, the second voltage line includes a third second voltage line; the third second voltage line is arranged on a side of the second second voltage line away from the display area;
An orthographic projection of the third second voltage line on the base substrate at least partially overlaps an orthographic projection of an active pattern of at least one transistor included in the output inverter circuit on the base substrate.

Optionally, the orthographic projection of the second first voltage line on the base substrate at least partially overlaps the orthographic projection of the active pattern of at least one transistor included in the output inverter circuit on the base substrate;
The enable signal line is arranged on a side of the second first voltage line away from the display area.

Optionally, the first voltage line includes a first first voltage line, a second first voltage line, and a third first voltage line sequentially arranged along a direction away from the display area, and the second voltage line includes a first second voltage line, a second second voltage line, and a third second voltage line sequentially arranged along a direction away from the display area;
The orthographic projection of the second second voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the electrode plate of the capacitor included in the potential maintaining circuit on the base substrate;
The orthographic projection of the third first voltage line on the base substrate at least partially overlaps the orthographic projection of the active pattern of at least one transistor included in the second output node control circuit on the base substrate;
The orthographic projection of the third second voltage line on the base substrate at least partially overlaps the orthographic projection of the electrode plate of the capacitor included in the second node control circuit on the base substrate;
The orthographic projection of the third second voltage line on the base substrate at least partially overlaps the orthographic projection of the active pattern of at least one transistor included in the first node control circuit on the base substrate;
An orthographic projection of the third second voltage line on the base substrate at least partially overlaps an orthographic projection of an active pattern of at least one transistor included in the second node control circuit on the base substrate.

Optionally, the first first clock signal line and the second clock signal line are arranged between the third first voltage line and the third second voltage line;
The orthographic projection of the first first clock signal line on the base substrate at least partially overlaps the orthographic projection of the electrode plate of the capacitor included in the first output node control circuit on the base substrate;
The orthographic projection of the first first clock signal line on the base substrate at least partially overlaps the orthographic projection of the active pattern of at least one transistor included in the second node control circuit on the base substrate;
The orthographic projection of the first first clock signal line on the base substrate at least partially overlaps the orthographic projection of the active pattern of at least one transistor included in the first output node control circuit on the base substrate;
The orthographic projection of the first second clock signal line on the base substrate at least partially overlaps the orthographic projection of the electrode plate of the capacitor included in the first output node control circuit on the base substrate;
The orthographic projection of the first second clock signal line on the base substrate at least partially overlaps the orthographic projection of the electrode plate of the capacitor included in the second node control circuit on the base substrate.

Optionally, the first voltage line includes a first first voltage line, a second first voltage line, and a third first voltage line sequentially arranged along a direction away from the display area, and the second voltage line includes a first second voltage line, a second second voltage line, and a third second voltage line sequentially arranged along a direction away from the display area;
The orthographic projection of the second second voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the electrode plate of the capacitor included in the potential maintaining circuit on the base substrate;
The orthographic projection of the third first voltage line on the base substrate at least partially overlaps the orthographic projection of the active pattern of at least one transistor included in the second output node control circuit on the base substrate;
The orthographic projection of the third second voltage line on the base substrate at least partially overlaps the orthographic projection of the electrode plate of the capacitor included in the second node control circuit on the base substrate;
The orthographic projection of the third second voltage line on the base substrate at least partially overlaps the orthographic projection of the active pattern of at least one transistor included in the first node control circuit on the base substrate;
An orthographic projection of the third second voltage line on the base substrate at least partially overlaps an orthographic projection of an active pattern of at least one transistor included in the second node control circuit on the base substrate.

Optionally, the second first clock signal line and the second second clock signal line are arranged between the second first voltage line and the fourth second voltage line;
An orthographic projection of the second first clock signal line on the base substrate at least partially overlaps the orthographic projection of the active pattern of at least part of the transistors included in the second output node control circuit on the base substrate;
An orthographic projection of the second second clock signal line on the base substrate at least partially overlaps with the orthographic projection of active patterns of at least part of transistors included in the second output node control circuit on the base substrate
Optionally, the first voltage line includes a first first voltage line, a second first voltage line, a third first voltage line, and a fourth first voltage line sequentially arranged along a direction away from the display area, and the second voltage line includes a first second voltage line, a second second voltage line, a third second voltage line, and a fourth second voltage line sequentially arranged along a direction away from the display area;
An orthographic projection of the third first voltage line on the base substrate at least partially overlaps an orthographic projection of the active pattern of at least one transistor included in the output circuit on the base substrate;
An orthographic projection of the third first voltage line on the base substrate at least partially overlaps an orthographic projection of the electrode plate of the capacitor included in the potential maintaining circuit on the base substrate;
An orthographic projection of the third second voltage line on the base substrate at least partially overlaps an orthographic projection of the active pattern of at least one transistor included in the output circuit on the base substrate;
An orthographic projection of the fourth first voltage line on the base substrate at least partially overlaps an orthographic projection of the active pattern of at least one transistor included in the second output node control circuit on the base substrate;
An orthographic projection of the fourth second voltage line on the base substrate at least partially overlaps an orthographic projection of the active pattern of at least one transistor included in the first node control circuit on the base substrate;
An orthographic projection of the fourth second voltage line on the base substrate at least partially overlaps an orthographic projection of an electrode plate of a capacitor included in the second node control circuit on the base substrate.

Optionally, the first first clock signal line and the second clock signal line are arranged between the third first voltage line and the third second voltage line;
The orthographic projection of the first first clock signal line on the base substrate at least partially overlaps the orthographic projection of the electrode plate of the capacitor included in the first output node control circuit on the base substrate;
The orthographic projection of the first first clock signal line on the base substrate at least partially overlaps the orthographic projection of the active pattern of at least one transistor included in the second node control circuit on the base substrate;
The orthographic projection of the first first clock signal line on the base substrate at least partially overlaps the orthographic projection of the active pattern of at least one transistor included in the first output node control circuit on the base substrate;
The orthographic projection of the first second clock signal line on the base substrate at least partially overlaps the orthographic projection of the electrode plate of the capacitor included in the first output node control circuit on the base substrate;
The orthographic projection of the first second clock signal line on the base substrate at least partially overlaps the orthographic projection of the electrode plate of the capacitor included in the second node control circuit on the base substrate.

Optionally, the first voltage line includes a first first voltage line, a second first voltage line, a third first voltage line, and a fourth first voltage line sequentially arranged along a direction away from the display area, and the second voltage line includes a first second voltage line, a second second voltage line, a third second voltage line, and a fourth second voltage line sequentially arranged along a direction away from the display area;
An orthographic projection of the third first voltage line on the base substrate at least partially overlaps an orthographic projection of the active pattern of at least one transistor included in the output circuit on the base substrate;
An orthographic projection of the third first voltage line on the base substrate at least partially overlaps an orthographic projection of the electrode plate of the capacitor included in the potential maintaining circuit on the base substrate;
An orthographic projection of the third second voltage line on the base substrate at least partially overlaps an orthographic projection of the active pattern of at least one transistor included in the output circuit on the base substrate;
An orthographic projection of the fourth first voltage line on the base substrate at least partially overlaps an orthographic projection of the active pattern of at least one transistor included in the second output node control circuit on the base substrate;
An orthographic projection of the fourth second voltage line on the base substrate at least partially overlaps an orthographic projection of the active pattern of at least one transistor included in the first node control circuit on the base substrate;
An orthographic projection of the fourth second voltage line on the base substrate at least partially overlaps an orthographic projection of an electrode plate of a capacitor included in the second node control circuit on the base substrate.

Optionally, the display substrate further includes a second first clock signal line and a second second clock signal line arranged between the fourth first voltage line and the fourth second voltage line;
An orthographic projection of the second first clock signal line on the base substrate at least partially overlaps the orthographic projection of the electrode plate of the capacitor included in the first output node control circuit on the base substrate;
An orthographic projection of the second second clock signal line on the base substrate at least partially overlaps the orthographic projection of the electrode plate of the capacitor included in the first output node control circuit on the base substrate;
An orthographic projection of the second second clock signal line on the base substrate at least partially overlaps the orthographic projection of the electrode plate of the capacitor included in the first output node control circuit on the base substrate;
An orthographic projection of the second first clock signal line on the base substrate at least partially overlaps the orthographic projection of the active patterns of at least part of the transistor included in the second node control circuit on the base substrate;
An orthographic projection of the second first clock signal line on the base substrate at least partially overlaps the orthographic projection of active patterns of at least part of transistors included in the first output node control circuit on the base substrate.

Optionally, the first voltage line includes a first first voltage line, the second voltage line includes a first second voltage line, a second second voltage line and a third second voltage line sequentially arranged in a direction away from the display area; the enable signal line is arranged between the second second voltage line and the third second voltage line;
The orthographic projection of the first second voltage line on the base substrate at least partially overlaps the orthographic projection of the active pattern of at least part of the transistors included in the second control circuit on the base substrate;
The orthographic projection of the first first voltage line on the base substrate at least partially overlaps the orthographic projection of the active pattern of at least part of the transistors included in the second control circuit on the base substrate;
The orthographic projection of the first first voltage line on the base substrate at least partially overlaps the orthographic projection of the active pattern of at least part of the transistors included in the first control circuit on the base substrate;
The orthographic projection of the first first voltage line on the base substrate at least partially overlaps the orthographic projection of the electrode plate of the capacitor included in the first energy storage circuit on the base substrate;
The orthographic projection of the first second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the active pattern of at least part of the transistors included in the first control circuit on the base substrate;
The orthographic projection of the enable signal line on the base substrate at least partially overlaps the orthographic projection of the active pattern of at least part of the transistors included in the control signal generation circuit on the base substrate;
An orthographic projection of the third second voltage line on the base substrate at least partially overlaps an orthographic projection of active patterns of at least part of transistors included in the control signal generation circuit on the base substrate.

Optionally, the first voltage line includes a first first voltage line, and the second voltage line includes a first second voltage line and a second second voltage line sequentially arranged in a direction away from the display area; the enable signal line is arranged between the first second voltage line and the second second voltage line;
The orthographic projection of the first second voltage line on the base substrate at least partially overlaps the orthographic projection of the active pattern of at least part of the transistors included in the second control circuit on the base substrate;
The orthographic projection of the enable signal line on the base substrate at least partially overlaps the orthographic projection of the electrode plate of the capacitor included in the first energy storage circuit on the base substrate; the orthographic projection of the second second voltage line on the base substrate at least partially overlaps the orthographic projection of the active pattern of at least part of the transistors included in the control signal generation circuit on the base substrate;
The orthographic projection of the first first voltage line on the base substrate at least partially overlaps the orthographic projection of the active pattern of at least part of the transistors included in the second control circuit on the base substrate;
An orthographic projection of the first first voltage line on the base substrate at least partially overlaps an orthographic projection of active patterns of at least part of transistors included in the first control circuit on the base substrate.

Optionally, the first voltage line includes a first first voltage line and a second first voltage line sequentially arranged along a direction away from the display area, and the second voltage line includes a first second voltage line, a second second voltage line, a third second voltage line and a fourth second voltage line sequentially arranged along a direction away from the display area;
The orthographic projection of the third second voltage line on the base substrate at least partially overlaps the orthographic projection of the electrode plate of the capacitor included in the third energy storage circuit on the base substrate;
The orthographic projection of the second first voltage line on the base substrate at least partially overlaps the orthographic projection of the electrode plate of the capacitor included in the first output node control circuit on the base substrate;
The orthographic projection of the second first voltage line on the base substrate at least partially overlaps the orthographic projection of the active pattern of at least part of the transistors included in the output circuit on the base substrate;
An orthographic projection of the fourth second voltage line on the base substrate at least partially overlaps an orthographic projection of active patterns of at least part of transistors included in the first output node control circuit on the base substrate.

Optionally, the third first clock signal line and the third second clock signal line are arranged between the second first voltage line and the fourth second voltage line;
An orthographic projection of the third first clock signal line on the base substrate at least partially overlaps an orthographic projection of the active pattern of at least some transistors included in the second output node control circuit on the base substrate;
An orthographic projection of the third second clock signal line on the base substrate at least partially overlaps an orthographic projection of the active pattern of at least some transistors included in the second output node control circuit on the base substrate.

Optionally, the active patterns of at least part of the transistor included in the second control circuit include at least two active pattern portions independent of each other.

In a second aspect, an embodiment of the present disclosure provides a display device including the display substrate.

### BRIEF DESCRIPTION OF THE DRAWINGS

FIG.1 is a structural diagram of a driving circuit according to an embodiment of the present disclosure;
FIG.2 is a circuit diagram of a related pixel circuit;
FIG.3 is a structural diagram of a driving circuit according to at least one embodiment of the present disclosure;
FIG.4 is a structural diagram of a driving circuit according to at least one embodiment of the present disclosure;
FIG.5 is a structural diagram of a driving circuit according to at least one embodiment of the present disclosure;
FIG.6 is a structural diagram of a driving circuit according to at least one embodiment of the present disclosure;
FIG.7 is a structural diagram of a driving circuit according to at least one embodiment of the present disclosure;
FIG.8 is a structural diagram of a driving circuit according to at least one embodiment of the present disclosure;
FIG.9 is a structural diagram of a driving circuit according to at least one embodiment of the present disclosure;
FIG. 10 is a structural diagram of a driving circuit according to at least one embodiment of the present disclosure;
FIG. 11 is a structural diagram of a driving circuit according to at least one embodiment of the present disclosure;
FIG. 12 is a structural diagram of a driving circuit according to at least one embodiment of the present disclosure;
FIG. 13 is a structural diagram of a driving circuit according to at least one embodiment of the present disclosure;
FIG.14 is a circuit diagram of a driving circuit according to at least one embodiment of the present disclosure;
FIG. 15 is timing diagram of the driving signal generation circuit in the driving circuit shown in FIG. 14.
FIG. 16 is timing diagram of the (n-1)th stage of driving circuit and the nth stage of driving circuit;
FIG. 17 is a circuit diagram of a driving circuit according to at least one embodiment of the present disclosure;
FIG.18 is a timing diagram of a driving signal generation circuit in the driving circuit shown in FIG.17;
FIG. 19 is a timing diagram of the (n-1)th stage of driving circuit and the nth stage of driving circuit;
FIG.20 is a circuit diagram of a driving circuit according to at least one embodiment of the present disclosure;
FIG.21 is a timing diagram of the driving signal generation circuit in the driving circuit shown in FIG. 20;
FIG. 22 is a timing diagram of the (n-1)th stage of driving circuit and the nth stage of driving circuit;
FIG.23 is a structural diagram of a display substrate according to at least one embodiment of the present disclosure;
FIGS. 24A, 24B and 24C are first layout diagrams of the driving circuit shown in FIG. 14;
FIG.25 is a layout diagram of the first semiconductor layer in FIG.24A;
FIG.26 is a layout diagram of the first gate metal layer in FIG.24A;
FIG.27 is a layout diagram of the second gate metal layer in FIG.24A;
FIG.28 is a layout diagram of the first source-drain metal layer in FIG.24A;
FIG.29 is a layout diagram of the second source-drain metal layer in FIG.24A;
FIG.30 is a layout diagram of the third source-drain metal layer in FIG.24A;
FIG.31A is a superimposed diagram of the first semiconductor layer and the first gate metal layer in FIG.24A;
FIG.31B is a superimposed diagram of the first gate metal layer and the second gate metal layer in FIG.24A;
FIG.31C is a superimposed diagram of the second gate metal layer and the first source-drain metal layer in FIG.24A;
FIG.31D is a superimposed diagram of the first source-drain metal layer and the second source-drain metal layer in FIG.24A;
FIG.31E is a superimposed diagram of the second source-drain metal layer and the third source-drain metal layer in FIG.24A;
FIGS. 32A, 32B and 32C are second layout diagrams of the driving circuit shown in FIG. 14;
FIG.33 is a layout diagram of the first semiconductor layer in FIG.32A;
FIG.34 is a layout diagram of the first gate metal layer in FIG.32A;
FIG.35 is a layout diagram of the second gate metal layer in FIG.32A;
FIG.36 is a layout diagram of the second semiconductor layer in FIG.32A;
FIG.37 is a layout diagram of the third gate metal layer in FIG.32A;
FIG.38 is a layout diagram of the first source-drain metal layer in FIG.32A;
FIG.39 is a layout diagram of the second source-drain metal layer in FIG.32A;
FIG.40 is a layout diagram of the third source-drain metal layer in FIG.32A;
FIG.41A is a schematic diagram of the superposition of the first semiconductor layer and the first gate metal layer in FIG.32A;
FIG.41B is a schematic diagram of the superposition of the first gate metal layer and the second gate metal layer in FIG.32A;
FIG.41C is a schematic diagram of the superposition of the second gate metal layer and the second semiconductor layer in FIG.32A;
FIG.41D is a schematic diagram of the superposition of the third gate metal layer and the second semiconductor layer in FIG.32A;
FIG.41E is a schematic diagram of the superposition of the third gate metal layer and the first source-drain metal layer in FIG.32A;
FIG.41F is a schematic diagram of the superposition of the first source-drain metal layer and the second source-drain metal layer in FIG.32A;
FIG.41G is a schematic diagram of the superposition of the second source-drain metal layer and the third source-drain metal layer in FIG.32A;
FIGS. 42A, 42B and 42C are first layout diagrams of the driving circuit shown in FIG. 17;
FIG.43 is a layout diagram of the first semiconductor layer in FIG.42A;
FIG.44 is a layout diagram of the first gate metal layer in FIG.42A;
FIG.45 is a layout diagram of the second gate metal layer in FIG.42A;
FIG.46 is a layout diagram of the first source-drain metal layer in FIG.42A;
FIG.47 is a layout diagram of the second source-drain metal layer in FIG.42A;
FIG.48 is a layout diagram of the third source-drain metal layer in FIG.42A;
FIG.49A is a superimposed diagram of the first semiconductor layer and the first gate metal layer in FIG.42A;
FIG.49B is a superimposed diagram of the first gate metal layer and the second gate metal layer in FIG.42A;
FIG.49C is a superimposed diagram of the second gate metal layer and the first source-drain metal layer in FIG.42A;
FIG.49D is a superimposed diagram of the first source-drain metal layer and the second source-drain metal layer in FIG.42A;
FIG.49E is a superimposed diagram of the second source-drain metal layer and the third source-drain metal layer in FIG.42A;
FIGS. 50A, 50B and 50C are second layout diagrams of the driving circuit shown in FIG. 17;
FIG.51 is a layout diagram of the first semiconductor layer in FIG.50A;
FIG.52 is a layout diagram of the first gate metal layer in FIG.50A;
FIG.53 is a layout diagram of the second gate metal layer in FIG.50A;
FIG.54 is a layout diagram of the second semiconductor layer in FIG.50A;
FIG.55 is a layout diagram of the third gate metal layer in FIG.50A;
FIG.56 is a layout diagram of the first source-drain metal layer in FIG.50A;
FIG.57 is a layout diagram of the second source-drain metal layer in FIG.50A;
FIG.58 is a layout diagram of the third source-drain metal layer in FIG.50A;
FIG.59A is a schematic diagram of the superposition of the first semiconductor layer and the first gate metal layer in FIG.50A;
FIG.59B is a schematic diagram of the superposition of the first gate metal layer and the second gate metal layer in FIG.50A;
FIG.59C is a schematic diagram of the superposition of the second gate metal layer and the second semiconductor layer in FIG.50A;
FIG.59D is a schematic diagram of the superposition of the third gate metal layer and the second semiconductor layer in FIG.50A;
FIG.59E is a schematic diagram of the superposition of the third gate metal layer and the first source-drain metal layer in FIG.50A;
FIG.59F is a schematic diagram of the superposition of the first source-drain metal layer and the second source-drain metal layer in FIG.50A;
FIG.59G is a schematic diagram of the superposition of the second source-drain metal layer and the third source-drain metal layer in FIG.50A;
FIGS. 60A, 60B and 60C are first layout diagrams of the driving circuit shown in FIG. 20;
FIG.61 is a layout diagram of the first semiconductor layer in FIG.60A;
FIG.62 is a layout diagram of the first gate metal layer in FIG.60A;
FIG.63 is a layout diagram of the second gate metal layer in FIG.60A;
FIG.64 is a layout diagram of the first source-drain metal layer in FIG.60A;
FIG.65 is a layout diagram of the second source-drain metal layer in FIG.60A;
FIG.66A is a superimposed diagram of the first semiconductor layer and the first gate metal layer in FIG.60A;
FIG.66B is a superimposed diagram of the first gate metal layer and the second gate metal layer in FIG.60A;
FIG.66C is a superimposed diagram of the second gate metal layer and the first source-drain metal layer in FIG.60A;
FIG.66D is a superimposed diagram of the first source-drain metal layer and the second source-drain metal layer in FIG.60A;
FIGS. 67A, 67B and 67C are second layout diagrams of a display substrate including the driving circuit shown in FIG. 20;
FIG.68 is a layout diagram of the first semiconductor layer in FIG.67A;
FIG.69 is a layout diagram of the first gate metal layer in FIG.67A;
FIG.70 is a layout diagram of the second gate metal layer in FIG.67A;
FIG.71 is a layout diagram of the second semiconductor layer in FIG.67A;
FIG.72 is a layout diagram of the third gate metal layer in FIG.67A;
FIG.73 is a layout diagram of the first source-drain metal layer in FIG.67A;
FIG.74 is a layout diagram of the second source-drain metal layer in FIG.67A;
FIG.75A is a layout diagram of the first semiconductor layer and the first gate metal layer in FIG.67A;
FIG.75B is a layout diagram of the first gate metal layer and the second gate metal layer in FIG.67A;
FIG.75C is a layout diagram of the second gate metal layer and the second semiconductor layer in FIG.67A;
FIG.75D is a layout diagram of the third gate metal layer and the second semiconductor layer in FIG.67A;
FIG.75E is a layout diagram of the third gate metal layer and the first source-drain metal layer in FIG.67A;
FIG.75F is a layout diagram of the first source-drain metal layer and the second source-drain metal layer in FIG.67A.

### DETAILED DESCRIPTION

The following will be combined with the drawings in the embodiments of the present disclosure to clearly and completely describe the technical solutions in the embodiments of the present disclosure. Obviously, the described embodiments are only part of the embodiments of the present disclosure, not all of the embodiments. Based on the embodiments in the present disclosure, all other embodiments obtained by ordinary skilled in the art without making creative work are within the scope of protection of the present disclosure.

The transistors used in all embodiments of the present disclosure may be thin-film transistors or field-effect transistors or other devices with the same characteristics. In the embodiment of the present disclosure, in order to distinguish the two electrodes of a transistor other than the gate electrode, one of the two electrodes is called the first electrode and the other electrode is called the second electrode.

In actual operation, when the transistor is a thin film transistor or a field effect transistor, the first electrode may be a drain electrode, and the second electrode may be a source electrode; or, the first electrode may be a source electrode, and the second electrode may be a drain electrode.

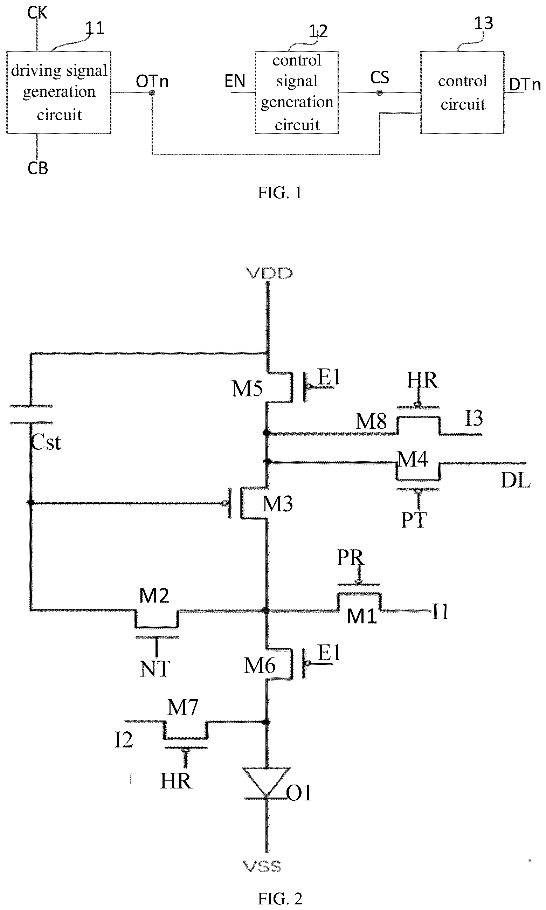

As shown in FIG.1, the driving circuit described in the embodiment of the present disclosure includes a driving signal generation circuit 11, a control signal generation circuit 12 and a control circuit 13;
The driving signal generation circuit 11 is electrically connected to the first clock signal line CK and the second clock signal line CB respectively, and is configured to generate and output the nth stage of driving signal through the nth stage of driving signal output terminal OTn under the control of the first clock signal provided by the first clock signal line CK and the second clock signal provided by the second clock signal line CB; n is a positive integer;
The control signal generation circuit 12 is electrically connected to the enable signal line EN and the control signal terminal CS respectively, and is configured to output a control signal to the control signal terminal CS according to the enable signal provided by the enable signal line EN;
The control circuit 13 is electrically connected with the control signal terminal CS and the nth stage of driving output terminal DTn respectively, and is configured to output a signal to the nth stage of driving output terminal DTn under the control of the control signal.

When the driving circuit described in the embodiment of the present disclosure is working, the driving signal generation circuit 11 outputs the nth stage of driving signal, the control signal generation circuit 12 generates a control signal according to the enable signal, and the control circuit 13 controls to output the nth stage of driving signal or the invalid voltage signal to the nth driving output terminal DTn under the control of the control signal.

In the related art, the driving circuit usually includes a driving signal generation circuit and a control circuit directly controlled by an enable signal. When the pulse width of the nth stage of driving signal provided by the driving signal generation circuit is 1H (1H is a row of scanning time), the control circuit directly controlled by the enable signal can be configured to control to output the nth stage of driving signal or an invalid voltage signal. However, with the development of pixels, the signals for controlling pixels are diversified, and the pulse width of the nth stage of driving signal will exceed 1H, resulting in the nth stage of driving signal waveform crossing the change edge (rising edge or falling edge) of the enable signal, resulting in only part of the nth stage of driving signal being output, which will cause abnormal pixel operation.

Based on this, the driving circuit described in the embodiment of the present disclosure is additionally provided with a control signal generation circuit 12, which generates a control signal according to an enable signal, and controls to output the nth stage of driving signal or the invalid voltage signal to the nth stage of driving output terminal DTn through the control signal. In at least one embodiment of the present disclosure, the control signal generation circuit can generate the control signal according to the enable signal under the control of the (n-1)th stage of driving signal, the (n-1)th stage of inverted driving signal (the (n-1)th stage of inverted driving signal can be inverted with the (n-1)th stage of driving signal), the nth stage of driving signal and the nth stage of inverted driving signal (the nth stage of inverted driving signal can be inverted with the nth stage of driving signal) provided at the (n-1)th stage of driving signal output terminal, and the control circuit 13 outputs the nth stage of driving signal or the invalid voltage signal to the nth stage of driving output terminal DTn under the control of the control signal, so that when the pulse width of the nth stage of driving signal is greater than 1H, the nth stage of driving signal or the invalid voltage signal can be accurately output to the nth stage of driving output terminal DTn, so that local refresh can be accurately performed.

In at least one embodiment of the present disclosure, the control signal generation circuit is also electrically connected to the (n-1)th stage of driving signal output terminal, the (n-1)th stage of inverted signal output terminal, the nth stage of driving signal output terminal and the nth stage of inverted signal output terminal, respectively, and is configured to control the connection or disconnection between the enable signal line and the control signal terminal under the control of the (n-1)th stage of driving signal, the (n-1)th stage of inverted driving signal, the nth stage of driving signal and the nth stage of inverted driving signal.

As shown in FIG. 2, one embodiment of the related pixel circuit includes a first display control transistor M1, a second display control transistor M2, a driving transistor M3, a fourth display control transistor M4, a fifth display control transistor M5, a sixth display control transistor M6, a seventh display control transistor M7, an eighth display control transistor M8, a storage capacitor Cst, and an organic light emitting diode Ol;
The gate electrode of M1 is electrically connected to the first reset terminal PR, the source electrode of M1 is electrically connected to the first initial voltage terminal I1, the second electrode of M1 is electrically connected to the drain electrode of M3, and the first initial voltage terminal I1 is configured to provide a first initial voltage Vinit1;
The gate electrode of M2 is electrically connected to the first scanning terminal NT, the source electrode of M2 is electrically connected to the gate electrode of M3, and the drain electrode of M2 is electrically connected to the drain electrode of M3;
The gate electrode of M4 is electrically connected to the second scanning terminal PT, the source electrode of M4 is electrically connected to the data line DL, and the drain electrode of M4 is electrically connected to the source electrode of M3;
The gate electrode of M5 is electrically connected to the light emitting control terminal E1, the source electrode of M5 is electrically connected to the high level terminal VDD, and the drain electrode of M5 is electrically connected to the source electrode of M3;
The gate electrode of M6 is electrically connected to the light emitting control terminal E1, the source electrode of M6 is electrically connected to the drain electrode of M3, the drain electrode of M6 is electrically connected to the anode of Ol; the cathode of Ol is electrically connected to the low level terminal VSS;
The gate electrode of M7 is electrically connected to the second reset terminal HR, the source electrode of M7 is electrically connected to the second initial voltage terminal I2, and the drain electrode of M7 is electrically connected to the anode of Ol;
The gate electrode of M8 is electrically connected to the second reset terminal HR, the source electrode of M8 is electrically connected to the third initial voltage terminal I3, and the drain electrode of M8 is electrically connected to the source electrode of M3;
The first electrode plate Cst is electrically connected to the gate electrode of M3, and the second electrode plate of Cst is electrically connected to the high level terminal VDD;
M1, M3, M4, M5, M6, M7 and M8 are all p-type transistors, and M2 is an n-type transistor.

In at least one embodiment of the present disclosure, the nth stage of driving output terminal DTn may be an nth stage of first scanning terminal, an nth stage of second scanning terminal or an nth stage first reset terminal, but is not limited thereto.

The driving circuit at least one embodiment of the present disclosure further includes an output inverting circuit;
The output inverting circuit is electrically connected to the nth stage of driving signal output terminal and the nth stage of inverted signal output terminal respectively, and is configured to invert the nth stage of driving signal to obtain and output the nth stage of inverted driving signal through the nth stage of inverted signal output terminal.

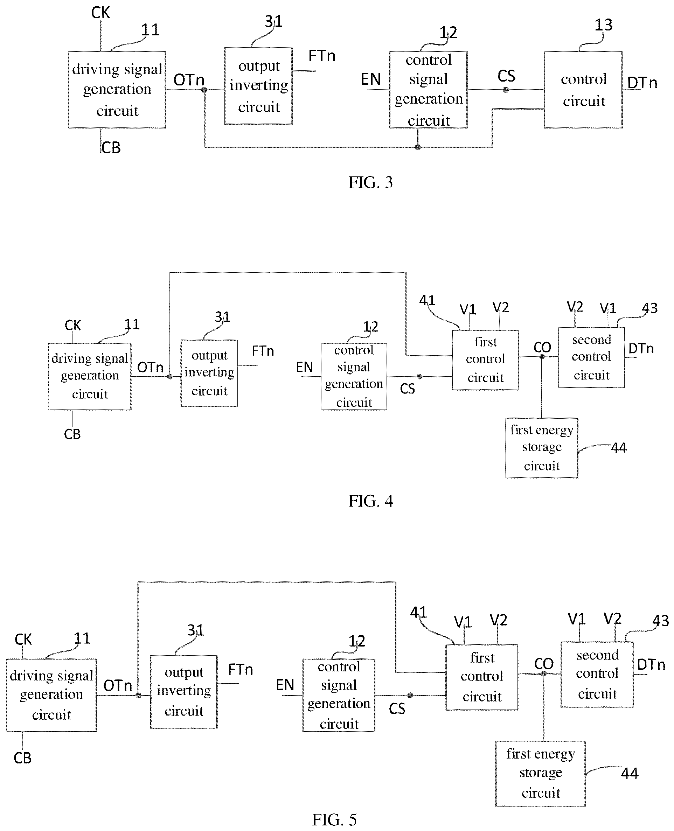

As shown in FIG.3, based on the embodiment of the driving circuit shown in FIG.1, the driving circuit according to at least one embodiment of the present disclosure further includes an output inverting circuit 31;
The output inverting circuit 31 is electrically connected to the nth stage of inverted signal output terminal FOn, and is configured to invert the nth stage of driving signal to obtain and output the nth stage of inverted driving signal through the nth stage of inverted signal output terminal FOn.

In at least one embodiment of the present disclosure, the control circuit includes a first control circuit, a second control circuit and a first energy storage circuit;
The first control circuit is electrically connected to the control signal terminal, the nth driving signal output terminal, the first control voltage line, the second control voltage line and the control output terminal respectively, and is configured to control the connection or disconnection between the control output terminal and the first control voltage line under the control of the control signal, control the connection or disconnection between the control output terminal and the first control voltage line under the control of the nth stage of driving signal output by the nth stage of driving signal output terminal, and control the connection or disconnection between the control output terminal and the second control voltage line under the control of the nth stage of driving signal and the control signal;
The second control circuit is electrically connected to the control output terminal, the nth stage of driving output terminal, the first voltage line and the second voltage line respectively, and is configured to control the connection or disconnection between the nth stage of driving output terminal and the first voltage line, and control the connection or disconnection between the nth stage of driving output terminal and the second voltage line under the control of the potential of the control output terminal;
The first energy storage circuit is electrically connected to the control output terminal and is configured to maintain the potential of the control output terminal.

Optionally, the first control voltage line is the first voltage line, and the second control voltage line is the second voltage line; or, the first control voltage line is the second voltage line, and the second control voltage line is the first voltage line.

As shown in FIG. 4, based on at least one embodiment of the driving circuit shown in FIG. 3, the control circuit includes a first control circuit 41, a second control circuit 42 and a first energy storage circuit 44;
The first control circuit 41 is electrically connected to the control signal terminal CS, the nth driving signal output terminal OTn, the first voltage line V1, the second voltage line V2 and the control output terminal CO, respectively, and is configured to control the control output terminal CO to be connected to the first voltage line V1 under the control of the control signal, to control the control output terminal CO to be connected or disconnected to the first voltage line V1 under the control of the nth stage of driving signal, and to control the control output terminal CO to be connected or disconnected to the second voltage line V2 under the control of the nth stage of driving signal and the control signal;
The second control circuit 42 is electrically connected to the control output terminal CO, the nth stage of driving output terminal DTn, the first voltage line V1 and the second voltage line V2 respectively, and is configured to control the connection or disconnection between the nth stage of driving output terminal DTn and the first voltage line V1, and control the connection or disconnection between the nth stage of driving output terminal DTn and the second voltage line V2 under the control of the potential of the control output terminal CO;
The first energy storage circuit 44 is electrically connected to the control output terminal CO, and is configured to maintain the potential of the control output terminal CO.

Optionally, the first voltage line may be a high voltage line, and the second voltage line may be a low voltage line, but is not limited thereto.

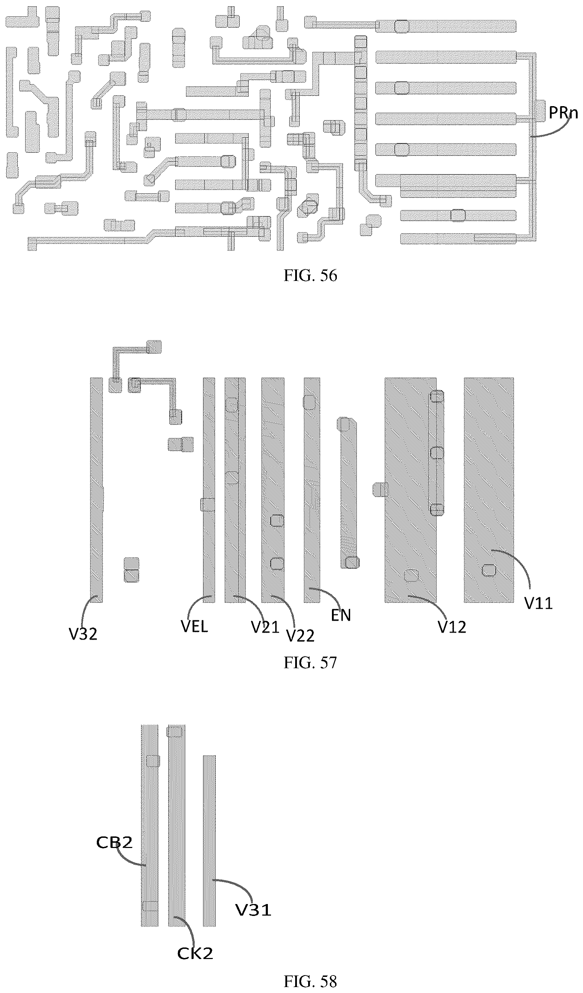

As shown in FIG. 5, based on at least one embodiment of the driving circuit shown in FIG.3, the control circuit includes a first control circuit 41, a second control circuit 42 and a first energy storage circuit 44;
The first control circuit 41 is electrically connected to the control signal terminal CS, the nth driving signal output terminal OTn, the first voltage line V1, the second voltage line V2 and the control output terminal CO, respectively, and is configured to control the connection between the control output terminal CO and the second voltage line V2 under the control of the control signal, control the connection or disconnection between the control output terminal CO and the second voltage line V2 under the control of the nth stage of driving signal, and control the connection or disconnection between the control output terminal CO and the first voltage line V1 under the control of the nth stage of driving signal and the control signal;
The second control circuit 42 is electrically connected to the control output terminal CO, the nth stage of driving output terminal DTn, the first voltage line V1 and the second voltage line V2 respectively, and is configured to control the connection or disconnection between the nth stage of driving output terminal DTn and the first voltage line V1, and control the connection or disconnection between the nth stage of driving output terminal DTn and the second voltage line V2 under the control of the potential of the control output terminal CO;
The first energy storage circuit 44 is electrically connected to the control output terminal CO, and is configured to maintain the potential of the control output terminal CO.

Optionally, the control circuit further includes a second energy storage circuit;
The second energy storage circuit is electrically connected to the control signal terminal and is configured to maintain the potential of the control signal terminal.

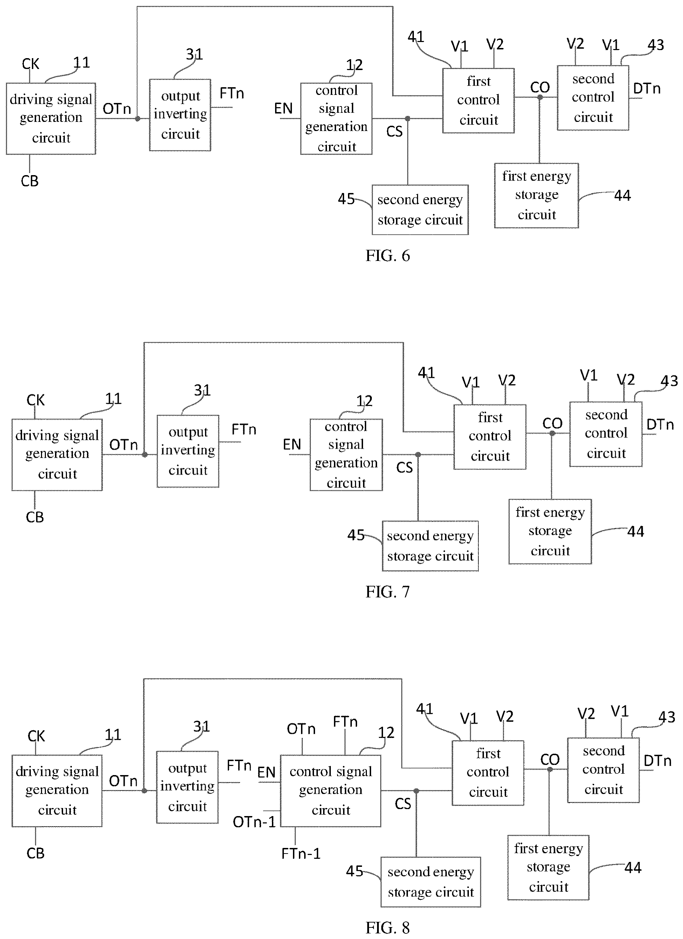

As shown in FIG. 6, based on one embodiment of the driving circuit shown in FIG.4, the control circuit further includes a second energy storage circuit 45;
The second energy storage circuit 45 is electrically connected to the control signal terminal CS, and is configured to maintain the potential of the control signal terminal CS.

As shown in FIG. 7, based on one embodiment of the driving circuit shown in FIG. 5, the control circuit further includes a second energy storage circuit 45;
The second energy storage circuit 45 is electrically connected to the control signal terminal CS, and is configured to maintain the potential of the control signal terminal CS.

In at least one embodiment of the present disclosure,
The control signal generation circuit is also electrically connected to the (n-1)th stage of driving signal output terminal, the (n-1)th stage of inverted signal output terminal, the nth stage of driving signal output terminal and the nth stage of inverted signal output terminal, respectively, and is configured to control the connection or disconnection between the enable signal line and the control signal terminal under the control of the (n-1)th stage of driving signal, the (n-1)th stage of inverted driving signal, the nth stage of driving signal and the nth stage of inverted driving signal.

As shown in FIG. 8, based on one embodiment of the driving circuit shown in FIG. 6, the control signal generation circuit 12 is also electrically connected to the (n-1)th stage of driving signal output terminal OTn-1, the (n-1)th stage of inverted signal output terminal FTn-1, the nth stage of driving signal output terminal OTn and the nth stage of inverted signal output terminal FTn, respectively, and is configured to control the connection or disconnection between the enable signal line EN and the control signal terminal CS under the control of the (n-1)th stage of driving signal, the (n-1)th stage of inverted driving signal, the (n-1)th stage of driving signal and the nth stage of inverted driving signal.

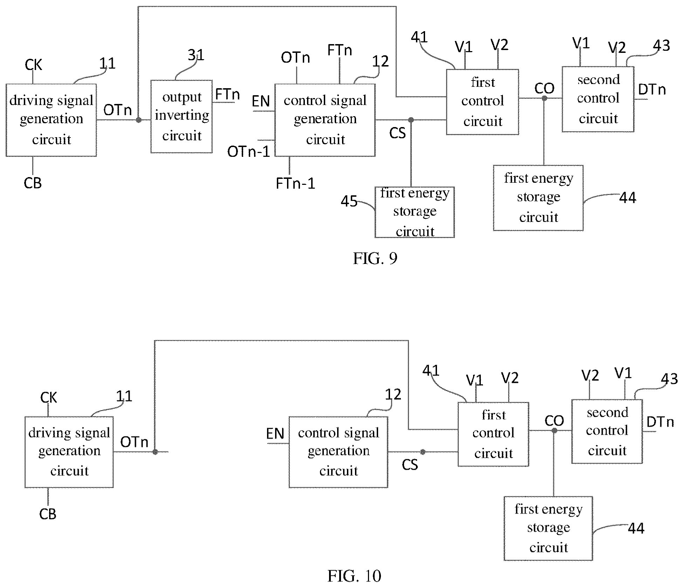

As shown in FIG. 9, based on one embodiment of the driving circuit shown in FIG. 7, the control signal generation circuit 12 is also electrically connected to the (n-1)th stage of driving signal output terminal OTn-1, the (n-1)th stage of inverted signal output terminal FTn-1, the nth stage of driving signal output terminal OTn and the nth stage of inverted signal output terminal FTn, respectively, and is configured to control the connection or disconnection between the enable signal line EN and the control signal terminal CS under the control of the (n-1)th stage of driving signal, the (n-1)th stage of inverted driving signal, the (n-1)th stage of driving signal and the nth stage of inverted driving signal.

As shown in FIG. 10, based on at least one embodiment of the driving circuit shown in FIG. 1, the control circuit includes a first control circuit 41, a second control circuit 42 and a first energy storage circuit 44;
The first control circuit 41 is electrically connected to the control signal terminal CS, the nth driving signal output terminal OTn, the first voltage line V1, the second voltage line V2 and the control output terminal CO, respectively, and is configured to control the connection between the control output terminal CO and the second voltage line V2 under the control of the control signal, control the connection or disconnection between the control output terminal CO and the second voltage line V2 under the control of the nth stage of driving signal, and control the connection or disconnection between the control output terminal CO and the first voltage line V1 under the control of the nth stage of driving signal and the control signal;
The second control circuit 42 is electrically connected to the control output terminal CO, the nth stage of driving output terminal DTn, the first voltage line V1 and the second voltage line V2 respectively, and is configured to control the connection or disconnection between the nth stage of driving output terminal DTn and the first voltage line V1, and control the connection or disconnection between the nth stage of driving output terminal DTn and the second voltage line V2 under the control of the potential of the control output terminal CO;
The first energy storage circuit 44 is electrically connected to the control output terminal CO, and is configured to maintain the potential of the control output terminal CO.

In at least one embodiment of the present disclosure, the control signal generation circuit is configured to invert the enable signal to generate an inverted enable signal, and output the inverted enable signal through the control signal terminal.

In a specific implementation, the control signal generation circuit may invert the enable signal to generate an inverted enable signal.

Optionally, the first control circuit includes a first control transistor, a second control transistor, a third control transistor and a fourth control transistor; the second control circuit includes a fifth control transistor and a sixth control transistor; the first energy storage circuit includes a first capacitor;
a gate electrode of the first control transistor is electrically connected to the nth stage of driving signal output terminal, a first electrode of the first control transistor is electrically connected to the first control voltage line, and a second electrode of the first control transistor is electrically connected to the control output terminal;
a gate electrode of the second control transistor is electrically connected to the control signal terminal, a first electrode of the second control transistor is electrically connected to a second electrode of the fourth control transistor, and a second electrode of the second control transistor is electrically connected to the second control voltage line;
a gate electrode of the third control transistor is electrically connected to the control signal terminal, a first electrode of the third control transistor is electrically connected to the first control voltage line, and a second electrode of the third control transistor is electrically connected to the control output terminal;
a gate electrode of the fourth control transistor is electrically connected to the nth stage of driving signal output terminal, and a first electrode of the fourth control transistor is electrically connected to the control output terminal;
a gate electrode of the fifth control transistor is electrically connected to the control output terminal, a first electrode of the fifth control transistor is electrically connected to the first voltage line, and a second electrode of the fifth control transistor is electrically connected to the nth driving output terminal;
a gate electrode of the sixth control transistor is electrically connected to the control output terminal, a first electrode of the sixth control transistor is electrically connected to the nth driving output terminal, and a second electrode of the sixth control transistor is electrically connected to the second voltage line;

A first terminal of the first capacitor is electrically connected to the control output terminal, and a second terminal of the first capacitor is electrically connected to the second voltage line.

Optionally, the first control circuit includes a first control transistor, a second control transistor, a third control transistor and a fourth control transistor; the second control circuit includes a fifth control transistor and a sixth control transistor; the first energy storage circuit includes a first capacitor; the first control voltage line is a second voltage line, and the second control voltage line is a first voltage line;
a gate electrode of the first control transistor is electrically connected to the control signal terminal, a first electrode of the first control transistor is electrically connected to a second electrode of the third control transistor, and a second electrode of the first control transistor is electrically connected to the control output terminal;
a gate electrode of the second control transistor is electrically connected to the control signal terminal, a first electrode of the second control transistor is electrically connected to the control output terminal, and a second electrode of the second control transistor is electrically connected to the second voltage line;
a gate electrode of the third control transistor is electrically connected to the nth stage of driving signal output terminal, and the first electrode of the third control transistor is electrically connected to the first voltage line;
a gate electrode of the fourth control transistor is electrically connected to the nth stage of driving signal output terminal, a first electrode of the fourth control transistor is electrically connected to the control output terminal, and a second electrode of the fourth control transistor is electrically connected to the second voltage line;
a gate electrode of the fifth control transistor is electrically connected to the control output terminal, a first electrode of the fifth control transistor is electrically connected to the first voltage line, and a second electrode of the fifth control transistor is electrically connected to the nth driving output terminal;
a gate electrode of the sixth control transistor is electrically connected to the control output terminal, a first electrode of the sixth control transistor is electrically connected to the nth driving output terminal, and a second electrode of the sixth control transistor is electrically connected to the second voltage line;

A first terminal of the first capacitor is electrically connected to the control output terminal, and a second terminal of the first capacitor is electrically connected to the second voltage line.

Optionally, the second energy storage circuit includes a second capacitor;
A first terminal of the second capacitor is electrically connected to the control signal terminal, and a second terminal of the second capacitor is electrically connected to the second voltage line.

Optionally, the control signal generation circuit includes a seventh control transistor, an eighth control transistor, a ninth control transistor and a tenth control transistor;
a gate electrode of the seventh control transistor is electrically connected to the (n-1)th stage of driving signal output terminal, a first electrode of the seventh control transistor is electrically connected to the enable signal line, and a second electrode of the seventh control transistor is electrically connected to a first electrode of the tenth control transistor;
a gate electrode of the eighth control transistor is electrically connected to the (n-1)th stage of inverting signal output terminal, a first electrode of the eighth control transistor is electrically connected to the enable signal line, and a second electrode of the eighth control transistor is electrically connected to a first electrode of the ninth control transistor;
a gate electrode of the ninth control transistor is electrically connected to the nth stage of driving signal output terminal, a first electrode of the ninth control transistor is electrically connected to a first electrode of the tenth control transistor, and a second electrode of the ninth control transistor is electrically connected to the control signal terminal;
a gate electrode of the tenth control transistor is electrically connected to the nth stage of inverted signal output terminal, and a second electrode of the tenth control transistor is electrically connected to the control signal terminal;
The seventh control transistor and the tenth control transistor are both n-type transistors, and the eighth control transistor and the ninth control transistor are both p-type transistors; or,
The seventh control transistor and the tenth control transistor are both p-type transistors, and the eighth control transistor and the ninth control transistor are both n-type transistors.

Optionally, the control signal generation circuit includes a seventh control transistor and an eighth control transistor;
a gate electrode of the seventh control transistor is electrically connected to the enable signal line, a first electrode of the seventh control transistor is electrically connected to the first voltage line, and a second electrode of the seventh control transistor is electrically connected to the control signal terminal;
a gate electrode of the eighth control transistor is electrically connected to the enable signal line, a first electrode of the eighth control transistor is electrically connected to the control signal terminal, and a second electrode of the eighth control transistor is electrically connected to the second voltage line;
The seventh control transistor is a p-type transistor, and the eighth control transistor is an n-type transistor; or, the seventh control transistor is an n-type transistor, and the eighth control transistor is a p-type transistor.

Optionally, the output inverting circuit includes an eleventh control transistor and a twelfth control transistor;
a gate electrode of the eleventh control transistor is electrically connected to the nth stage of driving signal output terminal, a first electrode of the eleventh control transistor is electrically connected to the nth stage of inverted signal output terminal, and a second electrode of the eleventh control transistor is electrically connected to the second voltage line;
a gate electrode of the twelfth control transistor is electrically connected to the nth stage of driving signal output terminal, a first electrode of the twelfth control transistor is electrically connected to the first voltage line, and a second electrode of the twelfth control transistor is electrically connected to the nth stage of inverted signal output terminal.

In at least one embodiment of the present disclosure, the driving signal generation circuit includes a first node control circuit, a second node control circuit, a first output node control circuit, a second output node control circuit, a potential maintaining circuit and an output circuit; the first clock signal line includes a first first clock signal line, and the second clock signal line includes a first second clock signal line;
The first node control circuit is electrically connected to the first node, the first first clock signal line, the second voltage line, and the second output node, respectively, and is configured to control the connection between the first node and the second voltage line under the control of the first clock signal provided by the first first clock signal line, and to control the connection or disconnection between the first node and the first first clock signal line under the control of the potential of the second output node;
The second node control circuit is electrically connected to the first node, the first intermediate node, the first voltage line, the first second clock signal line, the second node, the input terminal and the second voltage line respectively, and is configured to control the first intermediate node to be connected to the first voltage line under the control of the potential of the first node, control the first intermediate node to be connected to the first second clock signal line under the control of the potential of the second node, and control the potential of the second node according to the potential of the first intermediate node, and control the input terminal to be connected to the second node under the control of the second clock signal provided by the first second clock signal line and the second voltage signal provided by the second voltage line;
The first output node control circuit is electrically connected to the first output node, the first node, the first second clock signal line, the second intermediate node, the second output node and the first voltage line respectively, and is configured to control the second intermediate node to be connected to the first second clock signal line under the control of the potential of the first node, control the potential of the second intermediate node according to the potential of the first node, control the second intermediate node to be connected to the first output node under the control of the second clock signal provided by the first second clock signal line, and control the first output node to be connected to the first voltage line under the control of the potential of the second output node;
The second output node control circuit is electrically connected to the first second clock signal line, the input terminal, the control voltage line, the first voltage line, the second node, and the second output node, respectively, and is configured to control the second output node to be connected to the input terminal under the control of the second clock signal provided by the first second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

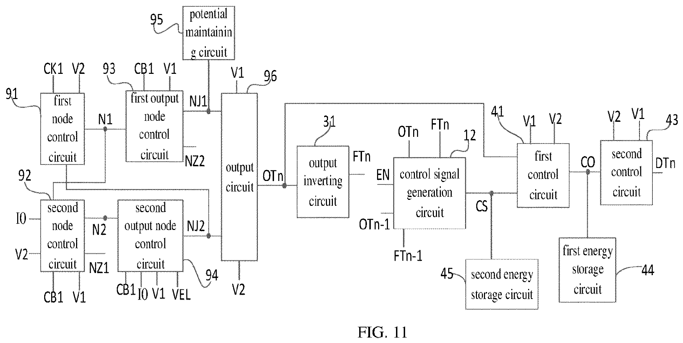

As shown in FIG. 11, based on one embodiment of the driving circuit shown in FIG.8, the driving signal generation circuit includes a first node control circuit 91, a second node control circuit 92, a first output node control circuit 93, a second output node control circuit 94, a potential maintaining circuit 95 and an output circuit 96; the first clock signal line includes a first first clock signal line CK1, and the second clock signal line includes a first second clock signal line CB1;
The first node control circuit 91 is electrically connected to the first node N1, the first first clock signal line CK1, the second voltage line V2 and the second output node NJ2 respectively, and is configured to control the connection between the first node N1 and the second voltage line V2 under the control of the first clock signal provided by the first first clock signal line CK1, and to control the connection or disconnection between the first node N1 and the first first clock signal line CK1 under the control of the potential of the second output node NJ2;
The second node control circuit 92 is electrically connected to the first node N1, the first intermediate node NZ1, the first voltage line V1, the first second clock signal line CB1, the second node N2, the input terminal I0 and the second voltage line V2, respectively, and is configured to control the connection between the first intermediate node NZ1 and the first voltage line V1 under the control of the potential of the first node N1, control the connection between the first intermediate node NZ1 and the first second clock signal line CB1 under the control of the potential of the second node N2, and control the potential of the second node N2 according to the potential of the second intermediate node NZ2, and control the connection between the input terminal I0 and the second node N2 under the control of the second clock signal provided by the first second clock signal line CB1 and the second voltage signal provided by the second voltage line V2;
The first output node control circuit 93 is electrically connected to the first output node NJ1, the first node N1, the first second clock signal line CB1, the second intermediate node NZ2, the second output node NJ2 and the first voltage line V1, respectively, and is configured to control the second intermediate node NZ2 to be connected to the first second clock signal line CB1 under the control of the potential of the first node N1, control the potential of the second intermediate node NZ2 according to the potential of the first node N1, control the second intermediate node NZ2 to be connected to the first output node NJ1 under the control of the second clock signal provided by the first second clock signal line CB1, and control the first output node NJ1 to be connected to the first voltage line V1 under the control of the potential of the second output node NJ2;
The second output node control circuit 94 is electrically connected to the first second clock signal line CB1, the input terminal I0, the control voltage line VEL, the first voltage line V1, the second node N2 and the second output node NJ2, respectively, and is configured to control the second output node NJ2 to be connected to the input terminal I0 under the control of the second clock signal provided by the first second clock signal line CB1, control the potential of the second output node NJ2 according to the potential of the second node N2, and control the second output node NJ2 to be connected to the first voltage line V1 under the control of the control voltage provided by the control voltage line VEL;
The potential maintaining circuit 95 is electrically connected to the first output node NJ1 and is configured to maintain the potential of the first output node NJ1;
The output circuit 96 is electrically connected to the first output node NJ1, the second output node NJ2, the first voltage line V1, the second voltage line V2 and the nth stage of driving signal output terminal OTn, respectively, and is configured to control the connection between the nth stage of driving signal output terminal OTn and the first voltage line V1 under the control of the potential of the first output node NJ1, and to control the connection between the nth stage of driving signal output terminal OTn and the second voltage line V2 under the control of the potential of the second output node NJ2.

In at least one embodiment of the present disclosure, the driving signal generation circuit includes a first node control circuit, a second node control circuit, a first output node control circuit, a second output node control circuit, a potential maintaining circuit and an output circuit; the first clock signal line includes a second first clock signal line, and the second clock signal line includes a second second clock signal line;
The first node control circuit is electrically connected to the first node, the second first clock signal line, the second voltage line, and the second output node, respectively, and is configured to control the connection between the first node and the second voltage line under the control of the first clock signal provided by the second first clock signal line, and to control the connection or disconnection between the first node and the second first clock signal line under the control of the potential of the second output node;
The second node control circuit is electrically connected to the first node, the first intermediate node, the first voltage line, the second second clock signal line, the second node, the input terminal and the second voltage line respectively, and is configured to control the connection between the first intermediate node and the first voltage line under the control of the potential of the first node, control the connection between the first intermediate node and the second second clock signal line under the control of the potential of the second node, and control the potential of the second node according to the potential of the first intermediate node, and control the connection between the input terminal and the second node under the control of the second clock signal provided by the second second clock signal line and the second voltage signal provided by the second voltage line;
The first output node control circuit is electrically connected to the first output node, the first node, the second second clock signal line, the second intermediate node, the second output node and the first voltage line respectively, and is configured to control the second intermediate node to be connected to the second second clock signal line under the control of the potential of the first node, control the potential of the second intermediate node according to the potential of the first node, control the second intermediate node to be connected to the first output node under the control of the second clock signal provided by the second second clock signal line, and control the first output node to be connected to the first voltage line under the control of the potential of the second output node;
The second output node control circuit is electrically connected to the second second clock signal line, the input terminal, the control voltage line, the first voltage line, the second node, and the second output node, respectively, and is configured to control the second output node to be connected to the input terminal under the control of the second clock signal provided by the second second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

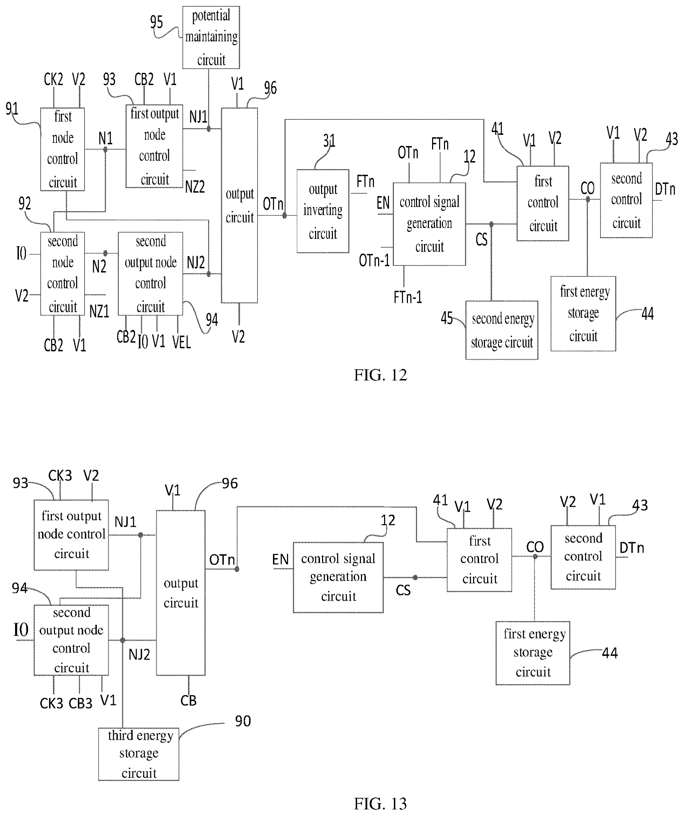

As shown in FIG. 12, based on one embodiment of the driving circuit shown in FIG.9, the driving signal generation circuit includes a first node control circuit 91, a second node control circuit 92, a first output node control circuit 93, a second output node control circuit 94, a potential maintaining circuit 95 and an output circuit 96;
The first node control circuit 91 is electrically connected to the first node N1, the second first clock signal line CK2, the second voltage line V2 and the second output node NJ2 respectively, and is configured to control the connection between the first node N1 and the second voltage line V2 under the control of the first clock signal provided by the second first clock signal line CK2, and to control the connection or disconnection between the first node N1 and the second first clock signal line CK2 under the control of the potential of the second output node NJ2;
The second node control circuit 92 is electrically connected to the first node N1, the first intermediate node NZ1, the first voltage line V1, the second second clock signal line CB2, the second node N2, the input terminal I0 and the second voltage line V2, respectively, and is configured to control the connection between the first intermediate node NZ1 and the first voltage line V1 under the control of the potential of the first node N1, control the connection between the first intermediate node NZ1 and the second second clock signal line CB2 under the control of the potential of the second node N2, and control the potential of the second node N2 according to the potential of the second intermediate node NZ2, and control the connection between the input terminal and the second node N2 under the control of the second clock signal provided by the second second clock signal line CB2 and the second voltage signal provided by the second voltage line V2;
The first output node control circuit 93 is electrically connected to the first output node NJ1, the first node N1, the second second clock signal line CB2, the second intermediate node NZ2, the second output node NJ2 and the first voltage line V1, respectively, and is configured to control the second intermediate node NZ2 to be connected to the second second clock signal line CB2 under the control of the potential of the first node N1, control the potential of the second intermediate node NZ2 according to the potential of the first node N1, control the second intermediate node NZ2 to be connected to the first output node NJ1 under the control of the second clock signal provided by the second second clock signal line CB2, and control the first output node NJ1 to be connected to the first voltage line V1 under the control of the potential of the second output node NJ2;
The second output node control circuit 94 is electrically connected to the second second clock signal line CB2, the input terminal I0, the control voltage line VEL, the first voltage line V1, the second node N2 and the second output node NJ2, respectively, and is configured to control the second output node NJ2 to be connected to the input terminal I0 under the control of the second clock signal provided by the second second clock signal line CB2, control the potential of the second output node NJ2 according to the potential of the second node N2, and control the second output node NJ2 to be connected to the first voltage line V1 under the control of the control voltage provided by the control voltage line VEL;
The potential maintaining circuit 95 is electrically connected to the first output node NJ1 and is configured to maintain the potential of the first output node NJ1;
The output circuit 96 is electrically connected to the first output node NJ1, the second output node NJ2, the first voltage line V1, the second voltage line V2 and the nth stage of driving signal output terminal OTn, respectively, and is configured to control the connection between the nth stage of driving signal output terminal OTn and the first voltage line V1 under the control of the potential of the first output node NJ1, and to control the connection between the nth stage of driving signal output terminal OTn and the second voltage line V2 under the control of the potential of the second output node NJ2.

Optionally, the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the first first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the first first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the first first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
The second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the first second clock signal line, and a second electrode of the eighth transistor is electrically connected to the first intermediate node;
a gate electrode of the ninth transistor is electrically connected to the second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the first first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
The first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the first second clock signal line, and a second electrode of the twelfth transistor is electrically connected to the second intermediate node;
a gate electrode of the thirteenth transistor is electrically connected to the first second clock signal line, a first electrode of the thirteenth transistor is electrically connected to the second intermediate node, and a second electrode of the thirteenth transistor is electrically connected to the first output node;
a gate electrode of the fourteenth transistor is electrically connected to the first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and a second electrode plate of the fourth capacitor is electrically connected to the second intermediate node;
The potential maintaining circuit includes a fifth capacitor;
a first electrode plate of the fifth capacitor is electrically connected to the first output node, and a second electrode plate of the fifth capacitor is electrically connected to the first voltage line;
The output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
A gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

Optionally, the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the second first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the second first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the second first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
The second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the second second clock signal line, and a second electrode of the eighth transistor is electrically connected to the first intermediate node;
a gate electrode of the ninth transistor is electrically connected to a second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the second first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
The first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the second second clock signal line, and a second electrode of the twelfth transistor is electrically connected to the second intermediate node;
a gate electrode of the thirteenth transistor is electrically connected to the second second clock signal line, a first electrode of the thirteenth transistor is electrically connected to the second intermediate node, and a second electrode of the thirteenth transistor is electrically connected to the first output node;
a gate electrode of the fourteenth transistor is electrically connected to a first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and the second electrode plate of the fourth capacitor is electrically connected to the second intermediate node;
The potential maintaining circuit includes a fifth capacitor;
a first electrode plate of the fifth capacitor is electrically connected to the first output node, and a second electrode plate of the fifth capacitor is electrically connected to the first voltage line;
The output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
A gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

In at least one embodiment of the present disclosure, the driving signal generation circuit includes a first output node control circuit, a second output node control circuit, a third energy storage circuit and an output circuit; the first clock signal line includes a third first clock signal line, and the second clock signal line includes a third second clock signal line;
The first output node control circuit is electrically connected to the third first clock signal line, the second voltage line and the second output node respectively, and is configured to control the first output node to be connected to the second voltage line under the control of the first clock signal provided by the third first clock signal line, and to control the first output node to be connected to the third first clock signal line under the control of the potential of the second output node, and to maintain the potential of the first output node;
The second output node control circuit is electrically connected to the second output node, the third first clock signal line, the input terminal, the third second clock signal line, the first output node and the first voltage line respectively, and is configured to control the second output node to be connected to the input terminal under the control of the first clock signal, and to control the second output node to be connected to the first voltage line under the control of the potential of the first output node and the second clock signal provided by the third second clock signal line;
a first terminal of the third energy storage circuit is electrically connected to the second output node, a second terminal of the third energy storage circuit is electrically connected to the nth stage of driving signal output terminal, and the third energy storage circuit is configured to store electric energy;
The output circuit is electrically connected to the first output node, the second output node, the first voltage line, the second clock signal and the nth stage of driving signal output terminal, respectively, and is configured to control the connection between the nth stage of driving signal output terminal and the first voltage line under the control of the potential of the first output node, and to control the connection between the nth stage of driving signal output terminal and the third second clock signal line under the control of the potential of the second output node.

As shown in FIG. 13, based on one embodiment of the driving circuit shown in FIG. 10, the driving signal generation circuit includes a first output node control circuit 93, a second output node control circuit 94, a third energy storage circuit 90 and an output circuit 96; the first clock signal line includes a third first clock signal line CK3, and the second clock signal line includes a third second clock signal line CB3;
The first output node control circuit 93 is electrically connected to the third first clock signal line CK3, the second voltage line V2, the first output node NJ1 and the second output node NJ2 respectively, and is configured to control the connection between the first output node NJ1 and the second voltage line V2 under the control of the first clock signal provided by the third first clock signal line CK3, and to control the connection between the first output node NJ1 and the first clock signal line CK under the control of the potential of the second output node NJ2, and to maintain the potential of the first output node NJ1;
The second output node control circuit 94 is electrically connected to the second output node NJ2, the third first clock signal line CK3, the input terminal I0, the third second clock signal line CB3, the first output node NJ1 and the first voltage line V1, respectively, and is configured to control the second output node NJ2 to be connected to the input terminal I0 under the control of the first clock signal, and to control the second output node NJ2 to be connected to the first voltage line V1 under the control of the potential of the first output node NJ1 and the second clock signal provided by the third second clock signal line CB3;
A first terminal of the third energy storage circuit 90 is electrically connected to the second output node NJ2, a second terminal of the third energy storage circuit 90 is electrically connected to the nth stage of driving signal output terminal OTn, and the third energy storage circuit 90 is configured to store electric energy;
The output circuit 96 is electrically connected to the first output node NJ1, the second output node NJ2, the first voltage line V1, the second clock signal CB and the nth stage of driving signal output terminal OTn, respectively, and is configured to control the connection between the nth stage of driving signal output terminal OTn and the first voltage line V1 under the control of the potential of the first output node NJ1, and to control the connection between the nth stage of driving signal output terminal OTn and the third second clock signal line CB3 under the control of the potential of the second output node NJ2.

Optionally, the first output node control circuit includes a seventeenth transistor, an eighteenth transistor and a sixth capacitor;
a gate electrode of the seventeenth transistor is electrically connected to the third first clock signal line, a first electrode of the seventeenth transistor is electrically connected to the second voltage line, and a second electrode of the seventeenth transistor is electrically connected to the first output node;
A gate electrode of the eighteenth transistor is electrically connected to the second output node, a first electrode of the eighteenth transistor is electrically connected to the third first clock signal line, and a second electrode of the eighteenth transistor is electrically connected to the first output node;
a first electrode plate of the sixth capacitor is electrically connected to the first output node, and a second electrode plate of the sixth capacitor is electrically connected to the first voltage line;
The second output node control circuit includes a nineteenth transistor, a twentieth transistor, and a twenty first transistor; the third energy storage circuit includes a seventh capacitor;
a gate electrode of the nineteenth transistor is electrically connected to the third first clock signal line, a first electrode of the nineteenth transistor is electrically connected to the input terminal, and a second electrode of the nineteenth transistor is electrically connected to the second output node;
A gate electrode of the twentieth transistor is electrically connected to the first output node, a first electrode of the twentieth transistor is electrically connected to the first voltage line, and a second electrode of the twentieth transistor is electrically connected to a first electrode of the twenty first transistor;
A gate electrode of the twenty first transistor is electrically connected to the third second clock signal line, and a second electrode of the twenty first transistor is electrically connected to the second output node;
a first electrode plate of the seventh capacitor is electrically connected to the second output node, and a second electrode plate of the seventh capacitor is electrically connected to the nth stage of driving signal output terminal;
The output circuit includes a twenty second transistor and a twenty third transistor;
A gate electrode of the twenty second transistor is electrically connected to the first output node, a first electrode of the twenty second transistor is electrically connected to the first voltage line, and a second electrode of the twenty second transistor is electrically connected to the nth stage of driving signal output terminal;
a gate electrode of the twenty third transistor is electrically connected to the second output node, a first electrode of the twenty third transistor is electrically connected to the nth stage of driving signal output terminal, and a second electrode of the twenty third transistor is electrically connected to the third second clock signal line;
The driving circuit further includes a twenty fourth transistor;
A second electrode of the twenty first transistor is electrically connected to the second output node through the twenty fourth transistor; a gate electrode of the twenty fourth transistor is electrically connected to the second voltage line, a first electrode of the twenty fourth transistor is electrically connected to a second electrode of the twenty first transistor, and a second electrode of the twenty fourth transistor is electrically connected to the second output node.

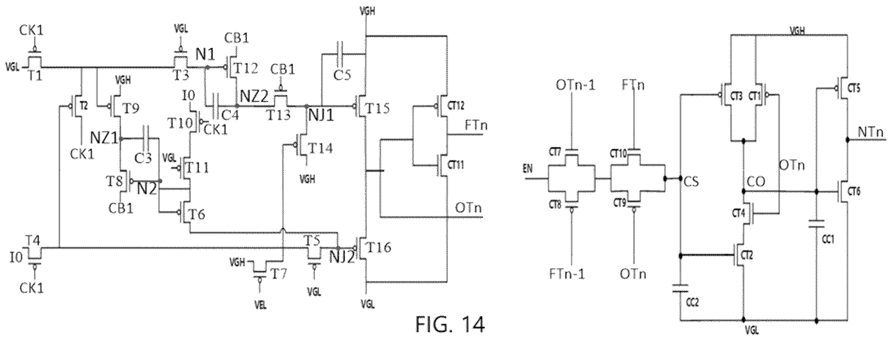

As shown in FIG. 14, based on at least one embodiment of the driving circuit shown in FIG. 11, the nth stage of driving output terminal is the nth stage of first scanning terminal NTn;
The first control circuit includes a first control transistor CT1, a second control transistor CT2, a third control transistor CT3 and a fourth control transistor CT4; the second control circuit includes a fifth control transistor CT5 and a sixth control transistor CT6; the first energy storage circuit includes a first capacitor CC1;
The gate electrode of the first control transistor CT1 is electrically connected to the nth stage of driving signal output terminal OTn, the source electrode of the first control transistor CT1 is electrically connected to the high voltage line VGH, and the drain electrode of the first control transistor CT1 is electrically connected to the control output terminal CO;
The gate electrode of the second control transistor CT2 is electrically connected to the control signal terminal CS, the source electrode of the second control transistor CT2 is electrically connected to the drain electrode of the fourth control transistor CT4, and the drain electrode of the second control transistor CT2 is electrically connected to the low voltage line VGL;
The gate electrode of the third control transistor CT3 is electrically connected to the control signal terminal CS, the source electrode of the third control transistor CT3 is electrically connected to the high voltage line VGH, and the drain electrode of the third control transistor CT3 is electrically connected to the control output terminal CO;
The gate electrode of the fourth control transistor CT4 is electrically connected to the nth stage of driving signal output terminal OTn, and the source electrode of the fourth control transistor CT4 is electrically connected to the control output terminal CO;
The gate electrode of the fifth control transistor CT5 is electrically connected to the control output terminal CO, the source electrode of the fifth control transistor CT5 is electrically connected to the high voltage line VGH, and the drain electrode of the fifth control transistor CT5 is electrically connected to the nth stage of first scanning terminal NTn;
The gate electrode of the sixth control transistor CT6 is electrically connected to the control output terminal CO, the source electrode of the sixth control transistor CT6 is electrically connected to the nth stage first scanning terminal NTn, and the drain electrode of the sixth control transistor CT6 is electrically connected to the low voltage line VGL;
A first terminal of the first capacitor CC1 is electrically connected to the control output terminal CO, and a second terminal of the first capacitor CC1 is electrically connected to the low voltage line VGL;
The second energy storage circuit includes a second capacitor CC2;
A first terminal of the second capacitor CC2 is electrically connected to the control signal terminal CS, and a second terminal of the second capacitor CC2 is electrically connected to the low voltage line VGL;
The control signal generation circuit includes a seventh control transistor CT7, an eighth control transistor CT8, a ninth control transistor CT9 and a tenth control transistor CT10;
The gate electrode of the seventh control transistor CT7 is electrically connected to the (n-1)th stage of driving signal output terminal OTn-1, the source electrode of the seventh control transistor CT7 is electrically connected to the enable signal line EN, and the drain electrode of the seventh control transistor CT7 is electrically connected to the source electrode of the tenth control transistor CT10;
The gate electrode of the eighth control transistor CT8 is electrically connected to the (n-1)th stage of inverted signal output terminal FTn-1, the source electrode of the eighth control transistor CT8 is electrically connected to the enable signal line EN, and the drain electrode of the eighth control transistor CT8 is electrically connected to the source electrode of the ninth control transistor CT9;
The gate electrode of the ninth control transistor CT9 is electrically connected to the nth stage of driving signal output terminal OTn, the source electrode of the ninth control transistor CT9 is electrically connected to the source electrode of the tenth control transistor CT10, and the drain electrode of the ninth control transistor CT9 is electrically connected to the control signal terminal CS;
The gate electrode of the tenth control transistor CT10 is electrically connected to the nth stage of inverted signal output terminal FTn, and the drain electrode of the tenth control transistor CT10 is electrically connected to the control signal terminal CS;
The output inverting circuit includes an eleventh control transistor CT11 and a twelfth control transistor CT12;
The gate electrode of the eleventh control transistor CT11 is electrically connected to the nth stage of driving signal output terminal OTn, the source electrode of the eleventh control transistor CT11 is electrically connected to the nth stage of inverted signal output terminal FTn, and the drain electrode of the eleventh control transistor CT11 is electrically connected to the low voltage line VGL;
The gate electrode of the twelfth control transistor CT12 is electrically connected to the nth stage of driving signal output terminal OTn, the source electrode of the twelfth control transistor CT12 is electrically connected to the high voltage line VGH, and the drain electrode of the twelfth control transistor CT12 is electrically connected to the nth stage of inverted signal output terminal FTn;
The first node control circuit includes a first transistor T1, a second transistor T2 and a third transistor T3; the second output node control circuit includes a fourth transistor T4, a fifth transistor T5, a sixth transistor T6 and a seventh transistor T7;
The gate electrode of the first transistor T1 is electrically connected to the first first clock signal line CK1, the source electrode of the first transistor T1 is electrically connected to the low voltage line VGL, and the drain electrode of the first transistor T1 is electrically connected to the source electrode of the third transistor T3;
The gate electrode of the second transistor T2 is electrically connected to the drain electrode of the fourth transistor T4, the source electrode of the second transistor T2 is electrically connected to the first first clock signal line CK1, and the drain electrode of the second transistor T2 is electrically connected to the source electrode of the third transistor T3;
A gate electrode of the third transistor T3 is electrically connected to the low voltage line VGL, and a drain electrode of the third transistor T3 is electrically connected to the first node N1;
The gate electrode of the fourth transistor T4 is electrically connected to the first first clock signal line CK1, and the source electrode of the fourth transistor T4 is electrically connected to the input terminal I0;
The gate electrode of the fifth transistor T5 is electrically connected to the low voltage line VGL, the source electrode of the fifth transistor T5 is electrically connected to the drain electrode of the fourth transistor T4, and the drain electrode of the fifth transistor T5 is electrically connected to the second output node NJ2;
The gate electrode of the sixth transistor T6 and the source electrode of the sixth transistor T6 are both electrically connected to the second node N2, and the drain electrode of the sixth transistor T6 is electrically connected to the second output node NJ2;
The gate electrode of the seventh transistor T7 is electrically connected to the control voltage line VEL, the source electrode of the seventh transistor T7 is electrically connected to the high voltage line VGH, and the drain electrode of the seventh transistor T7 is electrically connected to the source electrode of the fifth transistor T5;
The second node control circuit includes an eighth transistor T8, a ninth transistor T9, a tenth transistor T10, an eleventh transistor T11 and a third capacitor C3;
The gate electrode of the eighth transistor T8 is electrically connected to the second node N2, the source electrode of the eighth transistor T8 is electrically connected to the first second clock signal line CB1, and the drain electrode of the eighth transistor T8 is electrically connected to the first intermediate node NZ1;
The gate electrode of the ninth transistor T9 is electrically connected to the drain electrode of the first transistor T1, the source electrode of the ninth transistor T9 is electrically connected to the high voltage line VGH, and the drain electrode of the ninth transistor T9 is electrically connected to the first intermediate node NZ1;
The gate electrode of the tenth transistor T10 is electrically connected to the first first clock signal line CK1, the source electrode of the tenth transistor T10 is electrically connected to the input terminal I0, and the drain electrode of the tenth transistor T10 is electrically connected to the source electrode of the eleventh transistor T11;
A gate electrode of the eleventh transistor T11 is electrically connected to the low voltage line VGL, and a drain electrode of the eleventh transistor T11 is electrically connected to the second node N2;
The first electrode plate of the third capacitor C3 is electrically connected to the second node N2, and the second electrode plate of the third capacitor C3 is electrically connected to the first intermediate node NZ1;
The first output node control circuit includes a twelfth transistor T12, a thirteenth transistor T13, a fourteenth transistor T14 and a fourth capacitor C4;
The gate electrode of the twelfth transistor T12 is electrically connected to the first node N1, the source electrode of the twelfth transistor T12 is electrically connected to the first second clock signal line CB1, and the drain electrode of the twelfth transistor T12 is electrically connected to the second intermediate node NZ2;
The gate electrode of the thirteenth transistor T13 is electrically connected to the first second clock signal line CB1, the source electrode of the thirteenth transistor T13 is electrically connected to the second intermediate node NZ2, and the drain electrode of the thirteenth transistor T13 is electrically connected to the first output node NJ1;
The gate electrode of the fourteenth transistor T14 is electrically connected to the source electrode of the fifth transistor T5, the source electrode of the fourteenth transistor T14 is electrically connected to the high voltage line VGH, and the drain electrode of the fourteenth transistor T14 is electrically connected to the first output node NJ1;
The first electrode plate of the fourth capacitor C4 is electrically connected to the first node N1, and the second electrode plate of the fourth capacitor C4 is electrically connected to the second intermediate node NZ2;
The potential maintaining circuit includes a fifth capacitor C5;
The first electrode plate of the fifth capacitor C5 is electrically connected to the first output node NJ1, and the second electrode plate of the fifth capacitor C5 is electrically connected to the high voltage line VGH;
The output circuit includes a fifteenth transistor T15 and a sixteenth transistor T16;
The gate electrode of the fifteenth transistor T15 is electrically connected to the first output node NJ1, the source electrode of the fifteenth transistor T15 is electrically connected to the high voltage line VGH, and the drain electrode of the fifteenth transistor T15 is electrically connected to the nth stage of driving signal output terminal OTn;
The gate electrode of the sixteenth transistor T16 is electrically connected to the second output node NJ2, the source electrode of the sixteenth transistor T16 is electrically connected to the nth stage of driving signal output terminal OTn, and the drain electrode of the sixteenth transistor T16 is electrically connected to the low voltage line VGL.

In at least one embodiment of the driving circuit shown in FIG. 14, T1-T16 can be p-type transistors, CT11 is an n-type transistor, CT12 is a p-type transistor, CT7 is an n-type transistor, CT8 is a p-type transistor, CT10 is an n-type transistor, CT9 is a p-type transistor, CT1 is a p-type transistor, CT2 is an n-type transistor, CT3 is a p-type transistor, CT4 is an n-type transistor, CT5 is a p-type transistor, and CT6 is an n-type transistor.

In at least one embodiment of the driving circuit shown in FIG. 14, the driving signal generation circuit is a 16T3C circuit. In actual operation, the driving signal generation circuit may also be a circuit having other structures for generating an nth stage of driving signal.

In at least one embodiment of the driving circuit shown in FIG. 14, T3 and T5 may not be provided.

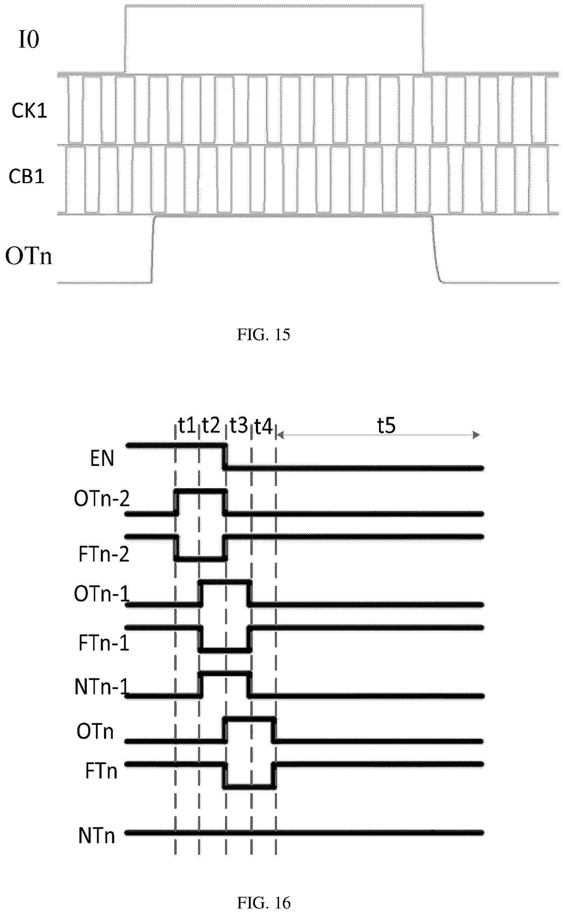

FIG. 15 is the timing diagram of the driving signal generation circuit in the driving circuit shown in FIG. 14.

When the driving circuit shown in FIG. 14 is working, when the display device including the driving circuit just starts to work, VEL provides a low voltage signal and T7 is turned on to control the connection between the gate electrode of T14 and VGH, so that T14 is turned off; thereafter, when the driving circuit is working, VEL always provides a high voltage signal, so that T7 is turned off.

FIG. 16 is a timing diagram of the (n-1)th stage of driving circuit and the nth stage of driving circuit; the structure of the nth stage of driving circuit is shown in FIG.14;
The structure of the (n-1)th stage of driving circuit is the same as the structure of the nth stage of driving circuit shown in FIG.14. The differences between the structure of the (n-1)th stage of driving circuit and the nth stage of driving circuit shown in FIG.14 include:
The drain electrode of T15 is electrically connected to the (n-1)th stage of driving signal output terminal OTn-1, and the drain electrode of CT12 is electrically connected to the (n-1)th stage of inverted signal output terminal FTn-1;
The gate electrode of CT9 is electrically connected to the (n-2)th stage of driving signal output terminal OTn-2, the gate electrode of CT8 is electrically connected to the (n-2)th stage of inverted signal output terminal FTn-2, the gate electrode of CT10 is electrically connected to the (n-1)th stage of inverted signal output terminal FTn-1, the gate electrode of CT7, the gate electrode of CT3 and the gate electrode of CT4 are electrically connected to the (n-1)th stage of driving signal output terminal OTn-1, and the drain electrode of CT5 is electrically connected to the (n-1)th stage of first scanning terminal NTn-1.

As shown in FIG. 15, when the (n-1)th stage of driving circuit and the nth stage of driving circuit are working,
In the first phase t1, EN outputs a high voltage signal, OTn-2 provides a high voltage signal, FTn-2 provides a low voltage signal, OTn-1 provides a low voltage signal, FTn-1 provides a high voltage signal, OTn provides a low voltage signal, and FTn provides a high voltage signal;
In the (n-1)th stage of driving circuit, CT7 and CT8 are turned on, CT9 and CT10 are turned on, EN is connected to CS, and the potential of CS is high voltage; OTn-1 provides a low voltage signal, CT1 is turned on, CO outputs a high voltage signal, CT4 is turned off, CT6 is turned on, CT5 is turned off, and NTn-1 outputs a low voltage signal;
In the nth stage of driving circuit, CT7 and CT8 are turned off, EN is disconnected from CS; OTn provides a low voltage signal, CT1 is turned on, CO outputs a high voltage signal, CT6 is turned on, and NTn outputs a low voltage signal;
In the second phase t2, EN provides a high voltage signal, OTn-2 provides a high voltage signal, FTn-2 provides a low voltage signal, OTn-1 provides a high voltage signal, FTn-1 provides a low voltage signal, OTn provides a low voltage signal, and FTn provides a high voltage signal;
In the (n-1)th stage of driving circuit, CT7 and CT8 are turned on, CT9 and CT10 are turned off, EN is disconnected from CS, and the potential of CS is maintained at a high voltage; CT3 is turned off, OTn-1 provides a high voltage signal, CT4 is turned on, CT2 is turned on, CO outputs a low voltage signal, CT5 is turned on, and NTn-1 provides a high voltage signal;
In the nth stage of driving circuit, CT7 and CT8 are turned on, CT9 and CT10 are turned on, EN is connected to CS, the potential of CS is a high voltage signal, CT3 is turned off, OTn outputs a low voltage signal, CT1 is turned on, CO outputs a high voltage signal, CT6 is turned on, and NTn provides a low voltage signal;
In the third phase t3, EN provides a low voltage signal, OTn-2 provides a low voltage signal, FTn-2 provides a high voltage signal, OTn-1 provides a high voltage signal, FTn-1 provides a low voltage signal, OTn provides a high voltage signal, and FTn provides a low voltage signal;
In the (n-1)th stage of driving circuit, CT7 and CT8 are turned off, EN is disconnected from CS, CC2 maintains the potential of CS at a high voltage; OTn-1 provides a high voltage signal, CT2 and CT4 are turned on, CO outputs a low voltage signal, CT5 is turned on, and NTn-1 provides a high voltage signal;
In the nth stage of driving circuit, CT9 and CT10 are turned off, EN is disconnected from CS, the potential of CS is high voltage, OTn provides a high voltage signal, CT2 and CT4 are both turned on, CO outputs a high voltage signal, CT6 is turned on, and NTn provides a low voltage signal;
In the fourth phase t4, EN provides a low voltage signal, OTn-2 provides a low voltage signal, FTn-2 provides a high voltage signal, OTn-1 provides a low voltage signal, FTn-1 provides a high voltage signal, OTn provides a high voltage signal, and FTn provides a low voltage signal;
In the (n-1)th stage of driving circuit, CT7 and CT8 are turned off, EN is disconnected from CS, CC2 maintains the potential of CS at a low voltage; OTn-1 provides a low voltage signal, CT1 is turned on, CO outputs a high voltage signal, CT6 is turned on, and NTn-1 provides a low voltage signal;
In the nth stage of driving circuit, CT7 and CT8 are turned off, EN is disconnected from CS, the potential of CS is high voltage, OTn provides a high voltage signal, CT2 and CT4 are both turned on, CO outputs a high voltage signal, CT6 is turned on, and NTn provides a low voltage signal;
In the fifth phase t5, EN provides a low voltage signal, OTn-2 provides a low voltage signal, FTn-2 provides a high voltage signal, OTn-1 provides a low voltage signal, FTn-1 provides a high voltage signal, OTn provides a low voltage signal, and FTn provides a high voltage signal;
In the (n-1)th stage of driving circuit, CT7 and CT8 are turned off, EN is disconnected from CS, CC2 maintains the potential of CS at a low voltage; CT3 is turned on, CO outputs a high voltage signal, CT6 is turned on, NTn-1 provides low voltage signal;
In the nth stage of driving circuit, CT7 and CT8 are turned off, EN is disconnected from CS, the potential of CS is high voltage, OTn provides a low voltage signal, CT1 is turned on, CO outputs a high voltage signal, CT6 is turned on, and NTn provides a low voltage signal.

As shown in FIG.16, NTn provides an invalid voltage signal, and NTn-1 provides a valid (n-1)th stage of first scanning signal, which can control the transistor whose gate electrode is electrically connected to NTn in the nth row of pixel circuit to be turned off, so as not to perform scanning; when the potential of the (n-1)th stage of first scanning signal is a valid voltage, the transistor whose gate electrode is electrically connected to NTn-1 in the (n-1)th row of pixel circuits is controlled to be turned on so as to perform normal scanning; so as to achieve the purpose of partial refresh;
Since the transistor in the pixel circuit electrically connected to NTn is an n-type transistor, the invalid voltage signal provided by NTn is a low voltage signal.

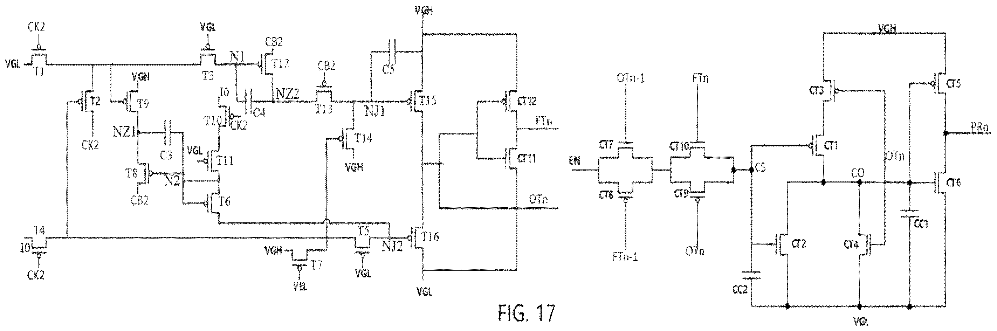

As shown in FIG. 17, based on at least one embodiment of the driving circuit shown in FIG. 12, the nth stage of driving output terminal is the nth stage of first reset terminal PRn;
The first control circuit includes a first control transistor CT1, a second control transistor CT2, a third control transistor CT3 and a fourth control transistor CT4; the second control circuit includes a fifth control transistor CT5 and a sixth control transistor CT6; the first energy storage circuit includes a first capacitor CC1; the first control voltage line is a second voltage line, and the second control voltage line is a first voltage line;
The gate electrode of the first control transistor CT1 is electrically connected to the control signal terminal CS, the source electrode of the first control transistor CT1 is electrically connected to the drain electrode of the third control transistor CT3, and the drain electrode of the first control transistor CT1 is electrically connected to the control output terminal CO;
The gate electrode of the second control transistor CT2 is electrically connected to the control signal terminal CS, the source electrode of the second control transistor CT2 is electrically connected to the control output terminal CO, and the drain electrode of the second control transistor CT2 is electrically connected to the low voltage line VGL;
The gate electrode of the third control transistor CT3 is electrically connected to the nth stage of driving signal output terminal OTn, and the source electrode of the third control transistor CT3 is electrically connected to the high voltage line VGH;
The gate electrode of the fourth control transistor CT4 is electrically connected to the nth stage of driving signal output terminal OTn, the source electrode of the fourth control transistor CT4 is electrically connected to the control output terminal CO, and the drain electrode of the fourth control transistor CT4 is electrically connected to the low voltage line VGL;
The gate electrode of the fifth control transistor CT5 is electrically connected to the control output terminal CO, the source electrode of the fifth control transistor CT5 is electrically connected to the high voltage line VGH, and the drain electrode of the fifth control transistor CT5 is electrically connected to the nth stage of first reset terminal PRn;
The gate electrode of the sixth control transistor CT6 is electrically connected to the control output terminal CO, the source electrode of the sixth control transistor CT6 is electrically connected to the nth stage of first reset terminal PRn, and the drain electrode of the sixth control transistor CT6 is electrically connected to the low voltage line VGL;
A first terminal of the first capacitor CC1 is electrically connected to the control output terminal CO, and a second terminal of the first capacitor CC1 is electrically connected to the low voltage line VGL;
The second energy storage circuit includes a second capacitor CC2;
A first terminal of the second capacitor CC2 is electrically connected to the control signal terminal CS, and a second terminal of the second capacitor CC2 is electrically connected to the low voltage line VGL;
The control signal generation circuit includes a seventh control transistor CT7, an eighth control transistor CT8, a ninth control transistor CT9 and a tenth control transistor CT10;
The gate electrode of the seventh control transistor CT7 is electrically connected to the (n-1)th stage of driving signal output terminal OTn-1, the source electrode of the seventh control transistor CT7 is electrically connected to the enable signal line EN, and the drain electrode of the seventh control transistor CT7 is electrically connected to the source electrode of the tenth control transistor CT10;
The gate electrode of the eighth control transistor CT8 is electrically connected to the (n-1)th stage of inverted signal output terminal FTn-1, the source electrode of the eighth control transistor CT8 is electrically connected to the enable signal line EN, and the drain electrode of the eighth control transistor CT8 is electrically connected to the source electrode of the ninth control transistor CT9;
The gate electrode of the ninth control transistor CT9 is electrically connected to the nth stage of driving signal output terminal OTn, the source electrode of the ninth control transistor CT9 is electrically connected to the source electrode of the tenth control transistor CT10, and the drain electrode of the ninth control transistor CT9 is electrically connected to the control signal terminal CS;
The gate electrode of the tenth control transistor CT10 is electrically connected to the nth stage of inverted signal output terminal FTn, and the drain electrode of the tenth control transistor CT10 is electrically connected to the control signal terminal CS;
The output inverting circuit includes an eleventh control transistor CT11 and a twelfth control transistor CT12;
The gate electrode of the eleventh control transistor CT11 is electrically connected to the nth stage of driving signal output terminal OTn, the source electrode of the eleventh control transistor CT11 is electrically connected to the nth stage of inverted signal output terminal FTn, and the drain electrode of the eleventh control transistor CT11 is electrically connected to the low voltage line VGL;
The gate electrode of the twelfth control transistor CT12 is electrically connected to the nth stage of driving signal output terminal OTn, the source electrode of the twelfth control transistor CT12 is electrically connected to the high voltage line VGH, and the drain electrode of the twelfth control transistor CT12 is electrically connected to the nth stage of inverted signal output terminal FTn;
The first node control circuit includes a first transistor T1, a second transistor T2 and a third transistor T3; the second output node control circuit includes a fourth transistor T4, a fifth transistor T5, a sixth transistor T6 and a seventh transistor T7;
The gate electrode of the first transistor T1 is electrically connected to the second first clock signal line CK2, the source electrode of the first transistor T1 is electrically connected to the low voltage line VGL, and the drain electrode of the first transistor T1 is electrically connected to the source electrode of the third transistor T3;
The gate electrode of the second transistor T2 is electrically connected to the drain electrode of the fourth transistor T4, the source electrode of the second transistor T2 is electrically connected to the second first clock signal line CK2, and the drain electrode of the second transistor T2 is electrically connected to the source electrode of the third transistor T3;
The gate electrode of the third transistor T3 is electrically connected to the low voltage line VGL, and the drain electrode of the third transistor T3 is electrically connected to the first node N1;
The gate electrode of the fourth transistor T4 is electrically connected to the second first clock signal line CK2, and the source electrode of the fourth transistor T4 is electrically connected to the input terminal I0;
The gate electrode of the fifth transistor T5 is electrically connected to the low voltage line VGL, the source electrode of the fifth transistor T5 is electrically connected to the drain electrode of the fourth transistor T4, and the drain electrode of the fifth transistor T5 is electrically connected to the second output node NJ2;
The gate electrode of the sixth transistor T6 and the source electrode of the sixth transistor T6 are both electrically connected to the second node N2, and the drain electrode of the sixth transistor T6 is electrically connected to the second output node NJ2;
The gate electrode of the seventh transistor T7 is electrically connected to the control voltage line VEL, the source electrode of the seventh transistor T7 is electrically connected to the high voltage line VGH, and the drain electrode of the seventh transistor T7 is electrically connected to the source electrode of the fifth transistor T5;
The second node control circuit includes an eighth transistor T8, a ninth transistor T9, a tenth transistor T10, an eleventh transistor T11 and a third capacitor C3;
The gate electrode of the eighth transistor T8 is electrically connected to the second node N2, the source electrode of the eighth transistor T8 is electrically connected to the second second clock signal line CB2, and the drain electrode of the eighth transistor T8 is electrically connected to the first intermediate node NZ1;
The gate electrode of the ninth transistor T9 is electrically connected to the drain electrode of the first transistor T1, the source electrode of the ninth transistor T9 is electrically connected to the high voltage line VGH, and the drain electrode of the ninth transistor T9 is electrically connected to the first intermediate node NZ1;
The gate electrode of the tenth transistor T10 is electrically connected to the second first clock signal line CK2, the source electrode of the tenth transistor T10 is electrically connected to the input terminal I0, and the drain electrode of the tenth transistor T10 is electrically connected to the source electrode of the eleventh transistor T11;
A gate electrode of the eleventh transistor T11 is electrically connected to the low voltage line VGL, and a drain electrode of the eleventh transistor T11 is electrically connected to the second node N2;
The first electrode plate of the third capacitor C3 is electrically connected to the second node N2, and the second electrode plate of the third capacitor C3 is electrically connected to the first intermediate node NZ1;
The first output node control circuit includes a twelfth transistor T12, a thirteenth transistor T13, a fourteenth transistor T14 and a fourth capacitor C4;
The gate electrode of the twelfth transistor T12 is electrically connected to the first node N1, the source electrode of the twelfth transistor T12 is electrically connected to the second second clock signal line CB2, and the drain electrode of the twelfth transistor T12 is electrically connected to the second intermediate node NZ2;
The gate electrode of the thirteenth transistor T13 is electrically connected to the second second clock signal line CB, the source electrode of the thirteenth transistor T13 is electrically connected to the second intermediate node NZ2, and the drain electrode of the thirteenth transistor T13 is electrically connected to the first output node NJ1;
The gate electrode of the fourteenth transistor T14 is electrically connected to the source electrode of the fifth transistor T5, the source electrode of the fourteenth transistor T14 is electrically connected to the high voltage line VGH, and the drain electrode of the fourteenth transistor T14 is electrically connected to the first output node NJ1;
The first electrode plate of the fourth capacitor C4 is electrically connected to the first node N1, and the second electrode plate of the fourth capacitor C4 is electrically connected to the second intermediate node NZ2;
The potential maintaining circuit includes a fifth capacitor C5;
The first electrode plate of the fifth capacitor C5 is electrically connected to the first output node NJ1, and the second electrode plate of the fifth capacitor C5 is electrically connected to the high voltage line VGH;
The output circuit includes a fifteenth transistor T15 and a sixteenth transistor T16;
The gate electrode of the fifteenth transistor T15 is electrically connected to the first output node NJ1, the source electrode of the fifteenth transistor T15 is electrically connected to the high voltage line VGH, and the drain electrode of the fifteenth transistor T15 is electrically connected to the nth stage of driving signal output terminal OTn;
The gate electrode of the sixteenth transistor T16 is electrically connected to the second output node NJ2, the source electrode of the sixteenth transistor T16 is electrically connected to the nth stage of driving signal output terminal OTn, and the drain electrode of the sixteenth transistor T16 is electrically connected to the low voltage line VGL.

In at least one embodiment of the driving circuit shown in FIG. 17, T1 - T16 are all p-type transistors, CT1, CT3, CT5, CT8, CT9, and CT12 are p-type transistors, and CT2, CT4, CT6, CT7, CT10, and CT11 are n-type transistors.

In at least one embodiment of the driving circuit shown in FIG. 17, the driving signal generation circuit is a 16T2C circuit. In actual operation, the driving signal generation circuit may also adopt a circuit of other structures for generating an nth stage of driving signal.

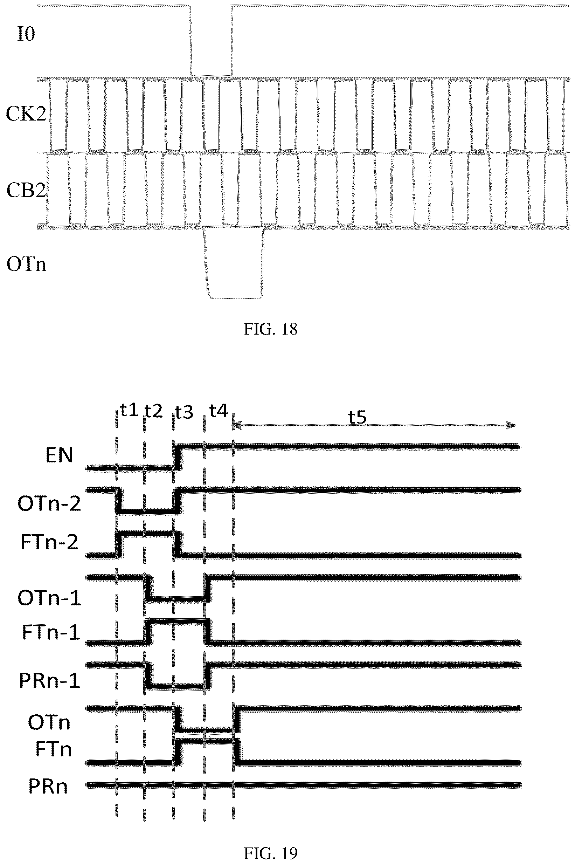

FIG. 18 is the timing diagram of the driving signal generation circuit in the driving circuit shown in FIG. 17.

FIG.19 is a timing diagram of the (n-1)th stage of driving circuit and the nth stage of driving circuit; the structure of the nth stage of driving circuit is shown in FIG.17;
The structure of the (n-1)th stage of driving circuit is the same as the structure of the nth stage of driving circuit shown in FIG.17. The differences between the structure of the (n-1)th stage of driving circuit and the nth stage of driving circuit shown in FIG.17 include:
The drain electrode of T15 is electrically connected to the (n-1)th stage of driving signal output terminal OTn-1, and the drain electrode of CT12 is electrically connected to the (n-1)th stage of inverted signal output terminal FTn-1;
The gate electrode of CT7 is electrically connected to the (n-1)th stage of driving signal output terminal OTn-1, the gate electrode of CT8 is electrically connected to the (n-1)th stage of inverted signal output terminal FTn-1, the gate electrode of CT10 is electrically connected to the (n-2)th stage of inverted signal output terminal FTn-2, the gate electrode of CT9 is electrically connected to the (n-2)th stage of driving signal output terminal OTn-2, the drain electrode of CT5 is electrically connected to the (n-1)th stage of first reset terminal PRn-1, and the gate electrodes of CT3 and CT4 are electrically connected to the (n-1)th stage of driving signal output terminal OTn-1.

As shown FIG. 19, when the (n-1)th stage of driving circuit and the nth stage of driving circuit are in operation,
In the first phase t1, EN outputs a low voltage signal, OTn-2 provides a low voltage signal, FTn-2 provides a high voltage signal, OTn-1 provides a high voltage signal, FTn-1 provides a low voltage signal, OTn provides a high voltage signal, and FTn provides a low voltage signal;
In the (n-1)th stage of driving circuit, CT7 and CT8 are turned on, CT9 and CT10 are turned on, EN is connected to CS, the potential of CS is low voltage, CT1 is turned on, OTn-1 provides a high voltage signal, CT4 is turned on, CO outputs a low voltage signal, CT5 is turned on, and PRn-1 provides a high voltage signal;
In the nth stage of driving circuit, CT7 and CT8 are turned on, CT9 and CT10 are turned off, and EN is disconnected from CS;
In the second phase t2, EN outputs a low voltage signal, OTn-2 provides a low voltage signal, FTn-2 provides a high voltage signal, OTn-1 provides a low voltage signal, FTn-1 provides a high voltage signal, OTn provides a high voltage signal, and FTn provides a low voltage signal;
In the (n-1)th stage of driving circuit, CT7 and CT8 are turned off, EN is disconnected from CS, the potential of CS is maintained at a low voltage, OTn-1 provides a low voltage signal, CT1 and CT3 are turned on, CO outputs a high voltage signal, CT6 is turned on, and PRn-1 provides a low voltage signal;
In the nth stage of driving circuit, CT7 and CT8 are turned on, CT9 and CT10 are turned on, EN is connected to CS, and the potential of CS is low voltage; OTn provides a high voltage signal, CT4 is turned on, CO outputs a low voltage signal, CT5 is turned on, and PRn provides a high voltage signal;
In the third phase t3, EN provides a high voltage signal, OTn-2 provides a high voltage signal, FTn-2 provides a low voltage signal, OTn-1 provides a low voltage signal, FTn-1 provides a high voltage signal, OTn provides a low voltage signal, and FTn provides a high voltage signal;
In the (n-1)th stage of driving circuit, CT7 and CT8 are turned off, EN is disconnected from CS, the potential of CS is maintained at a low voltage, OTn-1 provides a low voltage signal, CT1 and CT3 are turned on, CO outputs a high voltage signal, CT6 is turned on, and PRn-1 provides a low voltage signal;
In the nth stage of driving circuit, CT7 and CT8 are turned off, EN is disconnected from CS, and the potential of CS is maintained at a low voltage; OTn provides a low voltage signal, CT1 and CT2 are turned on, CO outputs a high voltage signal, CT6 is turned on, and PRn provides a low voltage signal;
In the fourth phase t4, EN provides a high voltage signal, OTn-2 provides a high voltage signal, FTn-2 provides a low voltage signal, OTn-1 provides a high voltage signal, FTn-1 provides a low voltage signal, OTn provides a low voltage signal, and FTn provides a high voltage signal;
In the (n-1)th stage of driving circuit, CT7 and CT8 are turned on, CT9 and CT10 are turned off, EN is disconnected from CS, the potential of CS is maintained at a low voltage, OTn-1 provides a high voltage signal, CT4 is turned on, CO outputs a low voltage signal, CT5 is turned on, and PRn-1 provides a high voltage signal;
In the nth stage of driving circuit, CT7 and CT8 are turned off, EN is disconnected from CS, and the potential of CS is maintained at a low voltage; OTn provides a low voltage signal, CT1 and CT2 are turned on, CO outputs a high voltage signal, CT6 is turned on, and PRn provides a low voltage signal;
In the fifth phase t5, EN provides a high voltage signal, OTn-2 provides a high voltage signal, FTn-2 provides a low voltage signal, OTn-1 provides a high voltage signal, FTn-1 provides a low voltage signal, OTn provides a high voltage signal, and FTn provides a low voltage signal;
In the (n-1)th stage of driving circuit, CT9 and CT10 are turned on, CT11 and CT12 are turned off, EN is disconnected from CS, the potential of CS is maintained at a low voltage, CT1 is turned on, CO1 outputs a high voltage signal, CT4 is turned on, CS is connected to VGL, OTn-1 provides a high voltage signal, CT6 is turned on, CO2 outputs a low voltage signal, CT7 is turned on, and PRn-1 provides a high voltage signal;
In the nth stage of driving circuit, CT9 and CT10 are turned on, CT11 and CT12 are turned off, EN is disconnected from CS, and the potential of CS is maintained at a low voltage; OTn provides a high voltage signal, CT4 is turned on, CO outputs a low voltage signal, CT5 is turned on, and PRn provides a high voltage signal.

As shown in FIG. 19, PRn provides an invalid voltage signal, and PRn-1 provides a valid the (n-1)th stage of first reset signal, which can control the transistor whose gate electrode is electrically connected to PRn in the nth row of pixel circuit to be turned off so as not to perform a reset; when the potential of the (n-1)th stage of first reset signal is a valid voltage, the transistor whose gate electrode is electrically connected to PRn-1 in the (n-1)th row of pixel circuit is controlled to be turned on so as to perform a normal reset;
Since the transistor in the pixel circuit electrically connected to PRn is a p-type transistor, the invalid voltage signal provided by PRn is a high voltage signal.

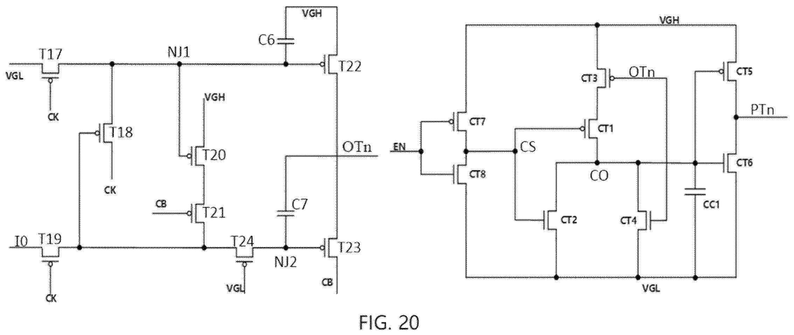

As shown in FIG. 20, based on at least one embodiment of the driving circuit shown in FIG. 13, the nth stage of driving output terminal is the nth stage of second scanning terminal PTn;
The first control circuit includes a first control transistor CT1, a second control transistor CT2, a third control transistor CT3 and a fourth control transistor CT4; the second control circuit includes a fifth control transistor CT5 and a sixth control transistor CT6; the first energy storage circuit includes a first capacitor CC1;
The gate electrode of the first control transistor CT1 is electrically connected to the control signal terminal CS, the source electrode of the first control transistor CT1 is electrically connected to the drain electrode of the third control transistor CT3, and the drain electrode of the first control transistor CT1 is electrically connected to the control output terminal CO;
The gate electrode of the second control transistor CT2 is electrically connected to the control signal terminal CS, the source electrode of the second control transistor CT2 is electrically connected to the control output terminal CO, and the drain electrode of the second control transistor CT2 is electrically connected to the low voltage line VGL;
The gate electrode of the third control transistor CT3 is electrically connected to the nth stage of driving signal output terminal OTn, and the source electrode of the third control transistor CT3 is electrically connected to the high voltage line VGH;
The gate electrode of the fourth control transistor CT4 is electrically connected to the nth stage of driving signal output terminal OTn, the source electrode of the fourth control transistor CT4 is electrically connected to the control output terminal CO, and the drain electrode of the fourth control transistor CT4 is electrically connected to the low voltage line VGL;
The gate electrode of the fifth control transistor CT5 is electrically connected to the control output terminal CO, the source electrode of the fifth control transistor CT5 is electrically connected to the high voltage line VGH, and the drain electrode of the fifth control transistor CT5 is electrically connected to the nth stage of second scanning terminal PTn;
The gate electrode of the sixth control transistor CT6 is electrically connected to the control output terminal CO, the source electrode of the sixth control transistor CT6 is electrically connected to the nth stage of second scanning terminal PTn, and the drain electrode of the sixth control transistor CT6 is electrically connected to the low voltage line VGL;
A first terminal of the first capacitor CC1 is electrically connected to the control output terminal CO, and a second terminal of the first capacitor CC1 is electrically connected to the low voltage line VGL;
The control signal generation circuit includes a seventh control transistor CT7 and an eighth control transistor CT8;
The gate electrode of the seventh control transistor CT7 is electrically connected to the enable signal line EN, the source electrode of the seventh control transistor CT7 is electrically connected to the high voltage line VGH, and the drain electrode of the seventh control transistor CT7 is electrically connected to the control signal terminal CS;
The gate electrode of the eighth control transistor CT8 is electrically connected to the enable signal line EN, the source electrode of the eighth control transistor CT8 is electrically connected to the control signal terminal CS, and the drain electrode of the eighth control transistor CT8 is electrically connected to the low voltage line VGL;
CT1, CT3 and CT5 are p-type transistors, CT2, CT4 and CT6 are n-type transistors; CT7 is a p-type transistor, and CT8 is an n-type transistor;
The first output node control circuit includes a seventeenth transistor T17, an eighteenth transistor T18 and a sixth capacitor C6;
The gate electrode of the seventeenth transistor T17 is electrically connected to the third first clock signal line CK3, the source electrode of the seventeenth transistor T17 is electrically connected to the low voltage line VGL, and the drain electrode of the seventeenth transistor T17 is electrically connected to the first output node NJ1;
The gate electrode of the eighteenth transistor T18 is electrically connected to the second output node NJ2, the source electrode of the eighteenth transistor T18 is electrically connected to the third first clock signal line CK3, and the drain electrode of the eighteenth transistor T18 is electrically connected to the first output node NJ1;
The first electrode plate of the sixth capacitor C6 is electrically connected to the first output node NJ1, and the second electrode plate of the sixth capacitor C6 is electrically connected to the high voltage line VGH;
The second output node control circuit includes a nineteenth transistor T19, a twentieth transistor T20 and a twenty first transistor T21; the third energy storage circuit includes a seventh capacitor C7;
The gate electrode of the nineteenth transistor T19 is electrically connected to the third first clock signal line CK3, the source electrode of the nineteenth transistor T19 is electrically connected to the input terminal I0, and the drain electrode of the nineteenth transistor T19 is electrically connected to the second output node NJ2;
A gate electrode of the twentieth transistor T20 is electrically connected to the first output node NJ1, a source electrode of the twentieth transistor T20 is electrically connected to the high voltage line VGH, and a drain electrode of the twentieth transistor T20 is electrically connected to a source electrode of the twenty first transistor T21;
A gate electrode of the twenty first transistor T21 is electrically connected to the third second clock signal line CB3, and a second electrode of the twenty first transistor T21 is electrically connected to the second output node NJ2;
The first electrode plate of the seventh capacitor C7 is electrically connected to the second output node NJ2, and the second electrode plate of the seventh capacitor C7 is electrically connected to the nth stage of driving signal output terminal OTn;
The output circuit includes a twenty second transistor T22 and a twenty third transistor T23;
The gate electrode of the twenty second transistor T22 is electrically connected to the first output node NJ1, the source electrode of the twenty second transistor T22 is electrically connected to the high voltage line VGH, and the drain electrode of the twenty second transistor T22 is electrically connected to the nth stage of driving signal output terminal OTn;
The gate electrode of the twenty third transistor T23 is electrically connected to the second output node NJ2, the source electrode of the twenty third transistor T23 is electrically connected to the nth stage of driving signal output terminal OTn, and the drain electrode of the twenty third transistor T23 is electrically connected to the third second clock signal line CB3;
The driving circuit further includes a twenty fourth transistor T24;
The drain electrode of the twenty first transistor T21 is electrically connected to the second output node NJ2 through the twenty fourth transistor T24;
A gate electrode of the twenty fourth transistor T24 is electrically connected to the low voltage line VGL, a source electrode of the twenty fourth transistor T24 is electrically connected to the drain electrode of the twenty first transistor T21, and a drain electrode of the twenty fourth transistor T24 is electrically connected to the second output node NJ2.

In at least one embodiment of the driving circuit shown in FIG. 20, T17 - T24 are p-type transistors, but the present disclosure is not limited thereto.

In at least one embodiment of the driving circuit shown in FIG. 20, T24 may not be provided.

In at least one embodiment of the driving circuit shown in FIG. 20, the driving signal generation circuit is an 8T2C circuit. In actual operation, the driving signal generation circuit may also adopt a circuit of other structures for generating an nth stage of driving signal.

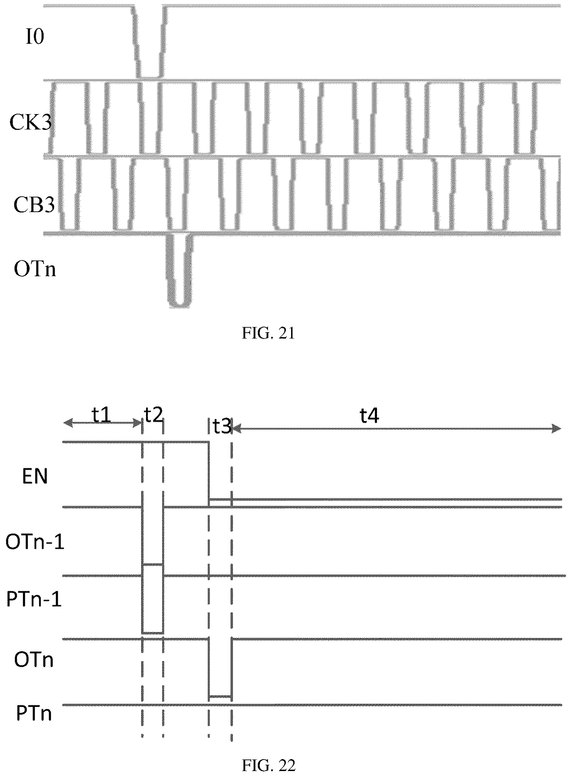

FIG. 21 is the timing diagram of the driving signal generation circuit in the driving circuit shown in FIG. 20.

FIG.22 is a working timing diagram of the (n-1)th stage of driving circuit and the nth stage of driving circuit; the structure of the nth stage of driving circuit is shown in FIG.20;
The structure of the (n-1)th stage of driving circuit is the same as the structure of the nth stage of driving circuit shown in FIG. 20. The differences between the structure of the (n-1)th stage of driving circuit and the nth stage of driving circuit shown in FIG. 20 include:
The drain electrode of T22 is electrically connected to the (n-1)th stage of driving signal output terminal OTn-1;
The gate electrode of CT5 and the gate electrode of CT6 are both electrically connected to the (n-1)th stage of driving signal output terminal OTn-1, and the drain electrode of CT5 is electrically connected to the (n-1)th stage of second scanning terminal PTn-1.

As shown in FIG. 22, when the (n-1)th stage of driving circuit and the nth stage of driving circuit are in operation,

In the first phase t1, EN provides a high voltage signal, OTn-1 provides a high voltage signal, and OTn provides a high voltage signal;
In the (n-1)th stage of driving circuit, CT8 is turned on, CS is connected to VGL, the potential of CS is low voltage, CT1 is turned on; OTn-1 provides a high voltage signal, CT4 is turned on, CO outputs a low voltage signal, CT5 is turned on, and PTn-1 provides a high voltage signal;
In the nth stage of driving circuit, CT8 is turned on, CS is connected to VGL, the potential of CS is low voltage, CT1 is turned on; OTn provides a high voltage signal, CT4 is turned on, CO outputs a low voltage signal, CT5 is turned on, and PTn provides a high voltage signal;
In the second phase t2, EN provides a high voltage signal, OTn-1 provides a low voltage signal, and OTn provides a high voltage signal;
In the (n-1)th stage of driving circuit, CT8 is turned on, CS is connected to VGL, the potential of CS is low voltage, CT1 is turned on, CO outputs a high voltage signal, OTn-1 provides a low voltage signal, CT3 is turned on, CO outputs a high voltage signal, CT6 is turned on, and PTn-1 outputs a low voltage signal;
In the nth stage of driving circuit, CT8 is turned on, CS is connected to VGL, the potential of CS is low voltage, CT1 is turned on; OTn provides a high voltage signal, CT4 is turned on, CO outputs a low voltage signal, CT5 is turned on, and PTn provides a high voltage signal;
In the third phase t3, EN provides a low voltage signal, OTn-1 provides a high voltage signal, and OTn provides a low voltage signal;
In the (n-1)th stage of driving circuit, CT7 is turned on, CS is connected to VGH, the potential of CS is high voltage, CT2 is turned on, CT5 is turned on, OTn-1 provides a high voltage signal, CT4 is turned on, CO outputs a low voltage signal, CT5 is turned on, and PTn-1 outputs a high voltage signal;
In the nth stage of driving circuit, CT7 is turned on, CS is connected to VGH, the potential of CS is high voltage, CT2 is turned on, CO outputs a low voltage signal, CT5 is turned on, and PTn provides a high voltage signal;
In the fourth phase t4, EN provides a low voltage signal, OTn-1 provides a high voltage signal, and OTn provides a high voltage signal;
In the (n-1)th stage of driving circuit, CT7 is turned on, CS is connected to VGH, the potential of CS is high voltage, CT2 is turned on, CO outputs a low voltage signal, CT1 is turned on, OTn-1 provides a high voltage signal, CT4 is turned on, CT5 is turned on, and PTn-1 outputs a high voltage signal;
In the nth stage of driving circuit, CT7 is turned on, CS is connected to VGH, the potential of CS is high voltage, CT2 is turned on, CO71 outputs a low voltage signal, CT1 is turned on, OTn provides a high voltage signal, CT4 is turned on, CT5 is turned on, and PTn provides a high voltage signal.

As shown in FIG. 22, PTn provides an invalid voltage signal, and PTn-1 provides a valid the (n-1)th stage of second scanning signal, which can control the transistor whose gate electrode is electrically connected to PTn in the nth row of pixel circuit to be turned off so as not to perform scanning; when the potential of the (n-1)th stage of second scanning signal is a valid voltage, the transistor whose gate electrode is electrically connected to PTn-1 in the (n-1)th row of pixel circuit is controlled to be turned on so as to perform normal scanning;
Since the transistor in the pixel circuit electrically connected to PTn is a p-type transistor, the invalid voltage signal provided by PTn is a high voltage signal.

In an embodiment of the present disclosure, the display substrate includes a base substrate and the above-mentioned driving circuit arranged on the base substrate;
The display substrate includes a display area and a peripheral area; the driving circuit is arranged in the peripheral area.

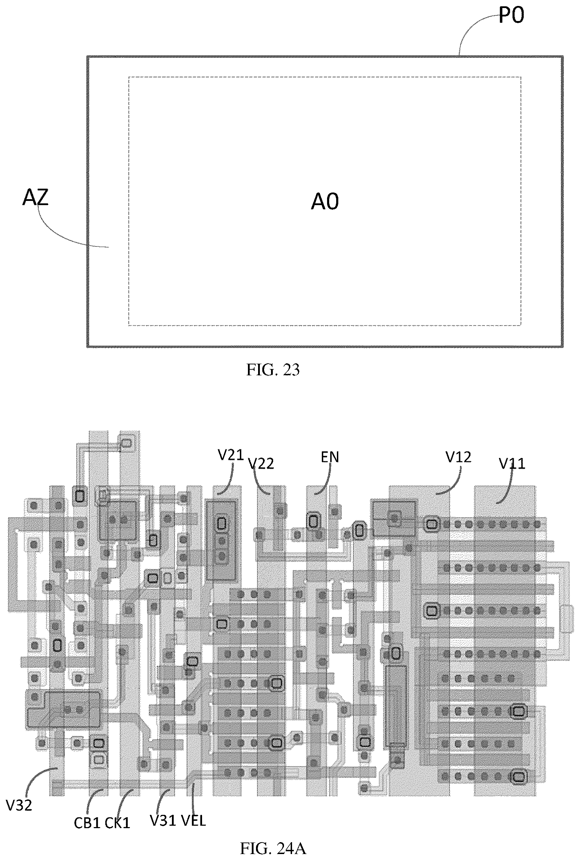

As shown in FIG. 23, the display substrate P0 includes a display area A0 and a peripheral area AZ;
The driving circuit is arranged in the peripheral area AZ;
A plurality of rows and a plurality of columns of pixel circuits are arranged in the display area A0.

In a specific implementation, the driving circuit may be arranged on the left side and/or the right side of the display area A01.

In at least one embodiment of the present disclosure, the driving circuit further includes an output inverting circuit;
The output inverting circuit is electrically connected to the nth stage of driving signal output terminal and the nth stage of inverted signal output terminal respectively, and is configured to invert the nth stage of driving signal to obtain and output the nth stage of inverted driving signal through the nth stage of inverted signal output terminal;
The control signal generation circuit is also electrically connected to the (n-1)th stage of driving signal output terminal, the (n-1)th stage of inverted signal output terminal, the nth stage of driving signal output terminal and the nth stage of inverted signal output terminal respectively, and is configured to generate a control signal according to an enable signal provided by an enable signal line under the control of the (n-1)th stage of driving signal, the (n-1)th stage of inverted signal, the nth stage of driving signal and the nth stage of inverted signal;
The (n-1)th stage of driving signal output terminal is configured to provide the (n-1)th stage of driving signal, and the (n-1)th stage of inverted signal output terminal is configured to provide the (n-1)th stage of inverted signal;
The control signal generation circuit is arranged on a side of the driving signal generation circuit close to the display area.

Optionally, the control circuit in the driving circuit includes a first control circuit, a second control circuit and a first energy storage circuit; the control circuit is arranged on a side of the driving signal generation circuit close to the display area;
The first control circuit is electrically connected to the control signal terminal, the nth driving signal output terminal, the first control voltage line, the second control voltage line and the control output terminal respectively, and is configured to control the control output terminal to be connected to the first control voltage line under the control of the control signal, to control the control output terminal to be connected or disconnected from the first control voltage line under the control of the nth stage of driving signal, and to control the control output terminal to be connected or disconnected from the second control voltage line under the control of the nth stage of driving signal and the control signal;
The second control circuit is electrically connected to the control output terminal, the nth stage of driving output terminal, the first voltage line and the second voltage line respectively, and is configured to control the connection or disconnection between the nth stage of driving output terminal and the first voltage line, and control the connection or disconnection between the nth stage of driving output terminal and the second voltage line under the control of the potential of the control output terminal;
The first energy storage circuit is electrically connected to the control output terminal and is configured to maintain the potential of the control output terminal;
The first control voltage line is the first voltage line, and the second control voltage line is the second voltage line; or, the first control voltage line is the second voltage line, and the second control voltage line is the first voltage line.

In at least one embodiment of the present disclosure, the control circuit further includes a second energy storage circuit;
The second energy storage circuit is electrically connected to the control signal terminal and is configured to maintain the potential of the control signal terminal;
The second energy storage circuit is arranged on a side of the second control circuit away from the display area.

Optionally, the driving signal generation circuit includes a first node control circuit, a second node control circuit, a first output node control circuit, a second output node control circuit, a potential maintaining circuit and an output circuit;
The first node control circuit is electrically connected to the first node, the first first clock signal line, the second voltage line, and the second output node, respectively, and is configured to control the connection between the first node and the second voltage line under the control of the first clock signal provided by the first first clock signal line, and to control the connection or disconnection between the first node and the first first clock signal line under the control of the potential of the second output node;
The second node control circuit is electrically connected to the first node, the first intermediate node, the first voltage line, the first second clock signal line, the second node, the input terminal and the second voltage line respectively, and is configured to control the first intermediate node to be connected to the first voltage line under the control of the potential of the first node, control the first intermediate node to be connected to the first second clock signal line under the control of the potential of the second node, and control the potential of the second node according to the potential of the first intermediate node, and control the input terminal to be connected to the second node under the control of the second clock signal provided by the first second clock signal line and the second voltage signal provided by the second voltage line;
The first output node control circuit is electrically connected to the first output node, the first node, the first second clock signal line, the second intermediate node, the second output node and the first voltage line respectively, and is configured to control the second intermediate node to be connected to the first second clock signal line under the control of the potential of the first node, control the potential of the second intermediate node according to the potential of the first node, control the second intermediate node to be connected to the first output node under the control of the second clock signal provided by the first second clock signal line, and control the first output node to be connected to the first voltage line under the control of the potential of the second output node;
The second output node control circuit is electrically connected to the first second clock signal line, the input terminal, the control voltage line, the first voltage line, the second node, and the second output node, respectively, and is configured to control the second output node to be connected to the input terminal under the control of the second clock signal provided by the first second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

Optionally, the driving signal generation circuit includes a first node control circuit, a second node control circuit, a first output node control circuit, a second output node control circuit, a potential maintaining circuit and an output circuit;
The first node control circuit is electrically connected to the first node, the second first clock signal line, the second voltage line, and the second output node, respectively, and is configured to control the connection between the first node and the second voltage line under the control of the first clock signal provided by the second first clock signal line, and to control the connection or disconnection between the first node and the second first clock signal line under the control of the potential of the second output node;
The second node control circuit is electrically connected to the first node, the first intermediate node, the first voltage line, the second second clock signal line, the second node, the input terminal and the second voltage line respectively, and is configured to control the connection between the first intermediate node and the first voltage line under the control of the potential of the first node, control the connection between the first intermediate node and the second second clock signal line under the control of the potential of the second node, and control the potential of the second node according to the potential of the first intermediate node, and control the connection between the input terminal and the second node under the control of the second clock signal provided by the second second clock signal line and the second voltage signal provided by the second voltage line;
The first output node control circuit is electrically connected to the first output node, the first node, the second second clock signal line, the second intermediate node, the second output node and the first voltage line respectively, and is configured to control the second intermediate node to be connected to the second second clock signal line under the control of the potential of the first node, control the potential of the second intermediate node according to the potential of the first node, control the second intermediate node to be connected to the first output node under the control of the second clock signal provided by the second second clock signal line, and control the first output node to be connected to the first voltage line under the control of the potential of the second output node;
The second output node control circuit is electrically connected to the second second clock signal line, the input terminal, the control voltage line, the first voltage line, the second node, and the second output node, respectively, and is configured to control the second output node to be connected to the input terminal under the control of the second clock signal provided by the second second clock signal line, control the potential of the second output node according to the potential of the second node, and control the second output node to be connected to the first voltage line under the control of the control voltage provided by the control voltage line;
The potential maintaining circuit is electrically connected to the first output node, and is configured to maintain the potential of the first output node;
The output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

In at least one embodiment of the present disclosure, the driving signal generation circuit includes a first output node control circuit, a second output node control circuit, a third energy storage circuit and an output circuit; the driving signal generation circuit is arranged on a side of the control signal generation circuit included in the driving circuit away from the display area; the transistors in the output circuit are arranged on a side of the transistors included in the driving signal generation circuit except the transistors in the output circuit close to the display area;
The first output node control circuit is electrically connected to the third first clock signal line, the second voltage line and the second output node respectively, and is configured to control the first output node to be connected to the second voltage line under the control of the first clock signal provided by the third first clock signal line, and to control the first output node to be connected to the third first clock signal line under the control of the potential of the second output node, and to maintain the potential of the first output node;
The second output node control circuit is electrically connected to the second output node, the third first clock signal line, the input terminal, the third second clock signal line, the first output node and the first voltage line respectively, and is configured to control the second output node to be connected to the input terminal under the control of the first clock signal, and to control the second output node to be connected to the first voltage line under the control of the potential of the first output node and the second clock signal provided by the third second clock signal line;
The first terminal of the third energy storage circuit is electrically connected to the second output node, the second terminal of the third energy storage circuit is electrically connected to the nth stage of driving signal output terminal, and the third energy storage circuit is configured to store electric energy;
The output circuit is electrically connected to the first output node, the second output node, the first voltage line, the second clock signal and the nth stage of driving signal output terminal, respectively, and is configured to control the connection between the nth stage of driving signal output terminal and the first voltage line under the control of the potential of the first output node, and to control the connection between the nth stage of driving signal output terminal and the third second clock signal line under the control of the potential of the second output node.

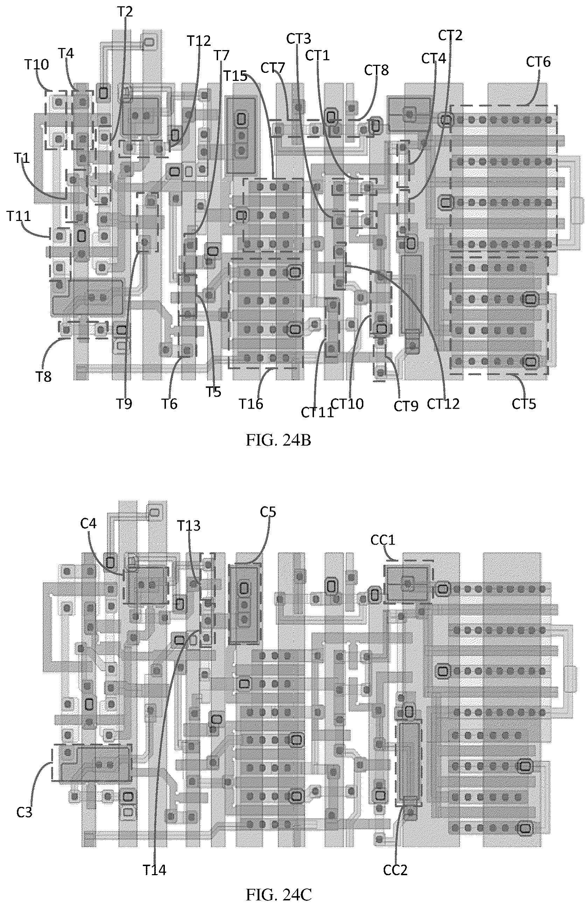

FIGS. 24A, 24B and 24C are first layout diagrams of the driving circuit shown in FIG. 14.

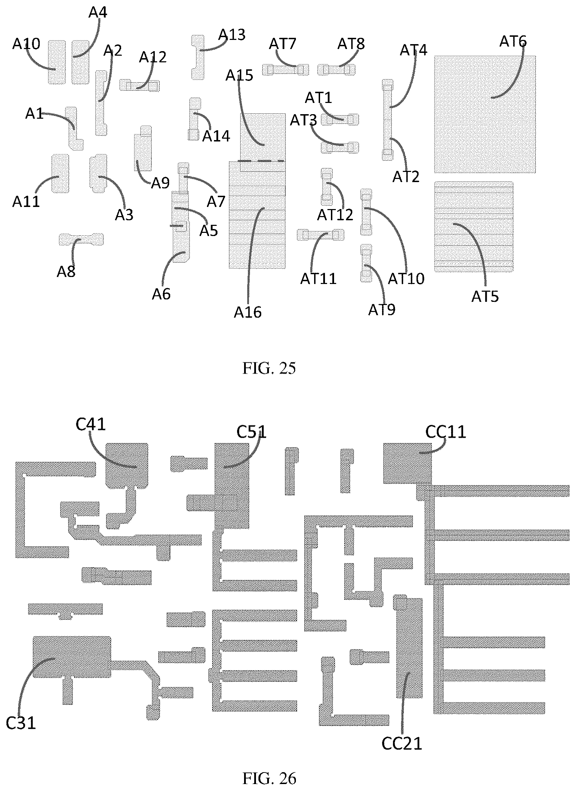

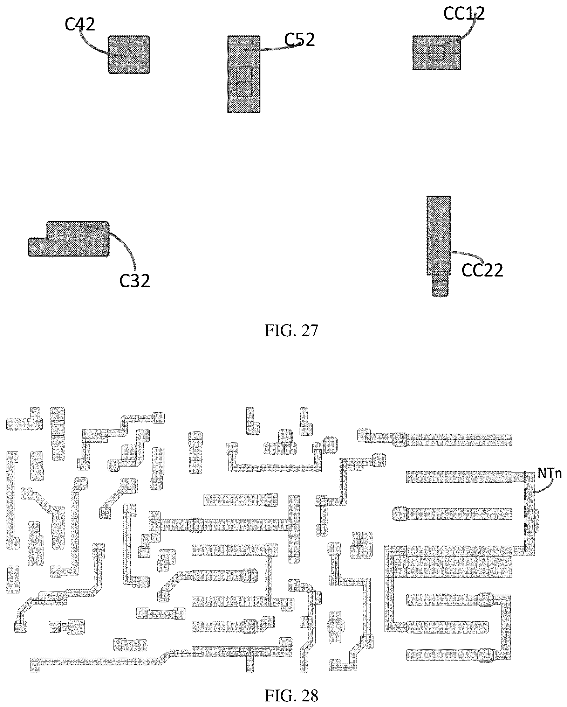

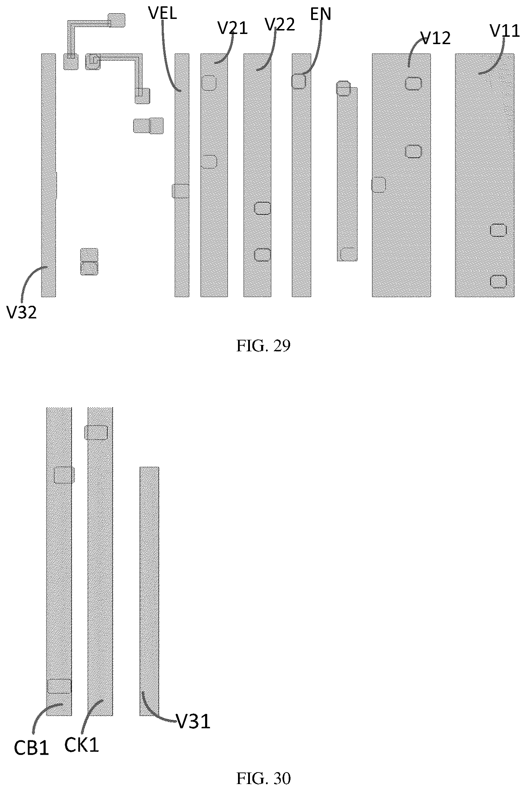

FIG. 25 is a layout diagram of the first semiconductor layer in FIG. 24A, FIG. 26 is a layout diagram of the first gate metal layer in FIG. 24A, FIG. 27 is a layout diagram of the second gate metal layer in FIG. 24A, FIG. 28 is a layout diagram of the first source-drain metal layer in FIG. 24A, FIG. 29 is a layout diagram of the second source-drain metal layer in FIG. 24A, and FIG. 30 is a layout diagram of the third source-drain metal layer in FIG. 24A.

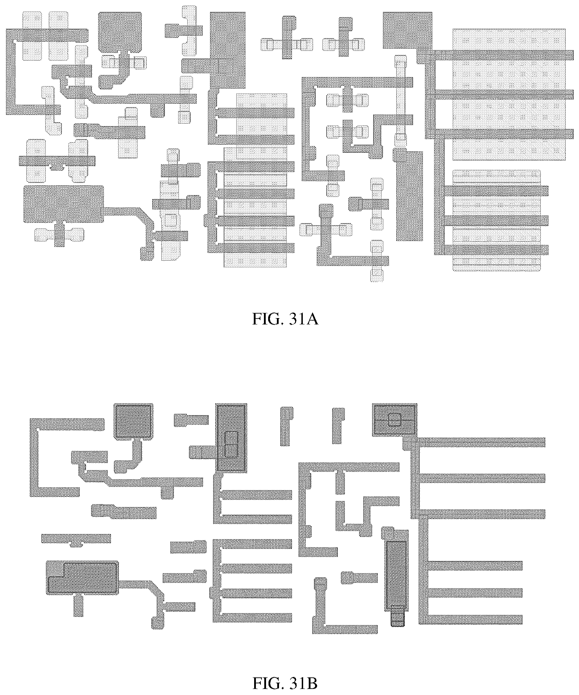

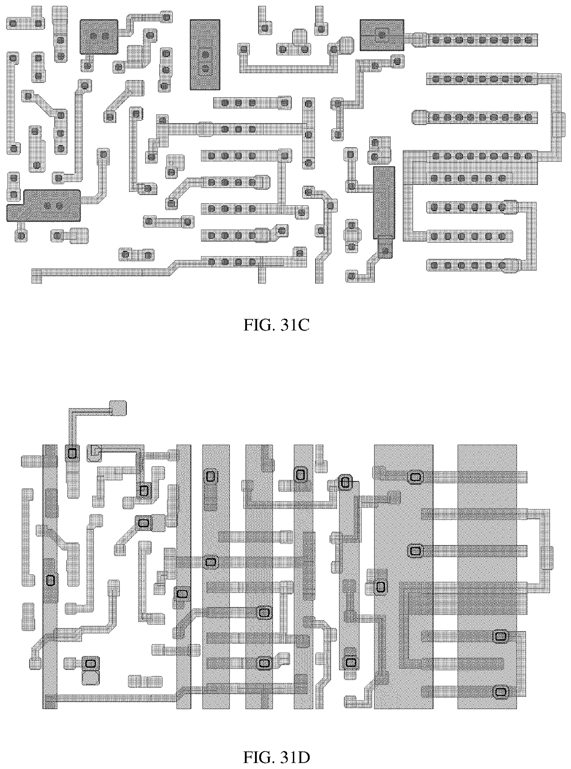

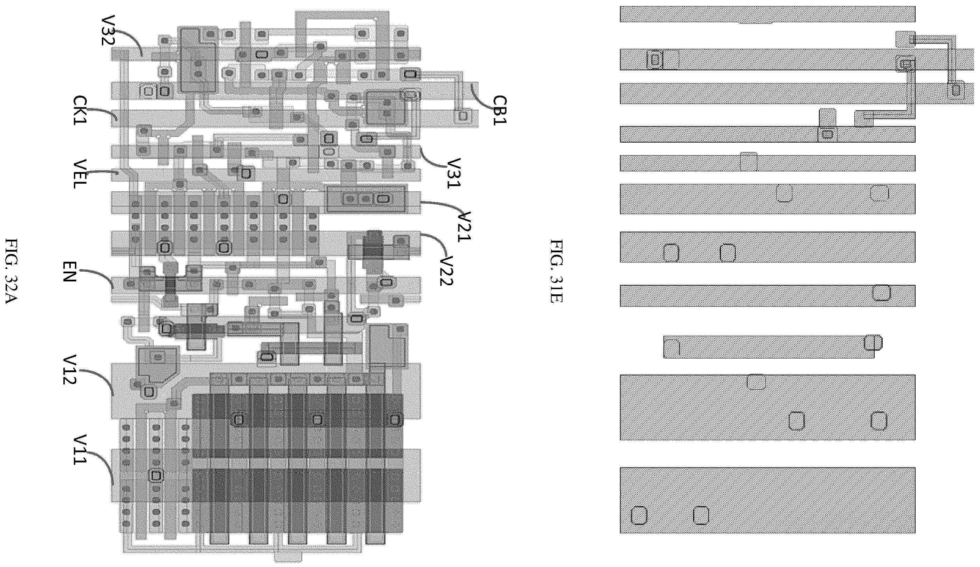

FIG. 31A is a superimposed diagram of the first semiconductor layer and the first gate metal layer in FIG. 24A, FIG. 31B is a superimposed diagram of the first gate metal layer and the second gate metal layer in FIG. 24A, FIG. 31C is a superimposed diagram of the second gate metal layer and the first source-drain metal layer in FIG. 24A, FIG. 31D is a superimposed diagram of the first source-drain metal layer and the second source-drain metal layer in FIG. 24A, and FIG. 31E is a superimposed diagram of the second source-drain metal layer and the third source-drain metal layer in FIG. 24A.

In FIG. 25, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, AT8 is an active pattern of CT8, AT9 is an active pattern of CT9, AT10 is an active pattern of CT10, AT11 is an active pattern of CT11, and AT12 is an active pattern of CT12;

A1 is the active pattern of T1, A2 is the active pattern of T2, A3 is the active pattern of T3, A4 is the active pattern of T4, A5 is the active pattern of T5, A6 is the active pattern of T6, A7 is the active pattern of T7, A8 is the active pattern of T8, A9 is the active pattern of T9, A10 is the active pattern of T10, A11 is the active pattern of T11, A12 is the active pattern of T12, A13 is the active pattern of T13, A14 is the active pattern of T14, A15 is the active pattern of T15, and A16 is the active pattern of T16.

In FIG.26, CC11 is the first electrode plate of CC1, CC21 is the first electrode plate of CC2, C31 is the first electrode plate of C3, C41 is the first electrode plate of C4, and C51 is the first electrode plate of C5.

In FIG.27, CC12 is the second electrode plate of CC1, CC22 is the second electrode plate of CC2, C32 is the second electrode plate of C3, C42 is the second electrode plate of C4, and C52 is the second electrode plate of C5.

In at least one embodiment of the display substrate shown in FIG. 24A, the first semiconductor layer, the first gate metal layer, the second gate metal layer, the first source-drain metal layer, the second source-drain metal layer and the third source-drain metal layer are arranged in sequence in a direction away from the base substrate.

In at least one embodiment of the display substrate shown in FIG. 24A is a driving circuit manufactured using a CMOS (complementary metal oxide semiconductor) process.

In at least one embodiment of the present disclosure, the first semiconductor layer may be made of polysilicon, and the second semiconductor layer may be made of IGZO (indium gallium zinc oxide), but the present disclosure is not limited thereto.

In at least one embodiment of the present disclosure, the control signal generation circuit and the control circuit are arranged on a side of the driving signal generation circuit close to the display area, so that the control circuit provides a corresponding driving signal to a pixel circuit arranged in the display area.

In at least one embodiment of the present disclosure, the first voltage line includes a first first voltage line and a second first voltage line sequentially arranged in a direction away from the display area, and the second voltage line includes a first second voltage line and a second second voltage line sequentially arranged in a direction away from the display area;
An orthographic projection of the active pattern of at least part of the transistors included in the second control circuit on the base substrate at least partially overlaps the orthographic projection of the first first voltage line on the base substrate;
An orthographic projection of the active pattern of the at least part of transistors included in the second control circuit on the base substrate at least partially overlaps the orthographic projection of the first second voltage line on the base substrate;
An orthographic projection of the first second voltage line on the base substrate at least partially overlaps the orthographic projection of the electrode plate of the capacitor included in the first energy storage circuit on the base substrate;
An orthographic projection of the enable signal line on the base substrate at least partially overlaps an orthographic projection of active patterns of at least a portion of transistors included in the control signal generation circuit on the base substrate.

In at least one embodiment of the present disclosure, an orthographic projection of each signal line on the base substrate at least partially overlaps the orthographic projection of the active pattern of the corresponding transistor on the base substrate, and the orthographic projection of the signal line on the base substrate at least partially overlap the orthographic projection of the electrode plate of the corresponding capacitor on the base substrate, so as to reduce the lateral space occupied by the driving circuit, thereby facilitating the realization of a narrow frame.

Optionally, the first voltage line may be a high voltage line, and the second voltage line may be a low voltage line.

As shown in FIGS. 24A to 30, the high voltage line includes a first first voltage line V11 and a second first voltage line V21, and the second voltage line includes a first second voltage line V12 and a second second voltage line V22;
V11 and V21 are arranged in sequence along the side away from the display area, and V12 and V22 are arranged in sequence along the side away from the display area;
In FIG. 24A to FIG. 30, the one labeled NTn is the nth stage of first scanning terminal;
As shown in FIGS. 24A to 30, the orthographic projection of the active pattern AT6 of CT6 on the base substrate at least partially overlaps the orthographic projection of V11 on the base substrate; the orthographic projection of the active pattern AT5 of CT5 on the base substrate at least partially overlaps the orthographic projection of V11 on the base substrate;
The orthographic projection of the active pattern AT6 of CT6 on the base substrate at least partially overlaps the orthographic projection of V12 on the base substrate; the orthographic projection of the active pattern AT5 of CT5 on the base substrate at least partially overlaps the orthographic projection of V12 on the base substrate;
The orthographic projection of the active pattern AT4 of CT4 on the base substrate at least partially overlaps the orthographic projection of V12 on the base substrate; the orthographic projection of the active pattern AT2 of CT2 on the base substrate at least partially overlaps the orthographic projection of V12 on the base substrate;
The orthographic projection of the first electrode plate CC11 of CC1 on the base substrate at least partially overlaps the orthographic projection of V12 on the base substrate; the orthographic projection of the second electrode plate CC12 of CC1 on the base substrate at least partially overlaps the orthographic projection of V12 on the base substrate;
The orthographic projection of the first electrode plate CC21 of CC2 on the base substrate at least partially overlaps the orthographic projection of V12 on the base substrate; the orthographic projection of the second electrode plate CC22 of CC2 on the base substrate at least partially overlaps the orthographic projection of V12 on the base substrate;
The orthographic projection of the enable signal line EN on the base substrate at least partially overlaps the orthographic projection of the active pattern of CT8 on the base substrate.

In at least one embodiment of the present disclosure, the orthographic projection of the first second voltage line on the base substrate at least partially overlaps the orthographic projection of the electrode plate of the capacitor included in the second energy storage circuit on the base substrate;
An orthographic projection of the second second voltage line on the base substrate at least partially overlaps an orthographic projection of active patterns of at least part of transistors included in the control signal generation circuit on the base substrate.

As shown in FIGS. 24A to 30, the orthographic projection of V22 on the base substrate at least partially overlaps the orthographic projection of the active pattern AT7 of CT7 on the base substrate.

In at least one embodiment of the present disclosure, an orthographic projection of the enable signal line on the base substrate at least partially overlaps an orthographic projection of an active pattern of at least one transistor included in the output inverting circuit on the base substrate.

As shown in FIGS. 24A to 30, the orthographic projection of the enable signal line EN on the base substrate at least partially overlaps the orthographic projection of the active pattern of CT12 on the base substrate; the orthographic projection of the enable signal line EN on the base substrate at least partially overlaps the orthographic projection of the active pattern of CT11 on the base substrate.

Optionally, the first first voltage line, the second first voltage line, the first second voltage line, the second second voltage line and the enable signal line all extend along a first direction;
The width of the first first voltage line along the second direction is greater than the width of the second first voltage line along the second direction;
The width of the first second voltage line along the second direction is greater than the width of the second second voltage line along the second direction;
The first direction intersects the second direction.

In at least one embodiment of the present disclosure, the first voltage line may include at least two voltage lines electrically connected to each other, and the width of at least one voltage line of the at least two voltage lines electrically connected to each other included in the first voltage line may be set to be larger along the second direction to reduce the resistance of the first voltage line;
The second voltage line may include at least two voltage lines electrically connected to each other, and the width of at least one voltage line of the at least two voltage lines electrically connected to each other included in the second voltage line may be set to be larger along the second direction to reduce the resistance of the second voltage line.

Optionally, the first direction may be a vertical direction, and the second direction may be a horizontal direction.

As shown in FIG. 24A to FIG. 30, V11, V21, V12, V22 and EN all extend in the vertical direction.

The width of V11 along the horizontal direction is greater than the width of V21 along the horizontal direction.

The width of V12 along the horizontal direction is greater than the width of V22 along the horizontal direction.

In at least one embodiment of the present disclosure, CT5 and CT6 are transistors electrically connected to the nth stage of driving output terminal, and the orthographic projection of the active pattern AT5 of CT5 on the base substrate at least partially overlaps the orthographic projection of V11 on the base substrate; the orthographic projection of the active pattern AT6 of CT6 on the base substrate at least partially overlaps the orthographic projection of V11 on the base substrate; the orthographic projection of the active pattern AT5 of CT5 on the base substrate at least partially overlaps the orthographic projection of V12 on the base substrate; the orthographic projection of the active pattern AT6 of CT6 on the base substrate at least partially overlaps the orthographic projection of V12 on the base substrate; the width of V11 along the horizontal direction is set to be larger, and the width of V12 along the horizontal direction is set to be larger, so as to reduce the resistance of V11 and the resistance of V12, and reduce the IR Drop (IR voltage drop, IR voltage drop is the voltage drop caused by current and resistance) of the high voltage line and the IR Drop of the low voltage line.

In at least one embodiment of the present disclosure, the transistor included in the second control circuit is arranged on a side of the transistor included in the first control circuit close to the display area;
The transistor included in the control signal generation circuit is arranged on a side of the second control circuit away from the display area.

As shown in FIGS. 24A to 30, the fifth control transistor CT5 and the sixth control transistor CT6 included in the second control circuit are arranged on a side of the first control transistor CT1, the second control transistor CT2, the third control transistor CT3 and the fourth control transistor CT4 included in the first control circuit close to the display area;
The seventh control transistor CT7, the eighth control transistor CT8, the ninth control transistor CT9 and the tenth control transistor CT10 included in the control signal generation circuit are arranged on a side of the fifth control transistor CT5 and the sixth control transistor CT6 included in the second control circuit away from the display area.

In at least one embodiment of the present disclosure, the first voltage line includes a first first voltage line, a second first voltage line, and a third first voltage line sequentially arranged along a direction away from the display area, and the second voltage line includes a first second voltage line, a second second voltage line, and a third second voltage line sequentially arranged along a direction away from the display area;
The orthographic projection of the second second voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the active pattern of at least one transistor included in the output circuit on the base substrate;
The orthographic projection of the second first voltage line on the base substrate at least partially overlaps the orthographic projection of the electrode plate of the capacitor included in the potential maintaining circuit on the base substrate;
The orthographic projection of the third first voltage line on the base substrate at least partially overlaps the orthographic projection of the active pattern of at least one transistor included in the second output node control circuit on the base substrate;
The orthographic projection of the third second voltage line on the base substrate at least partially overlaps the orthographic projection of the electrode plate of the capacitor included in the second node control circuit on the base substrate;
The orthographic projection of the third second voltage line on the base substrate at least partially overlaps the orthographic projection of the active pattern of at least one transistor included in the first node control circuit on the base substrate;
An orthographic projection of the third second voltage line on the base substrate at least partially overlaps an orthographic projection of an active pattern of at least one transistor included in the second node control circuit on the base substrate.

In at least one embodiment of the present disclosure, the orthographic projection of each signal line on the base substrate and the orthographic projection of the active pattern of the corresponding transistor on the base substrate at least partially overlap, so as to facilitate the realization of a narrow frame.

As shown in FIGS. 24A to 30, the first voltage lines include a first first voltage line V11, a second first voltage line V21, and a third first voltage line V31 which are sequentially arranged in a direction away from the display area;
The second voltage lines include a first second voltage line V12, a second second voltage line V22 and a third second voltage line V32 which are sequentially arranged in a direction away from the display area;
The orthographic projection of V22 on the base substrate at least partially overlaps the orthographic projection of the active pattern A15 of T15 on the base substrate, and the orthographic projection of V22 on the base substrate at least partially overlaps the orthographic projection of the active pattern A16 of T16 on the base substrate;
The orthographic projection of V22 on the base substrate at least partially overlaps the orthographic projection of the active pattern A15 of T15 on the base substrate, and the orthographic projection of V22 on the base substrate at least partially overlaps the orthographic projection of the active pattern A16 of T16 on the base substrate;
The orthographic projection of V21 on the base substrate at least partially overlaps the orthographic projection of the first electrode plate C51 of C5 on the base substrate; the orthographic projection of V21 on the base substrate at least partially overlaps the orthographic projection of the second electrode plate C52 of C5 on the base substrate;
The orthographic projection of V31 on the base substrate at least partially overlaps the orthographic projection of the active pattern A5 of T5 on the base substrate; the orthographic projection of V31 on the base substrate at least partially overlaps the orthographic projection of the active pattern A6 of T6 on the base substrate; the orthographic projection of V31 on the base substrate at least partially overlaps the orthographic projection of the active pattern A7 of T7 on the base substrate;
The orthographic projection of V32 on the base substrate at least partially overlaps the orthographic projection of the active pattern A4 of T4 on the base substrate; the orthographic projection of V32 on the base substrate at least partially overlaps the orthographic projection of the active pattern A1 of T1 on the base substrate; the orthographic projection of V32 on the base substrate at least partially overlaps the orthographic projection of the active pattern A8 of T8 on the base substrate;
The orthographic projection of V32 on the base substrate at least partially overlaps the orthographic projection of the first electrode plate C31 of C3 on the base substrate; the orthographic projection of V32 on the base substrate at least partially overlaps the orthographic projection of the second electrode plate C32 of C3 on the base substrate.

In at least one embodiment of the present disclosure, the first first clock signal line and the second clock signal line are arranged between the third first voltage line and the third second voltage line;
The orthographic projection of the first first clock signal line on the base substrate at least partially overlaps the orthographic projection of the electrode plate of the capacitor included in the first output node control circuit on the base substrate;
The orthographic projection of the first first clock signal line on the base substrate at least partially overlaps the orthographic projection of the active pattern of at least one transistor included in the second node control circuit on the base substrate;
The orthographic projection of the first first clock signal line on the base substrate at least partially overlaps the orthographic projection of the active pattern of at least one transistor included in the first output node control circuit on the base substrate;
The orthographic projection of the first second clock signal line on the base substrate at least partially overlaps the orthographic projection of the electrode plate of the capacitor included in the first output node control circuit on the base substrate;
The orthographic projection of the first second clock signal line on the base substrate at least partially overlaps the orthographic projection of the electrode plate of the capacitor included in the second node control circuit on the base substrate.

As shown in FIGS. 24A to 30, the first first clock signal line CK1 and the first second clock signal line CB1 are arranged between the third first voltage line V31 and the third second voltage line V32;
The orthographic projection of CK1 on the base substrate at least partially overlaps the orthographic projection of the first electrode plate C41 of C4 on the base substrate; the orthographic projection of CK1 on the base substrate at least partially overlaps the orthographic projection of the second electrode plate C42 of C4 on the base substrate;
The orthographic projection of CK1 on the base substrate at least partially overlaps the orthographic projection of the active pattern A9 of T9 on the base substrate; the orthographic projection of CK1 on the base substrate at least partially overlaps the orthographic projection of the active pattern A12 of T12 on the base substrate;
The orthographic projection of CB1 on the base substrate at least partially overlaps the orthographic projection of the active pattern A9 of T9 on the base substrate;
The orthographic projection of CB1 on the base substrate at least partially overlaps the orthographic projection of the first electrode plate C31 of C3 on the base substrate; the orthographic projection of CB1 on the base substrate at least partially overlaps the orthographic projection of the second electrode plate C32 of C3 on the base substrate;
The orthographic projection of CB1 on the base substrate at least partially overlaps the orthographic projection of the first electrode plate C31 of C3 on the base substrate; the orthographic projection of CB1 on the base substrate at least partially overlaps the orthographic projection of the second electrode plate C32 of C3 on the base substrate;
The orthographic projection of CB1 on the base substrate at least partially overlaps the orthographic projection of the first electrode plate C41 of C4 on the base substrate; the orthographic projection of CB1 on the base substrate at least partially overlaps the orthographic projection of the second electrode plate C42 of C4 on the base substrate.

Optionally, the active graphics of at least some transistors included in the second control circuit include at least two independent active pattern portions, and the at least two independent active pattern portions are spaced a certain distance to facilitate heat dissipation, so as to improve the performance of the transistor while ensuring the area of the active pattern.

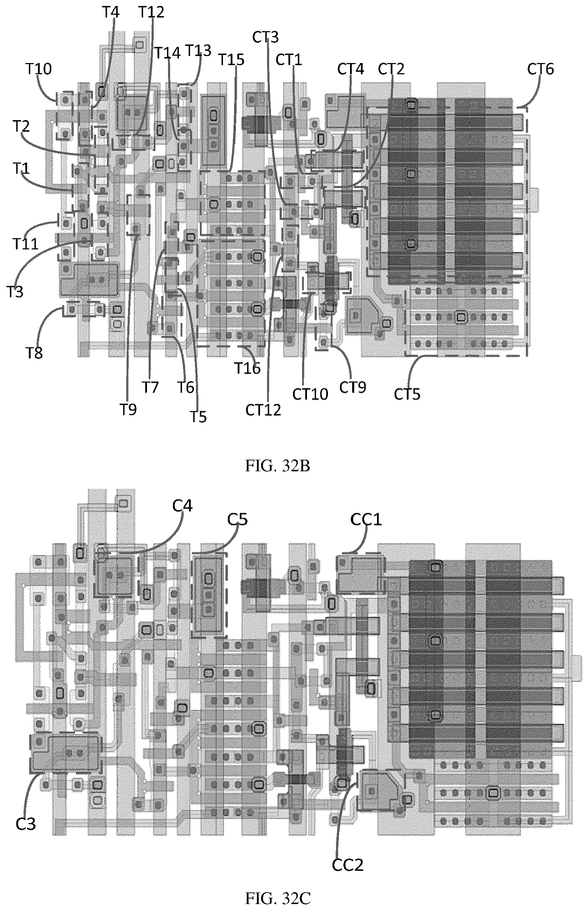

FIGS. 32A, 32B and 32C are second layout diagrams of the driving circuit shown in FIG. 14.

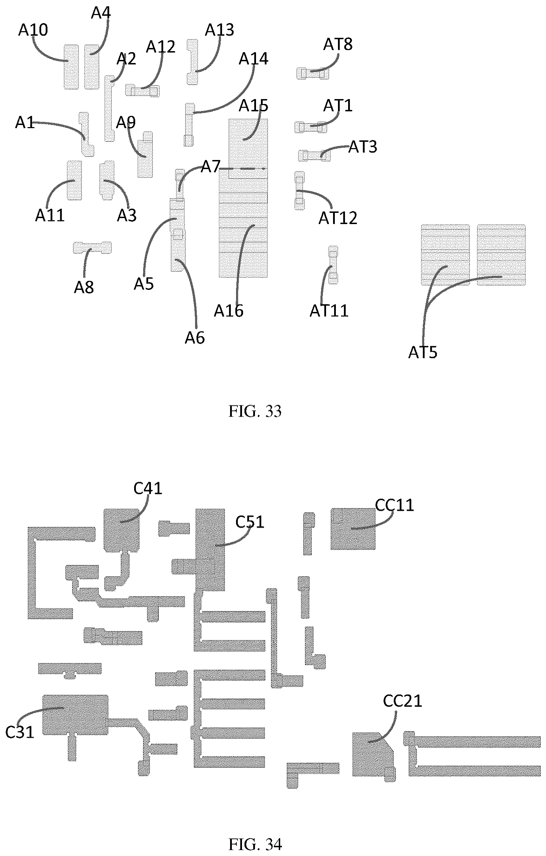

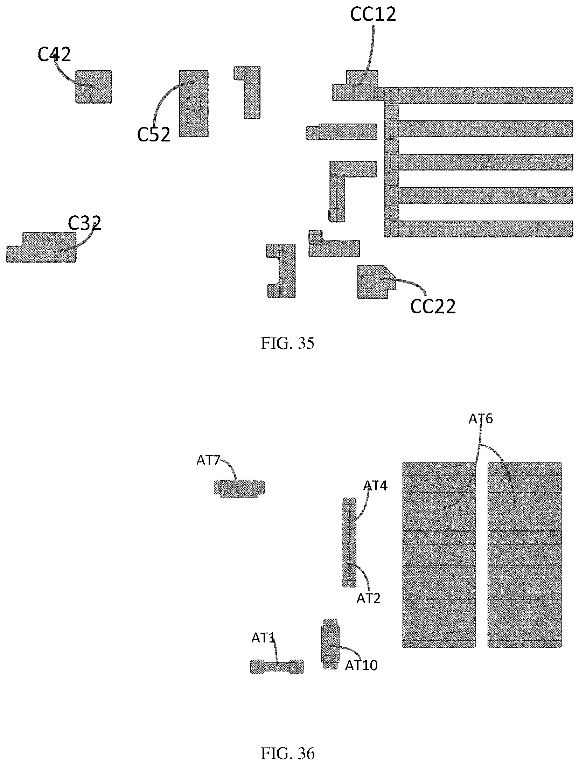

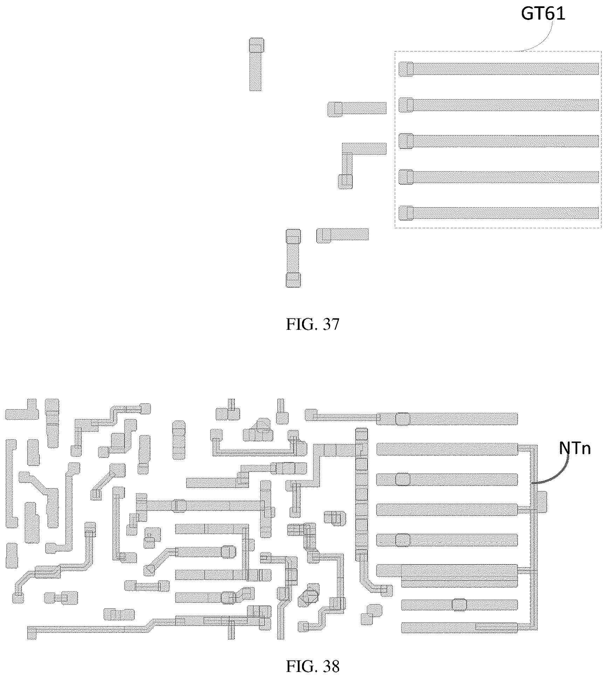

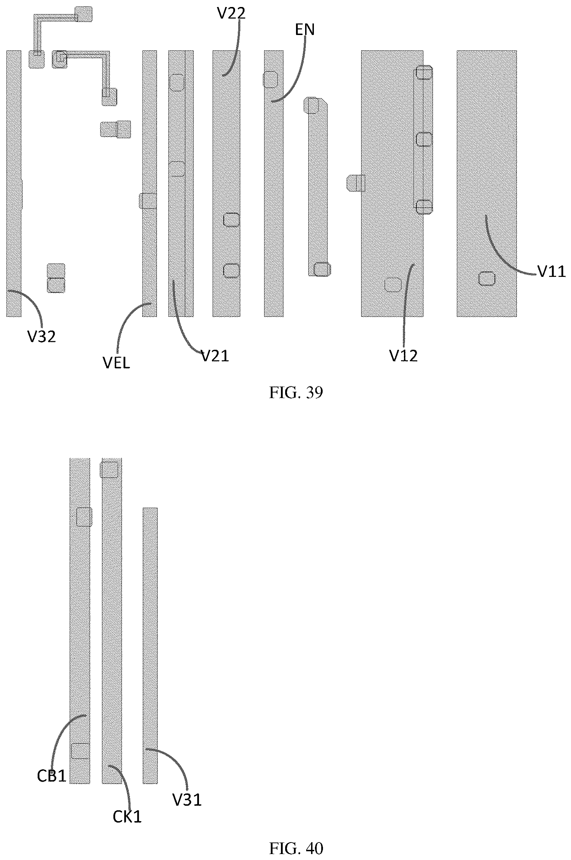

FIG. 33 is a layout diagram of the first semiconductor layer in FIG. 32A, FIG. 34 is a layout diagram of the first gate metal layer in FIG. 32A, FIG. 35 is a layout diagram of the second gate metal layer in FIG. 32A, FIG. 36 is a layout diagram of the second semiconductor layer in FIG. 32A, FIG. 37 is a layout diagram of the third gate metal layer in FIG. 32A, FIG. 38 is a layout diagram of the first source-drain metal layer in FIG. 32A, FIG. 39 is a layout diagram of the second source-drain metal layer in FIG. 32A, and FIG. 40 is a layout diagram of the third source-drain metal layer in FIG. 32A.

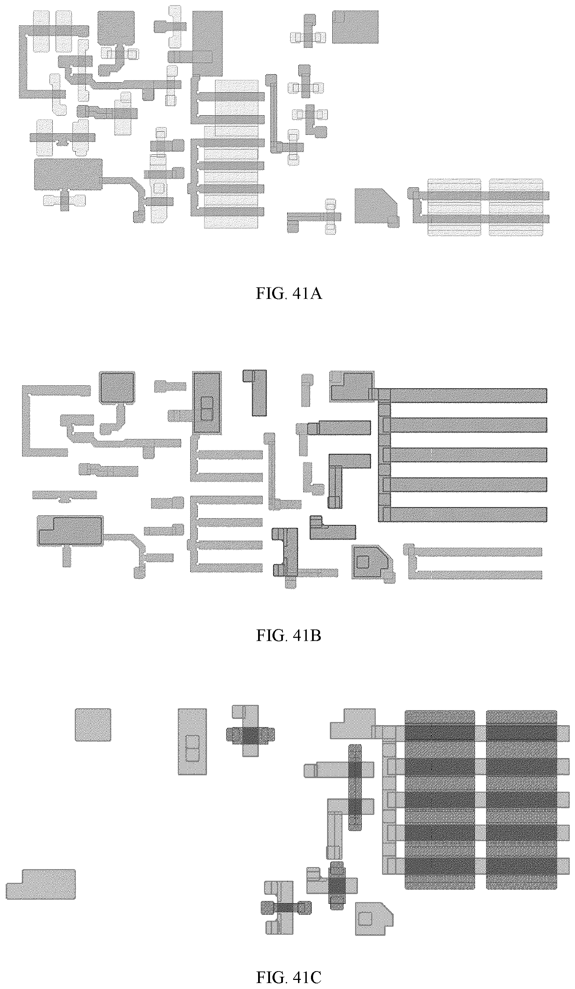

FIG.41A is a schematic diagram of the superposition of the first semiconductor layer and the first gate metal layer in FIG.32A; FIG.41B is a schematic diagram of the superposition of the first gate metal layer and the second gate metal layer in FIG.32A;

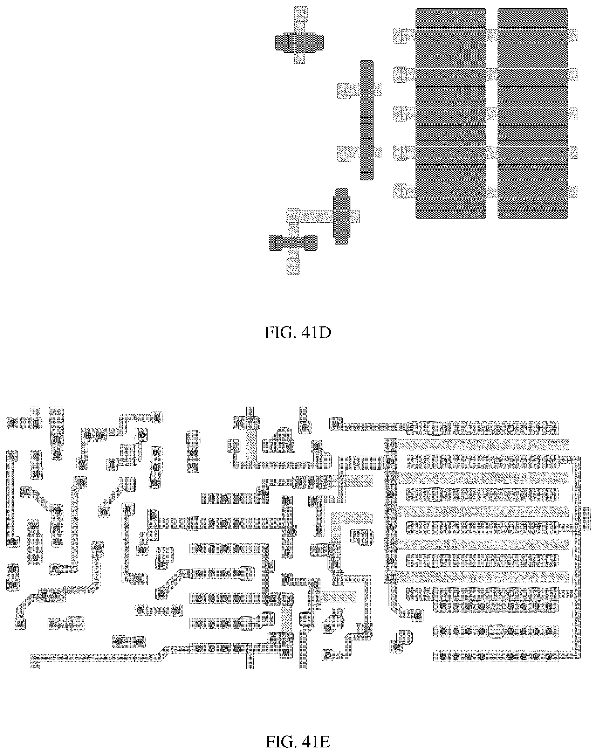

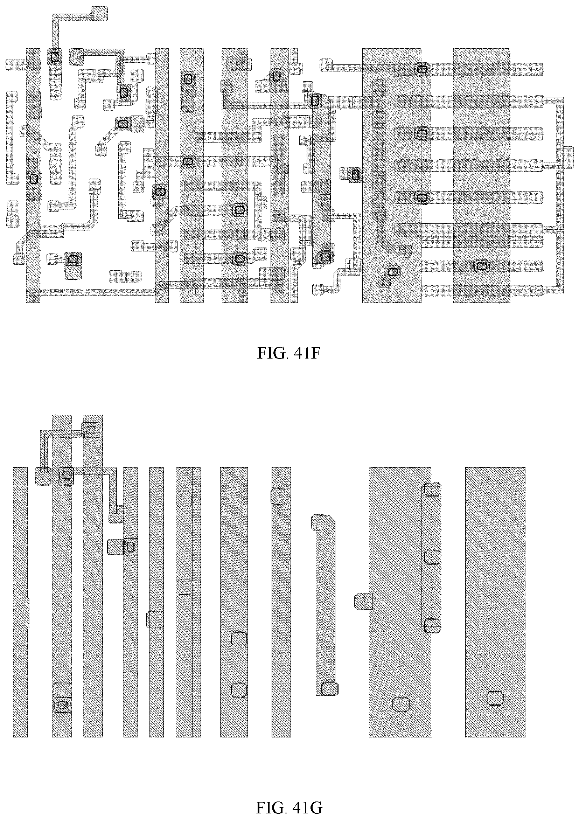

FIG. 41C is a schematic diagram of the superposition of the second gate metal layer and the second semiconductor layer in FIG. 32A; FIG. 41D is a schematic diagram of the superposition of the third gate metal layer and the second semiconductor layer in FIG. 32A; FIG. 41E is a schematic diagram of the superposition of the third gate metal layer and the first source-drain metal layer in FIG. 32A; FIG. 41F is a schematic diagram of the superposition of the first source-drain metal layer and the second source-drain metal layer in FIG. 32A; FIG. 41G is a schematic diagram of the superposition of the second source-drain metal layer and the third source-drain metal layer in FIG. 32A.

In at least one embodiment of the display substrate shown in FIG. 32A, the first semiconductor layer, the first gate metal layer, the second gate metal layer, the second semiconductor layer, the third gate metal layer, the first source-drain metal layer, the second source-drain metal layer and the third source-drain metal layer are arranged in sequence along the direction away from the base substrate.

At least one embodiment of the display substrate shown in FIG. 32A is a driving circuit manufactured using an LTPO (low temperature polycrystalline oxide) process.

In at least one embodiment of the present disclosure, the first semiconductor layer may be made of polysilicon, and the second semiconductor layer may be made of IGZO (indium gallium zinc oxide), but the present disclosure is not limited thereto.

In FIGS. 33 and 36, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, AT8 is an active pattern of CT8, AT9 is an active pattern of CT9, AT 10 is an active pattern of CT10, AT11 is an active pattern of CT11, and AT12 is an active pattern of CT12;
A1 is the active pattern of T1, A2 is the active pattern of T2, A3 is the active pattern of T3, A4 is the active pattern of T4, A5 is the active pattern of T5, A6 is the active pattern of T6, A7 is the active pattern of T7, A8 is the active pattern of T8, A9 is the active pattern of T9, A10 is the active pattern of T10, A11 is the active pattern of T11, A12 is the active pattern of T12, A13 is the active pattern of T13, A14 is the active pattern of T14, A15 is the active pattern of T15, and A16 is the active pattern of T16.

In FIG.34, CC11 is the first electrode plate of CC1, CC21 is the first electrode plate of CC2, C31 is the first electrode plate of C3, C41 is the first electrode plate of C4, and C51 is the first electrode plate of C5.

In FIG. 35, the one labeled CC12 is the second electrode plate of CC1, the one labeled CC22 is the second electrode plate of CC2, the one labeled C32 is the second electrode plate of C3, the one labeled C42 is the second electrode plate of C4, and the one labeled C52 is the second electrode plate of C5.

In FIG. 37, GT61 is a gate pattern included in the gate electrode of CT61.

As shown in FIG. 36, the active pattern of CT5 includes two active pattern portions that are independent of each other, and the active pattern of CT6 includes two active pattern portions that are independent of each other;
The two independent active pattern portions are spaced a certain distance to facilitate heat dissipation, so as to improve the performance of the transistor while ensuring the area of the active pattern.

As shown in FIGS. 32 to 40, the first first voltage line V11, the first second voltage line V12, the second second voltage line V22, the second first voltage line V21, the third first voltage line V31 and the third second voltage line V32 are sequentially arranged in a direction away from the display area;
V11, V12, V22, V21, V31 and V32 all extend in the vertical direction;
EN, VEL, CK1 and CB1 all extend in the vertical direction;
V11, V12, EN, V22, V21, VEL, V31, CK1, CB1 and V32 are arranged in sequence in a direction away from the display area;
The orthographic projection of V11 on the base substrate at least partially overlaps the orthographic projection of the active pattern AT5 of CT5 on the base substrate, and the orthographic projection of V11 on the base substrate at least partially overlaps the orthographic projection of the active pattern AT6 of CT6 on the base substrate;
The orthographic projection of V12 on the base substrate at least partially overlaps the orthographic projection of the active pattern AT5 of CT5 on the base substrate, and the orthographic projection of V12 on the base substrate at least partially overlaps the orthographic projection of the active pattern AT6 of CT6 on the base substrate;
The orthographic projection of EN on the base substrate at least partially overlaps the orthographic projection of the active pattern AT8 of CT8 on the base substrate; the orthographic projection of EN on the base substrate at least partially overlaps the orthographic projection of the active pattern AT12 of CT12 on the base substrate; the orthographic projection of EN on the base substrate at least partially overlaps the orthographic projection of the active pattern AT11 of CT11 on the base substrate;
The orthographic projection of V22 on the base substrate at least partially overlaps the orthographic projection of the active pattern AT7 of CT7 on the base substrate;
The orthographic projection of V22 on the base substrate at least partially overlaps the orthographic projection of the active pattern AT15 of T15 on the base substrate; the orthographic projection of V22 on the base substrate at least partially overlaps the orthographic projection of the active pattern AT16 of T16 on the base substrate;
The orthographic projection of V21 on the base substrate at least partially overlaps the orthographic projection of the active pattern AT15 of T15 on the base substrate; the orthographic projection of V21 on the base substrate at least partially overlaps the orthographic projection of the active pattern AT16 of T16 on the base substrate;
The orthographic projection of V21 on the base substrate at least partially overlaps the orthographic projection of the first electrode plate C51 of C5 on the base substrate; the orthographic projection of V21 on the base substrate at least partially overlaps the orthographic projection of the second electrode plate C52 of C5 on the base substrate; the orthographic projection of V31 on the base substrate at least partially overlaps the orthographic projection of the active pattern A5 of T5 on the base substrate; the orthographic projection of V31 on the base substrate at least partially overlaps the orthographic projection of the active pattern A6 of T6 on the base substrate; the orthographic projection of V31 on the base substrate at least partially overlaps the orthographic projection of the active pattern A7 of T7 on the base substrate;
The orthographic projection of CK1 on the base substrate at least partially overlaps the orthographic projection of the active pattern A9 of T9 on the base substrate; the orthographic projection of CK1 on the base substrate at least partially overlaps the orthographic projection of the active pattern A12 of T12 on the base substrate;
The orthographic projection of CK1 on the base substrate at least partially overlaps the orthographic projection of the first electrode plate C41 of C4 on the base substrate; the orthographic projection of CK1 on the base substrate at least partially overlaps the orthographic projection of the second electrode plate C42 of C4 on the base substrate;
The orthographic projection of CB1 on the base substrate at least partially overlaps the orthographic projection of the first electrode plate C41 of C4 on the base substrate; the orthographic projection of CB1 on the base substrate at least partially overlaps the orthographic projection of the second electrode plate C42 of C4 on the base substrate;
The orthographic projection of CB1 on the base substrate at least partially overlaps the orthographic projection of the first electrode plate C31 of C3 on the base substrate; the orthographic projection of CB1 on the base substrate at least partially overlaps the orthographic projection of the second electrode plate C32 of C3 on the base substrate;
The orthographic projection of V32 on the base substrate at least partially overlaps the orthographic projection of the first electrode plate C31 of C3 on the base substrate; the orthographic projection of V32 on the base substrate at least partially overlaps the orthographic projection of the second electrode plate C32 of C3 on the base substrate;
The orthographic projection of V32 on the base substrate at least partially overlaps the orthographic projection of the active pattern A4 of T4 on the base substrate; the orthographic projection of V32 on the base substrate at least partially overlaps the orthographic projection of the active pattern A1 of T1 on the base substrate; the orthographic projection of V32 on the base substrate at least partially overlaps the orthographic projection of the active pattern A8 of T8 on the base substrate.

In at least one embodiment of the present disclosure, the first voltage line includes a first first voltage line, a second first voltage line, a third first voltage line, and a fourth first voltage line sequentially arranged along a direction away from the display area, and the second voltage line includes a first second voltage line, a second second voltage line, a third second voltage line, and a fourth second voltage line sequentially arranged along a direction away from the display area;
An orthographic projection of the third first voltage line on the base substrate at least partially overlaps an orthographic projection of the active pattern of at least one transistor included in the output circuit on the base substrate;
An orthographic projection of the third first voltage line on the base substrate at least partially overlaps an orthographic projection of the electrode plate of the capacitor included in the potential maintaining circuit on the base substrate;
An orthographic projection of the third second voltage line on the base substrate at least partially overlaps an orthographic projection of the active pattern of at least one transistor included in the output circuit on the base substrate;
An orthographic projection of the fourth first voltage line on the base substrate at least partially overlaps an orthographic projection of the active pattern of at least one transistor included in the second output node control circuit on the base substrate;
An orthographic projection of the fourth second voltage line on the base substrate at least partially overlaps an orthographic projection of the active pattern of at least one transistor included in the first node control circuit on the base substrate;
An orthographic projection of the fourth second voltage line on the base substrate at least partially overlaps an orthographic projection of an electrode plate of a capacitor included in the second node control circuit on the base substrate.

In at least one embodiment of the present disclosure, the orthographic projection of each signal line on the base substrate at least partially overlaps the orthographic projection of the active pattern of the corresponding transistor on the base substrate, and the orthographic projection of the signal line on the base substrate at least partially overlap with the orthographic projection of the electrode plate of the corresponding capacitor on the base substrate, so as to reduce the lateral space occupied by the driving circuit, thereby facilitating the realization of a narrow frame.

In at least one embodiment of the present disclosure, the display substrate further includes a second first clock signal line and a second second clock signal line arranged between the fourth first voltage line and the fourth second voltage line;
An orthographic projection of the second first clock signal line on the base substrate at least partially overlaps the orthographic projection of the electrode plate of the capacitor included in the first output node control circuit on the base substrate;
An orthographic projection of the second second clock signal line on the base substrate at least partially overlaps the orthographic projection of the electrode plate of the capacitor included in the first output node control circuit on the base substrate;
An orthographic projection of the second second clock signal line on the base substrate at least partially overlaps the orthographic projection of the electrode plate of the capacitor included in the first output node control circuit on the base substrate;
An orthographic projection of the second first clock signal line on the base substrate at least partially overlaps the orthographic projection of the active patterns of at least part of the transistor included in the second node control circuit on the base substrate;
An orthographic projection of the second first clock signal line on the base substrate at least partially overlaps the orthographic projection of active patterns of at least part of transistors included in the first output node control circuit on the base substrate.

In at least one embodiment of the present disclosure, the second first clock signal line and the second second clock signal line are arranged between the second first voltage line and the fourth second voltage line;
An orthographic projection of the second first clock signal line on the base substrate at least partially overlaps the orthographic projection of the active pattern of at least part of the transistors included in the second output node control circuit on the base substrate;
An orthographic projection of the second second clock signal line on the base substrate at least partially overlaps with the orthographic projection of active patterns of at least part of transistors included in the second output node control circuit on the base substrate.

In at least one embodiment of the present disclosure, the orthographic projection of the second first voltage line on the base substrate at least partially overlaps the orthographic projection of the active pattern of at least part of the transistors included in the first control circuit on the base substrate;
An orthographic projection of the enable signal line on the base substrate at least partially overlaps the orthographic projection of the electrode plate of the capacitor included in the second energy storage circuit on the base substrate;
An orthographic projection of the second second voltage line on the base substrate at least partially overlaps the orthographic projection of the electrode plate of the capacitor included in the second energy storage circuit on the base substrate;
An orthographic projection of the second second voltage line on the base substrate at least partially overlaps an orthographic projection of active patterns of at least part of transistors included in the control signal generation circuit on the base substrate.

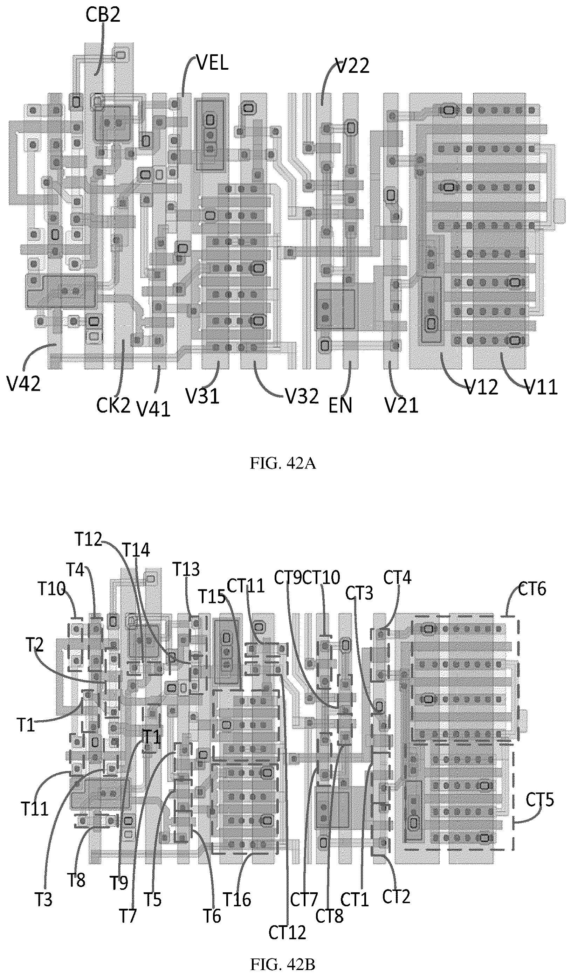

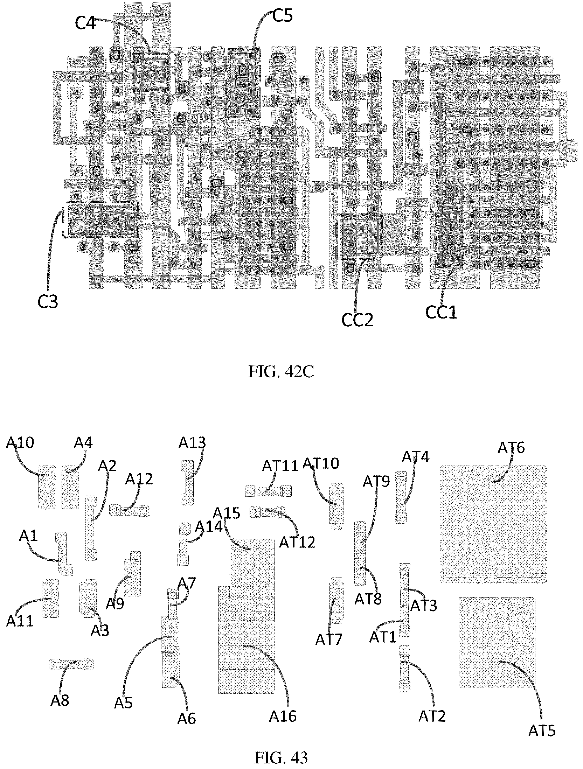

FIGS. 42A, 42B and 42C are first layout diagrams of the driving circuit shown in FIG. 17.

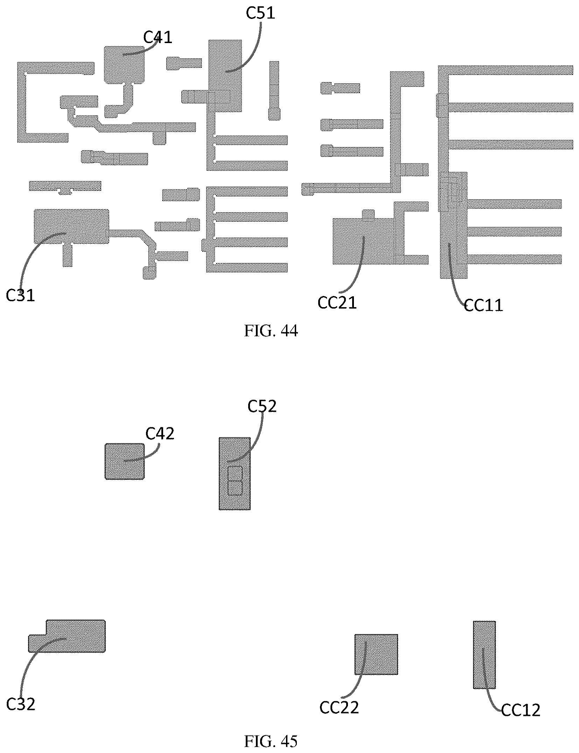

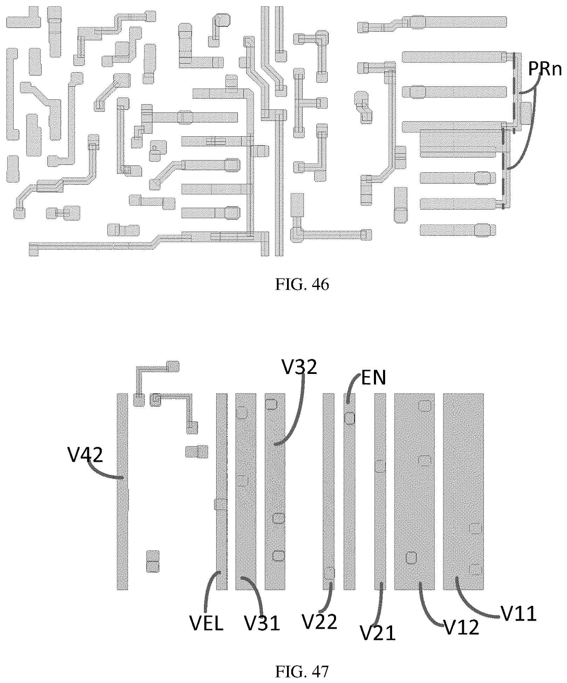

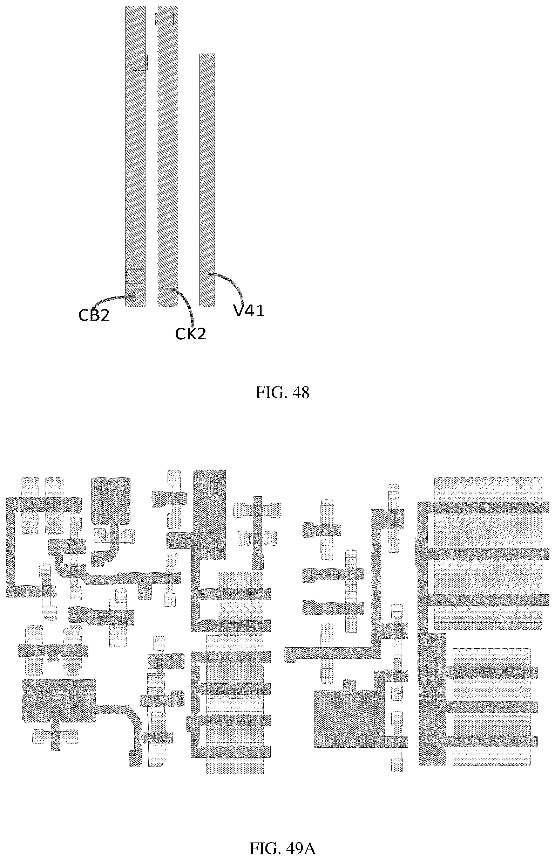

FIG. 43 is a layout diagram of the first semiconductor layer in FIG. 42A, FIG. 44 is a layout diagram of the first gate metal layer in FIG. 42A, FIG. 45 is a layout diagram of the second gate metal layer in FIG. 42A, FIG. 46 is a layout diagram of the first source-drain metal layer in FIG. 42A, FIG. 47 is a layout diagram of the second source-drain metal layer in FIG. 42A, and FIG. 48 is a layout diagram of the third source-drain metal layer in FIG. 42A.

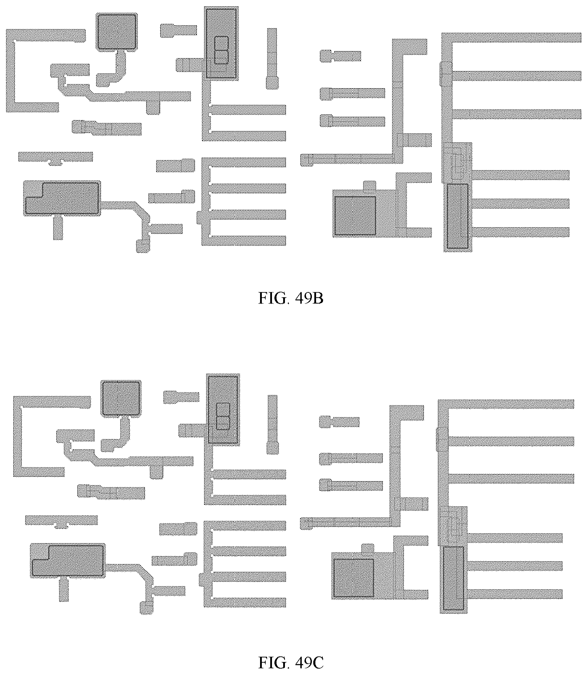

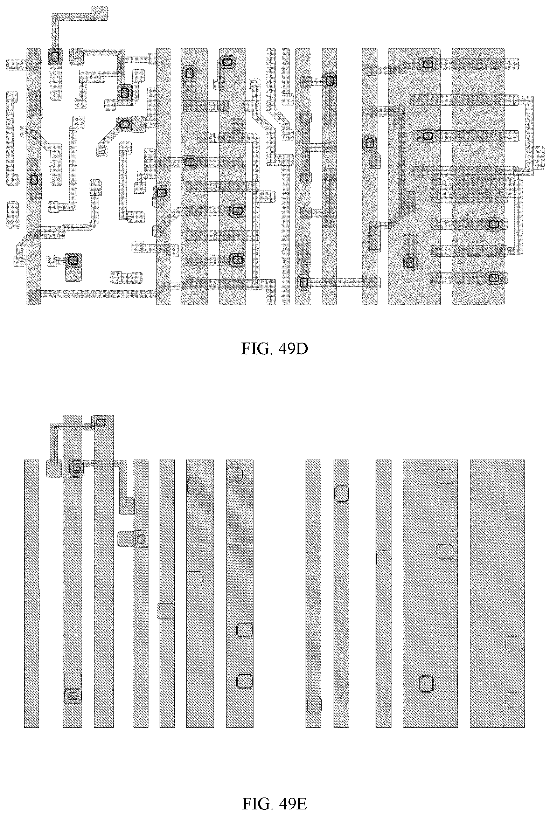

FIG. 49A is a superposed diagram of the first semiconductor layer and the first gate metal layer in FIG. 42A, FIG. 49B is a superposed diagram of the first gate metal layer and the second gate metal layer in FIG. 42A, FIG. 49C is a superposed diagram of the second gate metal layer and the first source-drain metal layer in FIG. 42A, FIG. 49D is a superposed diagram of the first source-drain metal layer and the second source-drain metal layer in FIG. 42A, and FIG. 49E is a superposed diagram of the second source-drain metal layer and the third source-drain metal layer in FIG. 42A.

In at least one embodiment of the display substrate shown in FIG. 42A, the first semiconductor layer, the first gate metal layer, the second gate metal layer, the first source-drain metal layer, the second source-drain metal layer and the third source-drain metal layer are arranged in sequence in a direction away from the base substrate.

At least one embodiment of the display substrate shown in FIG. 42A is a display substrate manufactured using a CMOS process.

In FIG. 43, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, AT8 is an active pattern of CT8, AT9 is an active pattern of CT9, AT 10 is an active pattern of CT10, AT11 is an active pattern of CT11, and AT12 is an active pattern of CT12;
A1 is the active pattern of T1, A2 is the active pattern of T2, A3 is the active pattern of T3, A4 is the active pattern of T4, A5 is the active pattern of T5, A6 is the active pattern of T6, A7 is the active pattern of T7, A8 is the active pattern of T8, A9 is the active pattern of T9, A10 is the active pattern of T10, A11 is the active pattern of T11, A12 is the active pattern of T12, A13 is the active pattern of T13, A14 is the active pattern of T14, A15 is the active pattern of T15, and A16 is the active pattern of T16.

In FIG. 44, CC11 is the first electrode plate of CC1, CC21 is the first electrode plate of CC2, C31 is the first electrode plate of C3, C41 is the first electrode plate of C4, and C51 is the first electrode plate of C5.

In FIG. 45, CC12 is the second electrode plate of CC1, CC22 is the second electrode plate of CC2, C32 is the second electrode plate of C3, C42 is the second electrode plate of C4, and C52 is the second electrode plate of C5.

As shown in FIGS. 42A-48, the first voltage lines include a first first voltage line V11, a second first voltage line V21, a third first voltage line V31, and a fourth first voltage line V41 sequentially arranged in a direction away from the display area; the second voltage lines include a first second voltage line V12, a second second voltage line V22, a third second voltage line V32, and a fourth second voltage line V42 sequentially arranged in a direction away from the display area;
The orthographic projection of V11 on the base substrate at least partially overlaps the orthographic projection of the active pattern AT5 of CT5 on the base substrate; the orthographic projection of V11 on the base substrate at least partially overlaps the orthographic projection of the active pattern AT6 of CT6 on the base substrate;
The orthographic projection of V12 on the base substrate at least partially overlaps the orthographic projection of the active pattern AT5 of CT5 on the base substrate; the orthographic projection of V12 on the base substrate at least partially overlaps the orthographic projection of the active pattern AT6 of CT6 on the base substrate;
The orthographic projection of V12 on the base substrate at least partially overlaps the orthographic projection of the first electrode plate CC11 of CC1 on the base substrate; the orthographic projection of V12 on the base substrate at least partially overlaps the orthographic projection of the second electrode plate CC12 of CC1 on the base substrate;
The orthographic projection of V21 on the base substrate at least partially overlaps the orthographic projection of the active pattern AT4 of CT4 on the base substrate; the orthographic projection of V21 on the base substrate at least partially overlaps the orthographic projection of the active pattern AT3 of CT3 on the base substrate;
The orthographic projection of EN on the base substrate at least partially overlaps the orthographic projection of the first electrode plate CC21 of CC2 on the base substrate; the orthographic projection of EN on the base substrate at least partially overlaps the orthographic projection of the second electrode plate CC22 of CC2 on the base substrate;
The orthographic projection of EN on the base substrate at least partially overlaps the orthographic projection of the active pattern AT9 of CT9 on the base substrate; the orthographic projection of EN on the base substrate at least partially overlaps the orthographic projection of the active pattern AT8 of CT8 on the base substrate;
The orthographic projection of V22 on the base substrate at least partially overlaps the orthographic projection of the first electrode plate CC21 of CC2 on the base substrate; the orthographic projection of V22 on the base substrate at least partially overlaps the orthographic projection of the second electrode plate CC22 of CC2 on the base substrate;
The orthographic projection of V22 on the base substrate at least partially overlaps the orthographic projection of the active pattern AT 10 of CT10 on the base substrate; the orthographic projection of V22 on the base substrate at least partially overlaps the orthographic projection of the active pattern AT7 of CT7 on the base substrate;
The orthographic projection of V31 on the base substrate at least partially overlaps the orthographic projection of the active pattern A15 of T15 on the base substrate; the orthographic projection of V31 on the base substrate at least partially overlaps the orthographic projection of the active pattern A16 of T16 on the base substrate;
The orthographic projection of V31 on the base substrate at least partially overlaps the orthographic projection of the first electrode plate C51 of C5 on the base substrate; the orthographic projection of V31 on the base substrate at least partially overlaps the orthographic projection of the second electrode plate C52 of C5 on the base substrate;
The orthographic projection of V41 on the base substrate at least partially overlaps the orthographic projection of the active pattern A5 of T5 on the base substrate; the orthographic projection of V41 on the base substrate at least partially overlaps the orthographic projection of the active pattern A6 of T6 on the base substrate; the orthographic projection of V41 on the base substrate at least partially overlaps the orthographic projection of the active pattern A7 of T7 on the base substrate;
The orthographic projection of V42 on the base substrate at least partially overlaps the orthographic projection of the active pattern A4 of T4 on the base substrate; the orthographic projection of V42 on the base substrate at least partially overlaps the orthographic projection of the active pattern A1 of T1 on the base substrate; the orthographic projection of V42 on the base substrate at least partially overlaps the orthographic projection of the active pattern A8 of T8 on the base substrate;
The orthographic projection of V42 on the base substrate at least partially overlaps the orthographic projection of the first electrode plate C31 of C3 on the base substrate; the orthographic projection of V42 on the base substrate at least partially overlaps the orthographic projection of the second electrode plate C32 of C3 on the base substrate.

As shown in FIGS. 42A-48, the display substrate further includes a second first clock signal line CK2 and a second second clock signal line CB2 arranged between V41 and V42;
The orthographic projection of CK2 on the base substrate at least partially overlaps the orthographic projection of the first electrode plate C41 of C4 on the base substrate; the orthographic projection of CK2 on the base substrate at least partially overlaps the orthographic projection of the second electrode plate C42 of C4 on the base substrate;
The orthographic projection of CK2 on the base substrate at least partially overlaps the orthographic projection of the active pattern A9 of T9 on the base substrate; the orthographic projection of CK2 on the base substrate at least partially overlaps the orthographic projection of the active pattern A12 of T12 on the base substrate;
The orthographic projection of CB2 on the base substrate at least partially overlaps the orthographic projection of the first electrode plate C41 of C4 on the base substrate; the orthographic projection of CB2 on the base substrate at least partially overlaps the orthographic projection of the second electrode plate C42 of C4 on the base substrate;
The orthographic projection of CB2 on the base substrate at least partially overlaps the orthographic projection of the first electrode plate C31 of C3 on the base substrate; the orthographic projection of CB2 on the base substrate at least partially overlaps the orthographic projection of the second electrode plate C32 of C3 on the base substrate.

In at least one embodiment of the present disclosure, the second voltage line includes a third second voltage line; the third second voltage line is arranged on a side of the second second voltage line away from the display area;
An orthographic projection of the third second voltage line on the base substrate at least partially overlaps an orthographic projection of an active pattern of at least one transistor included in the output inverter circuit on the base substrate.

As shown in FIGS. 42A-48, the second voltage lines include a third second voltage line V32, and V32 is arranged on a side of V22 away from the display area;
The orthographic projection of V32 on the base substrate at least partially overlaps the orthographic projection of the active pattern A15 of T15 on the base substrate; the orthographic projection of V32 on the base substrate at least partially overlaps the orthographic projection of the active pattern A16 of T16 on the base substrate;
The orthographic projection of V32 on the base substrate at least partially overlaps the orthographic projection of the active pattern AT11 of CT11 on the base substrate; the orthographic projection of V32 on the base substrate at least partially overlaps the orthographic projection of the active pattern AT12 of CT12 on the base substrate;
In at least one embodiment of the present disclosure, the orthographic projection of the second first voltage line on the base substrate at least partially overlaps the orthographic projection of the active pattern of at least part of the transistors included in the first control circuit on the base substrate;
The orthographic projection of the second second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the active pattern of at least part of the transistor included in the first control circuit on the base substrate;
The orthographic projection of the second first voltage line on the base substrate at least partially overlaps the orthographic projection of the active pattern of at least part of the transistor included in the first control circuit on the base substrate;
An orthographic projection of the second first voltage line on the base substrate at least partially overlaps an orthographic projection of active patterns of at least part of transistors included in the control signal generation circuit on the base substrate.

In at least one embodiment of the present disclosure, the orthographic projection of each signal line on the base substrate at least partially overlaps the orthographic projection of the active pattern of the corresponding transistor on the base substrate, and the orthographic projection of the signal line on the base substrate at least partially overlap the orthographic projection of the electrode plate of the corresponding capacitor on the base substrate, so as to reduce the lateral space occupied by the driving circuit, thereby facilitating the realization of a narrow frame.

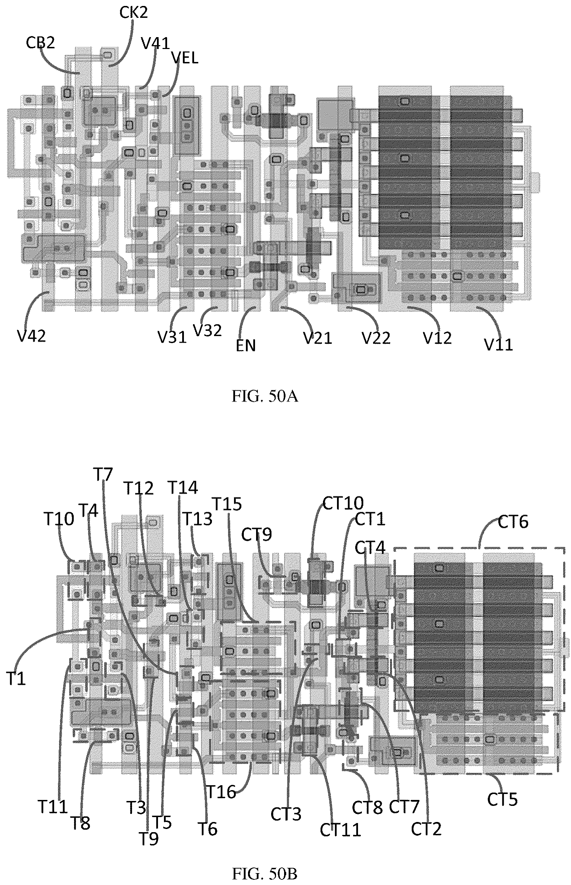

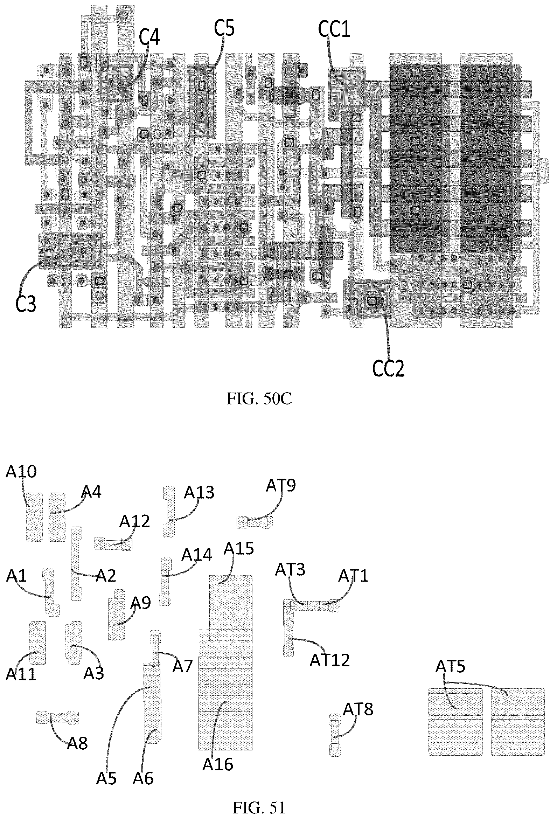

FIGS. 50A, 50B and 50C are second layout diagrams of the driving circuit shown in FIG. 17.

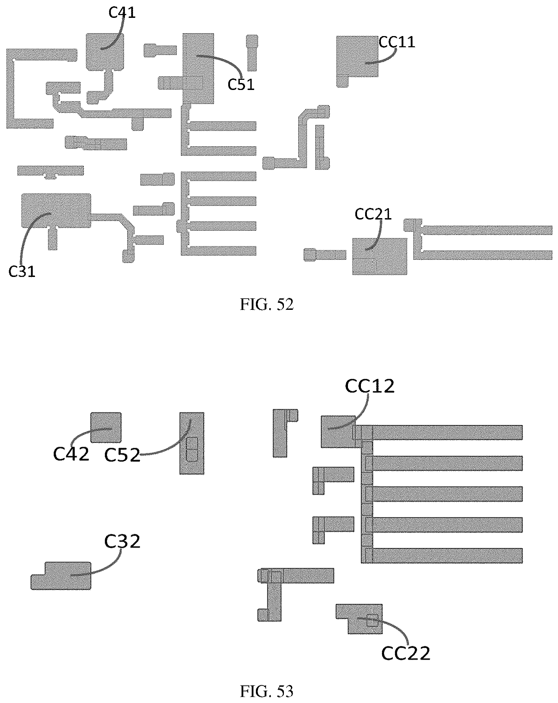

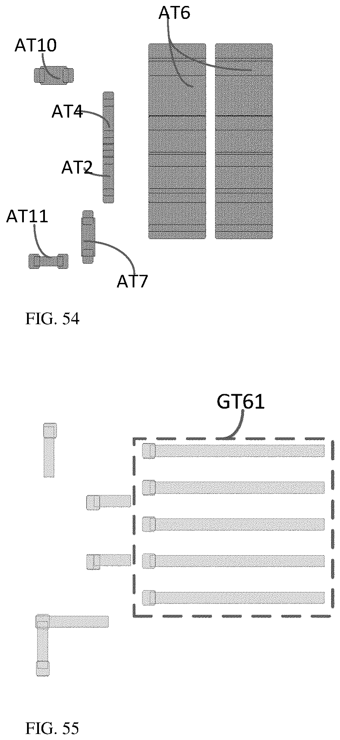

FIG. 51 is a layout diagram of the first semiconductor layer in FIG. 50A, FIG. 52 is a layout diagram of the first gate metal layer in FIG. 50A, FIG. 53 is a layout diagram of the second gate metal layer in FIG. 50A, FIG. 54 is a layout diagram of the second semiconductor layer in FIG. 50A, FIG. 55 is a layout diagram of the third gate metal layer in FIG. 50A, FIG. 56 is a layout diagram of the first source-drain metal layer in FIG. 50A, FIG. 57 is a layout diagram of the second source-drain metal layer in FIG. 50A, and FIG. 58 is a layout diagram of the third source-drain metal layer in FIG. 50A.

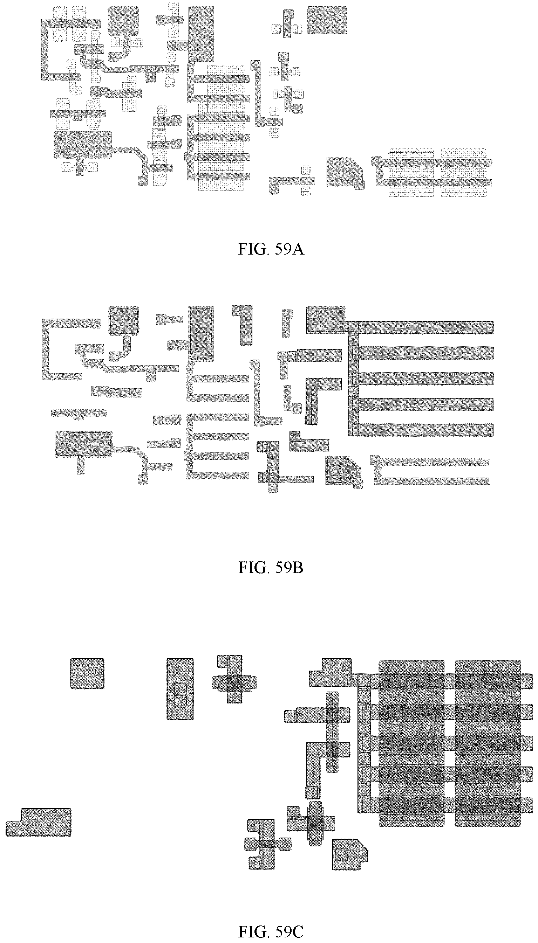

FIG.59A is a schematic diagram of the superposition of the first semiconductor layer and the first gate metal layer in FIG.50A; FIG.59B is a schematic diagram of the superposition of the first gate metal layer and the second gate metal layer in FIG.50A;

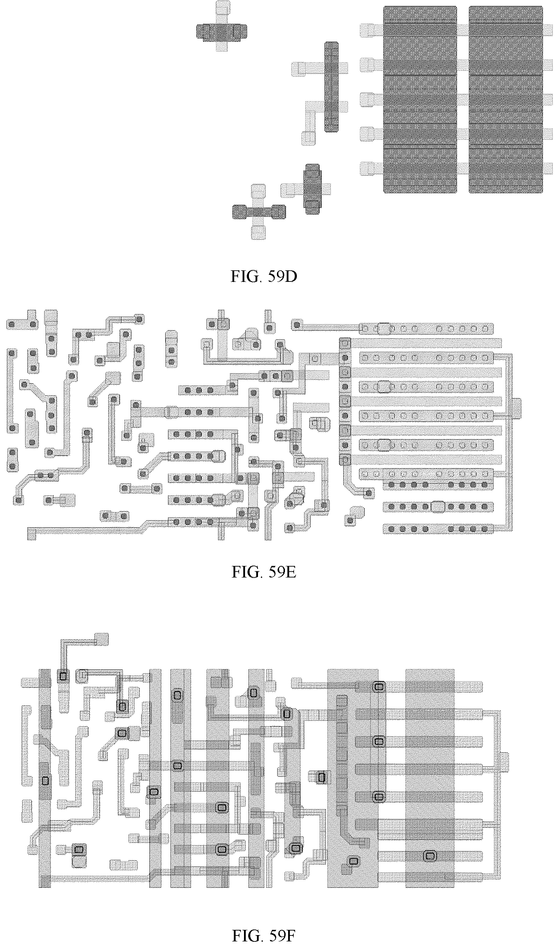

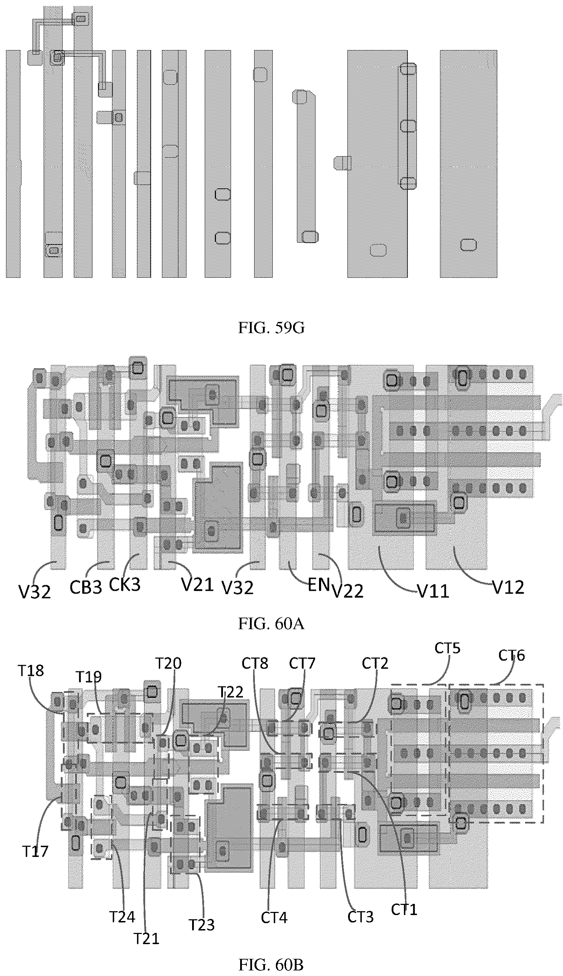

FIG. 59C is a schematic diagram of the superposition of the second gate metal layer and the second semiconductor layer in FIG. 50A; FIG. 59D is a schematic diagram of the superposition of the third gate metal layer and the second semiconductor layer in FIG. 50A; FIG. 59E is a schematic diagram of the superposition of the third gate metal layer and the first source-drain metal layer in FIG. 50A; FIG. 59F is a schematic diagram of the superposition of the first source-drain metal layer and the second source-drain metal layer in FIG. 50A; FIG. 59G is a schematic diagram of the superposition of the second source-drain metal layer and the third source-drain metal layer in FIG. 50A.

In at least one embodiment of the display substrate shown in FIG. 50A, the first semiconductor layer, the first gate metal layer, the second gate metal layer, the second semiconductor layer, the third gate metal layer, the first source-drain metal layer, the second source-drain metal layer and the third source-drain metal layer are arranged in sequence along the direction away from the base substrate.

At least one embodiment of the display substrate shown in FIG. 50A is a driving circuit manufactured using an LTPO (low temperature polycrystalline oxide) process.

In FIGS. 51 and 54, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, AT8 is an active pattern of CT8, AT9 is an active pattern of CT9, AT10 is an active pattern of CT10, AT11 is an active pattern of CT11, and AT12 is an active pattern of CT12;
A1 is the active pattern of T1, A2 is the active pattern of T2, A3 is the active pattern of T3, A4 is the active pattern of T4, A5 is the active pattern of T5, A6 is the active pattern of T6, A7 is the active pattern of T7, A8 is the active pattern of T8, A9 is the active pattern of T9, A10 is the active pattern of T10, A11 is the active pattern of T11, A12 is the active pattern of T12, A13 is the active pattern of T13, A14 is the active pattern of T14, A15 is the active pattern of T15, and A16 is the active pattern of T16.

In FIG. 52, the one labeled CC11 is the first electrode plate of CC1, the one labeled CC21 is the first electrode plate of CC2, the one labeled C31 is the first electrode plate of C3, the one labeled C41 is the first electrode plate of C4, and the one labeled C51 is the first electrode plate of C5.

In FIG. 53, the one labeled CC12 is the second electrode plate of CC1, the one labeled CC22 is the second electrode plate of CC2, the one labeled C32 is the second electrode plate of C3, the one labeled C42 is the second electrode plate of C4, and the one labeled C52 is the second electrode plate of C5.

As shown in FIGS. 50A to 58, the orthographic projection of the second second voltage line V22 on the base substrate at least partially overlaps the orthographic projection of the active pattern AT4 of CT4 on the base substrate; the orthographic projection of the second second voltage line V22 on the base substrate at least partially overlaps the orthographic projection of the active pattern AT2 of CT2 on the base substrate;
The orthographic projection of the second second voltage line V22 on the base substrate at least partially overlaps the orthographic projection of the first electrode plate CC11 of CC1 on the base substrate; the orthographic projection of the second second voltage line V22 on the base substrate at least partially overlaps the orthographic projection of the second electrode plate CC12 of CC1 on the base substrate;
The orthographic projection of the second second voltage line V22 on the base substrate at least partially overlaps the orthographic projection of the first electrode plate CC21 of CC2 on the base substrate; the orthographic projection of the second second voltage line V22 on the base substrate at least partially overlaps the orthographic projection of the second electrode plate CC22 of CC2 on the base substrate;
In at least one embodiment of the present disclosure, the orthographic projection of the second first voltage line on the base substrate at least partially overlaps the orthographic projection of the active pattern of at least one transistor included in the output inverter circuit on the base substrate;
The enable signal line is arranged on a side of the second first voltage line away from the display area.

As shown in FIGS. 50A to 58, the orthographic projection of the second first voltage line V21 on the base substrate at least partially overlaps the orthographic projection of the active pattern AT12 of CT12 on the base substrate; the orthographic projection of the second first voltage line V21 on the base substrate at least partially overlaps the orthographic projection of the active pattern AT11 of CT11 on the base substrate;
The orthographic projection of the second first voltage line V21 on the base substrate at least partially overlaps the orthographic projection of the active pattern AT10 of CT10 on the base substrate; the orthographic projection of the second first voltage line V21 on the base substrate at least partially overlaps the orthographic projection of the active pattern AT3 of CT3 on the base substrate;
The enable signal line EN is arranged at a side of the second first voltage line V21 away from the display area.

As shown in FIGS. 50A to 58, the first voltage lines include a first first voltage line V11, a second first voltage line V21, a third first voltage line V31, and a fourth first voltage line V41 sequentially arranged in a direction away from the display area; the second voltage lines include a first second voltage line V12, a second second voltage line V22, a third second voltage line V32, and a fourth second voltage line V42 sequentially arranged in a direction away from the display area;
V11, V12, V22, V21, EN, V32, V31, VEL, V41, CK2, CB2 and V42 are arranged in sequence in a direction away from the display area;
V11, V12, V22, V21, EN, V32, V31, VEL, V41, CK2, CB2 and V42 are arranged in sequence along the vertical direction.

As shown in FIGS. 50A to 58, the orthographic projection of V11 on the base substrate at least partially overlaps the orthographic projection of the active pattern AT6 of CT6 on the base substrate; the orthographic projection of V11 on the base substrate at least partially overlaps the orthographic projection of the active pattern AT5 of CT5 on the base substrate;
The orthographic projection of V12 on the base substrate at least partially overlaps the orthographic projection of the active pattern AT6 of CT6 on the base substrate; the orthographic projection of V12 on the base substrate at least partially overlaps the orthographic projection of the active pattern AT5 of CT5 on the base substrate;
The orthographic projection of the enable signal line EN on the base substrate at least partially overlaps the orthographic projection of the active pattern AT9 of CT9 on the base substrate;
The orthographic projection of V32 on the base substrate at least partially overlaps the orthographic projection of the active pattern A15 of T15 on the base substrate; the orthographic projection of V32 on the base substrate at least partially overlaps the orthographic projection of the active pattern A16 of T16 on the base substrate;
The orthographic projection of V31 on the base substrate at least partially overlaps the orthographic projection of the active pattern A15 of T15 on the base substrate; the orthographic projection of V31 on the base substrate at least partially overlaps the orthographic projection of the active pattern A16 of T16 on the base substrate;
The orthographic projection of V31 on the base substrate at least partially overlaps the orthographic projection of the first electrode plate C51 of C5 on the base substrate; the orthographic projection of V31 on the base substrate at least partially overlaps the orthographic projection of the second electrode plate C52 of C5 on the base substrate;
The orthographic projection of V41 on the base substrate at least partially overlaps the orthographic projection of the active pattern A5 of T5 on the base substrate; the orthographic projection of V41 on the base substrate at least partially overlaps the orthographic projection of the active pattern A6 of T6 on the base substrate; the orthographic projection of V41 on the base substrate at least partially overlaps the orthographic projection of the active pattern A7 of T7 on the base substrate;
The orthographic projection of V42 on the base substrate at least partially overlaps the orthographic projection of the active pattern A4 of T4 on the base substrate; the orthographic projection of V42 on the base substrate at least partially overlaps the orthographic projection of the active pattern A1 of T1 on the base substrate; the orthographic projection of V42 on the base substrate at least partially overlaps the orthographic projection of the active pattern A8 of T8 on the base substrate;
The orthographic projection of V42 on the base substrate at least partially overlaps the orthographic projection of the first electrode plate C31 of C3 on the base substrate; the orthographic projection of V42 on the base substrate at least partially overlaps the orthographic projection of the second electrode plate C32 of C3 on the base substrate;
The orthographic projection of CK2 on the base substrate at least partially overlaps the orthographic projection of the first electrode plate C41 of C4 on the base substrate; the orthographic projection of CK2 on the base substrate at least partially overlaps the orthographic projection of the second electrode plate C42 of C4 on the base substrate;
The orthographic projection of CK2 on the base substrate at least partially overlaps the orthographic projection of the active pattern A9 of T9 on the base substrate; the orthographic projection of CK2 on the base substrate at least partially overlaps the orthographic projection of the active pattern A12 of T12 on the base substrate;
The orthographic projection of CB2 on the base substrate at least partially overlaps the orthographic projection of the first electrode plate C41 of C4 on the base substrate; the orthographic projection of CB2 on the base substrate at least partially overlaps the orthographic projection of the second electrode plate C42 of C4 on the base substrate;
The orthographic projection of CB2 on the base substrate at least partially overlaps the orthographic projection of the first electrode plate C31 of C3 on the base substrate; the orthographic projection of CB2 on the base substrate at least partially overlaps the orthographic projection of the second electrode plate C32 of C3 on the base substrate.

As shown in FIG. 50A, the active pattern of CT5 includes two active pattern portions that are independent of each other, and the active pattern of CT6 includes two active pattern portions that are independent of each other;
The two independent active pattern portions are spaced a certain distance to facilitate heat dissipation, so as to improve the performance of the transistor while ensuring the area of the active pattern.

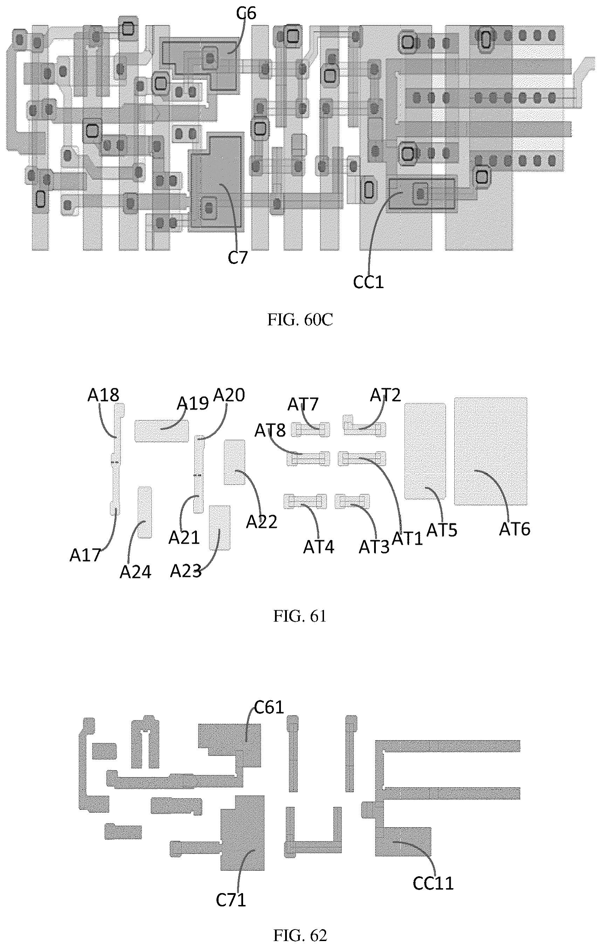

FIGS. 60A, 60B and 60C are first layout diagrams of the driving circuit shown in FIG. 20.

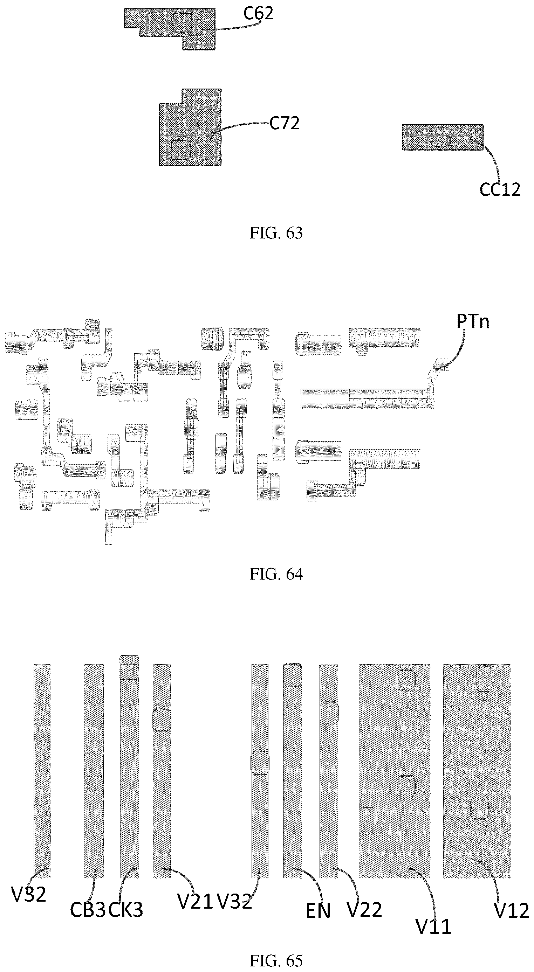

FIG. 61 is a layout diagram of the first semiconductor layer in FIG. 60A, FIG. 62 is a layout diagram of the first gate metal layer in FIG. 60A, FIG. 63 is a layout diagram of the second gate metal layer in FIG. 60A, FIG. 64 is a layout diagram of the first source-drain metal layer in FIG. 60A, and FIG. 65 is a layout diagram of the second source-drain metal layer in FIG. 60A.

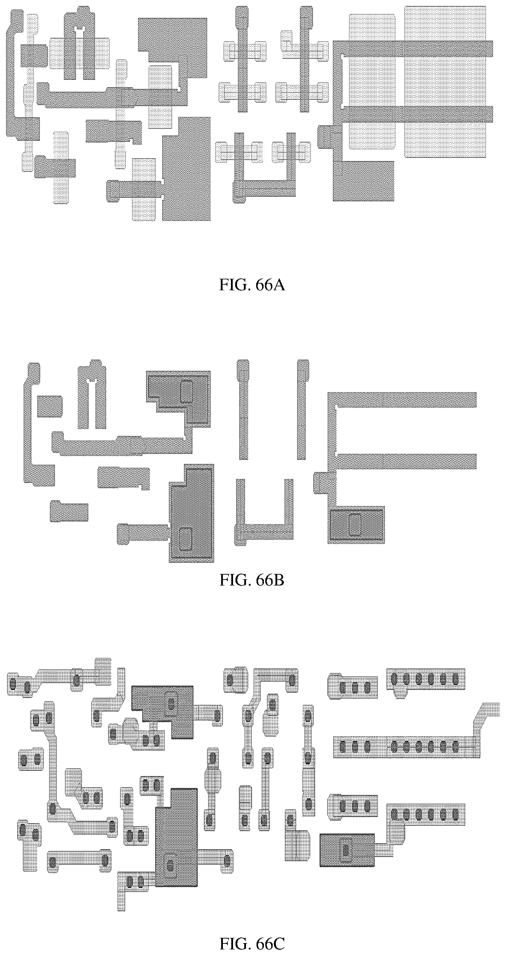

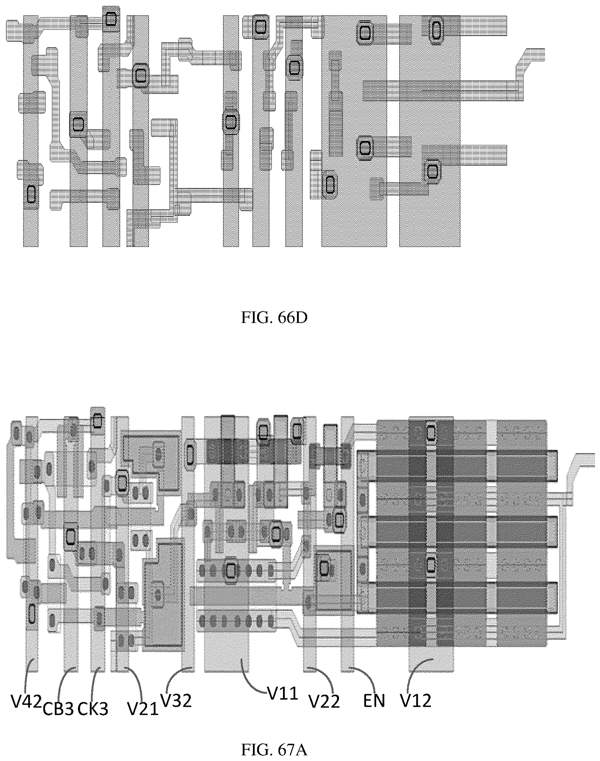

FIG. 66A is a superimposed diagram of the first semiconductor layer and the first gate metal layer in FIG. 60A, and FIG. 66B is a superimposed diagram of the first gate metal layer and the second gate metal layer in FIG. 60A; FIG. 66C is a superimposed diagram of the second gate metal layer and the first source-drain metal layer in FIG. 60A; FIG. 66D is a superimposed diagram of the first source-drain metal layer and the second source-drain metal layer in FIG. 60A.

In at least one embodiment of the display substrate shown in FIG. 60A, the first semiconductor layer, the first gate metal layer, the second gate metal layer, the first source-drain metal layer, and the second source-drain metal layer are arranged in sequence in a direction away from the base substrate.

At least one embodiment of the display substrate shown in FIG. 60A is a display substrate manufactured using a CMOS process.

In FIG.61, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, and AT8 is an active pattern of CT8;
A17 is the active pattern of T17, A18 is the active pattern of T18, A19 is the active pattern of T19, A20 is the active pattern of T20, A21 is the active pattern of T21, A22 is the active pattern of T22, A23 is the active pattern of T23, and A24 is the active pattern of T24.

In FIG. 62, CC11 is the first electrode plate of CC1, C61 is the first electrode plate of C6, and C71 is the first electrode plate of C7.

In FIG. 63, the one labeled CC12 is the second electrode plate of CC1, the one labeled C62 is the second electrode plate of C6, and the one labeled C72 is the second electrode plate of C7.

In at least one embodiment of the present disclosure, the first voltage line includes a first first voltage line, the second voltage line includes a first second voltage line, a second second voltage line and a third second voltage line sequentially arranged in a direction away from the display area; the enable signal line is arranged between the second second voltage line and the third second voltage line;
The orthographic projection of the first second voltage line on the base substrate at least partially overlaps the orthographic projection of the active pattern of at least part of the transistors included in the second control circuit on the base substrate;
The orthographic projection of the first first voltage line on the base substrate at least partially overlaps the orthographic projection of the active pattern of at least part of the transistors included in the second control circuit on the base substrate;
The orthographic projection of the first first voltage line on the base substrate at least partially overlaps the orthographic projection of the active pattern of at least part of the transistors included in the first control circuit on the base substrate;
The orthographic projection of the first first voltage line on the base substrate at least partially overlaps the orthographic projection of the electrode plate of the capacitor included in the first energy storage circuit on the base substrate;
The orthographic projection of the first second voltage line on the base substrate at least partially overlaps the orthographic projection of the electrode plate of the capacitor included in the first energy storage circuit on the base substrate;
The orthographic projection of the second second voltage line on the base substrate at least partially overlaps the orthographic projection of the active pattern of at least part of the transistors included in the first control circuit on the base substrate;
The orthographic projection of the enable signal line on the base substrate at least partially overlaps the orthographic projection of the active pattern of at least part of the transistors included in the control signal generation circuit on the base substrate;
An orthographic projection of the third second voltage line on the base substrate at least partially overlaps an orthographic projection of active patterns of at least part of transistors included in the control signal generation circuit on the base substrate.

In at least one embodiment of the present disclosure, the orthographic projection of each signal line on the base substrate at least partially overlaps the orthographic projection of the active pattern of the corresponding transistor on the base substrate, and the orthographic projection of the signal line on the base substrate at least partially overlap the orthographic projection of the electrode plate of the corresponding capacitor on the base substrate, so as to reduce the lateral space occupied by the driving circuit, thereby facilitating the realization of a narrow frame.

As shown in FIGS. 60A to 65, the first voltage line includes a first first voltage line V11, and the second voltage line includes a first second voltage line V12, a second second voltage line V22, and a third second voltage line V32 sequentially arranged in a direction away from the display area; the enable signal line EN is arranged between the second second voltage line V22 and the third second voltage line V32;
The orthographic projection of V12 on the base substrate at least partially overlaps the orthographic projection of the active pattern AT6 of CT6 on the base substrate;
The orthographic projection of V12 on the base substrate at least partially overlaps the orthographic projection of the active pattern AT5 of CT5 on the base substrate;
The orthographic projection of V11 on the base substrate at least partially overlaps the orthographic projection of the active pattern AT5 of CT5 on the base substrate; the orthographic projection of V11 on the base substrate at least partially overlaps the orthographic projection of the active pattern AT1 of CT1 on the base substrate; the orthographic projection of V11 on the base substrate at least partially overlaps the orthographic projection of the active pattern AT2 of CT2 on the base substrate;
The orthographic projection of V11 on the base substrate at least partially overlaps the orthographic projection of the first electrode plate CC11 of CC1 on the base substrate; the orthographic projection of V11 on the base substrate at least partially overlaps the orthographic projection of the second electrode plate CC12 of CC1 on the base substrate;
The orthographic projection of V12 on the base substrate at least partially overlaps the orthographic projection of the first electrode plate CC11 of CC1 on the base substrate; the orthographic projection of V12 on the base substrate at least partially overlaps the orthographic projection of the second electrode plate CC12 of CC1 on the base substrate;
The orthographic projection of V22 on the base substrate at least partially overlaps the orthographic projection of the active pattern AT2 of CT2 on the base substrate; the orthographic projection of V22 on the base substrate at least partially overlaps the orthographic projection of the active pattern AT1 of CT1 on the base substrate; the orthographic projection of V22 on the base substrate at least partially overlaps the orthographic projection of the active pattern AT3 of CT3 on the base substrate;
The orthographic projection of EN on the base substrate at least partially overlaps the orthographic projection of the active pattern AT7 of CT7 on the base substrate; the orthographic projection of EN on the base substrate at least partially overlaps the orthographic projection of the active pattern AT8 of CT8 on the base substrate; the orthographic projection of EN on the base substrate at least partially overlaps the orthographic projection of the active pattern AT4 of CT4 on the base substrate;
The orthographic projection of V32 on the base substrate at least partially overlaps the orthographic projection of the active pattern AT7 of CT7 on the base substrate; the orthographic projection of V32 on the base substrate at least partially overlaps the orthographic projection of the active pattern AT8 of CT8 on the base substrate; the orthographic projection of V32 on the base substrate at least partially overlaps the orthographic projection of the active pattern AT4 of CT4 on the base substrate.

In at least one embodiment of the present disclosure, the first voltage line includes a first first voltage line and a second first voltage line sequentially arranged along a direction away from the display area, and the second voltage line includes a first second voltage line, a second second voltage line, a third second voltage line and a fourth second voltage line sequentially arranged along a direction away from the display area;
The orthographic projection of the electrode plate of the capacitor included in the third energy storage circuit on the base substrate is arranged between the orthographic projection of the third second voltage line on the base substrate and the orthographic projection of the second first voltage line on the base substrate;
The orthographic projection of the second first voltage line on the base substrate at least partially overlaps the orthographic projection of the electrode plate of the capacitor included in the first output node control circuit on the base substrate;
The orthographic projection of the second first voltage line on the base substrate at least partially overlaps the orthographic projection of the active pattern of at least part of the transistors included in the output circuit on the base substrate;
An orthographic projection of the fourth second voltage line on the base substrate at least partially overlaps an orthographic projection of active patterns of at least part of transistors included in the first output node control circuit on the base substrate.

As shown in FIGS. 60A to 65, the first voltage lines include a first first voltage line V11 and a second first voltage line V21 sequentially arranged in a direction away from the display area, and the second voltage lines include a first second voltage line V12, a second second voltage line V22, a third second voltage line V32, and a fourth second voltage line V42 sequentially arranged in a direction away from the display area;
The orthographic projection of the first electrode plate C71 of C7 on the base substrate is arranged between the orthographic projection of V32 on the base substrate and the orthographic projection of V21 on the base substrate; the orthographic projection of the second electrode plate C72 of C7 on the base substrate is arranged between the orthographic projection of V32 on the base substrate and the orthographic projection of V21 on the base substrate;
The orthographic projection of V21 on the base substrate at least partially overlaps the orthographic projection of the first electrode plate C61 of C6 on the base substrate; the orthographic projection of V21 on the base substrate at least partially overlaps the orthographic projection of the second electrode plate C62 of C6 on the base substrate;
The orthographic projection of V21 on the base substrate at least partially overlaps the orthographic projection of the active pattern A23 of T23 on the base substrate;
The orthographic projection of V42 on the base substrate at least partially overlaps the orthographic projection of the active pattern A17 of T17 on the base substrate; the orthographic projection of V42 on the base substrate at least partially overlaps the orthographic projection of the active pattern A18 of T18 on the base substrate.

As shown in FIGS. 60A to 65, the third first clock signal line CK3 and the third second clock signal line CB3 are arranged between V21 and V42;
The orthographic projection of CK3 on the base substrate at least partially overlaps the orthographic projection of the active pattern A20 of T20 on the base substrate; the orthographic projection of CK on the base substrate at least partially overlaps the orthographic projection of the active pattern A21 of T21 on the base substrate;
The orthographic projection of CB3 on the base substrate at least partially overlaps the orthographic projection of the active pattern A19 of T19 on the base substrate.

As shown in FIGS. 60A-65, V12, V11, V22, EN, V32, V21, CK3, CB3 and V42 are arranged in sequence in the direction away from the display area, and V12, V11, V22, EN, V32, V21, CK3, CB3 and V42 are all arranged in the vertical direction.

In at least one embodiment of the present disclosure, the first voltage line includes a first first voltage line, and the second voltage line includes a first second voltage line and a second second voltage line sequentially arranged in a direction away from the display area; the enable signal line is arranged between the first second voltage line and the second second voltage line;
The orthographic projection of the first second voltage line on the base substrate at least partially overlaps the orthographic projection of the active pattern of at least part of the transistors included in the second control circuit on the base substrate;
The orthographic projection of the enable signal line on the base substrate at least partially overlaps the orthographic projection of the electrode plate of the capacitor included in the first energy storage circuit on the base substrate; the orthographic projection of the second second voltage line on the base substrate at least partially overlaps the orthographic projection of the active pattern of at least part of the transistors included in the control signal generation circuit on the base substrate;
The orthographic projection of the first first voltage line on the base substrate at least partially overlaps the orthographic projection of the active pattern of at least part of the transistors included in the second control circuit on the base substrate;
An orthographic projection of the first first voltage line on the base substrate at least partially overlaps an orthographic projection of active patterns of at least part of transistors included in the first control circuit on the base substrate.

In at least one embodiment of the present disclosure, the first voltage line includes a first first voltage line and a second first voltage line sequentially arranged along a direction away from the display area, and the second voltage line includes a first second voltage line, a second second voltage line, a third second voltage line and a fourth second voltage line sequentially arranged along a direction away from the display area;
The orthographic projection of the third second voltage line on the base substrate at least partially overlaps the orthographic projection of the electrode plate of the capacitor included in the third energy storage circuit on the base substrate;
The orthographic projection of the second first voltage line on the base substrate at least partially overlaps the orthographic projection of the electrode plate of the capacitor included in the first output node control circuit on the base substrate;
The orthographic projection of the second first voltage line on the base substrate at least partially overlaps the orthographic projection of the active pattern of at least part of the transistors included in the output circuit on the base substrate;
An orthographic projection of the fourth second voltage line on the base substrate at least partially overlaps an orthographic projection of active patterns of at least part of transistors included in the first output node control circuit on the base substrate.

In at least one embodiment of the present disclosure, the orthographic projection of each signal line on the base substrate at least partially overlaps the orthographic projection of the active pattern of the corresponding transistor on the base substrate, and the orthographic projection of the signal line on the base substrate at least partially overlap the orthographic projection of the electrode plate of the corresponding capacitor on the base substrate, so as to reduce the lateral space occupied by the driving circuit, thereby facilitating the realization of a narrow frame.

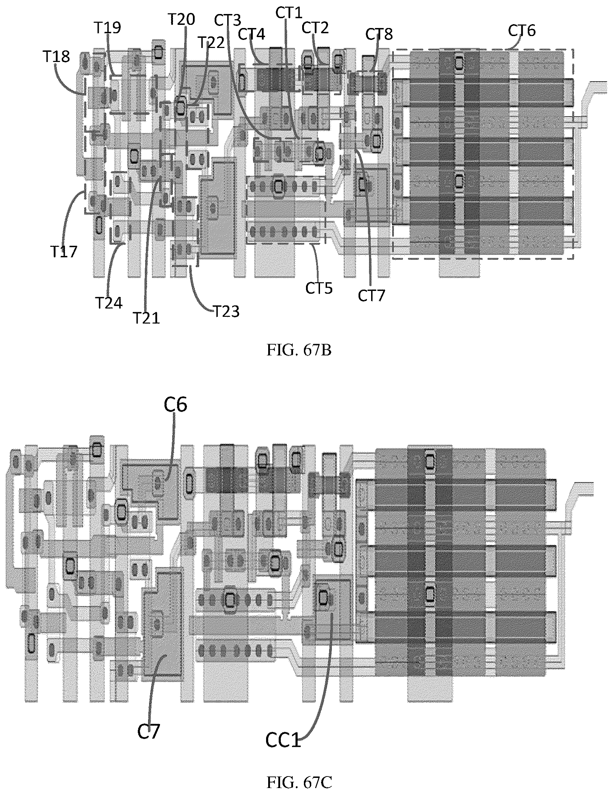

FIGS. 67A, 67B and 67C are second layout diagrams of a display substrate including the driving circuit shown in FIG. 20;

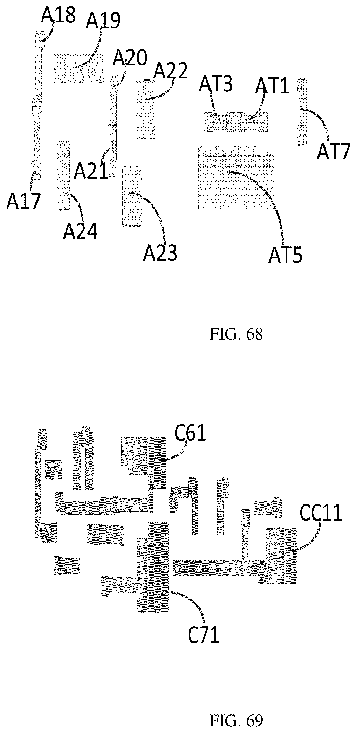

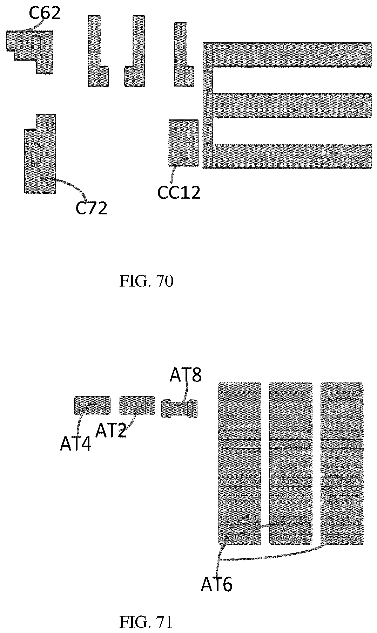

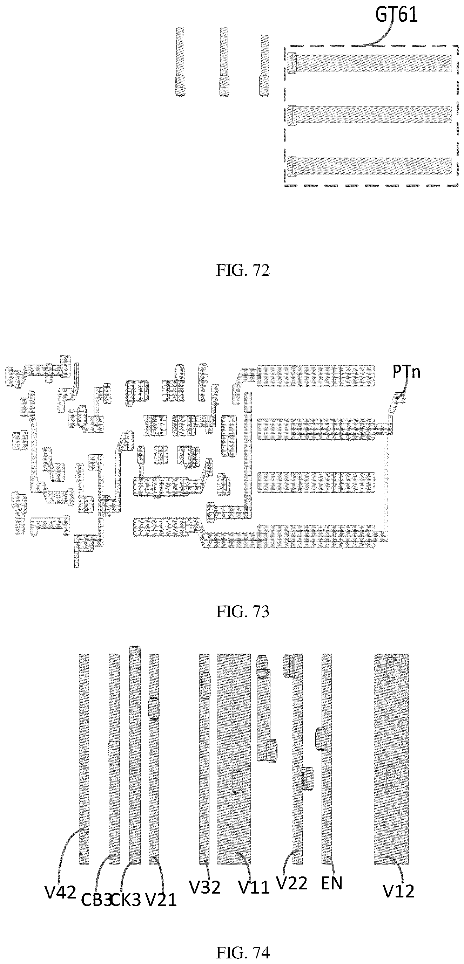

FIG. 68 is a layout diagram of the first semiconductor layer in FIG. 67A, FIG. 69 is a layout diagram of the first gate metal layer in FIG. 67A, FIG. 70 is a layout diagram of the second gate metal layer in FIG. 67A, FIG. 71 is a layout diagram of the second semiconductor layer in FIG. 67A, FIG. 72 is a layout diagram of the third gate metal layer in FIG. 67A, FIG. 73 is a layout diagram of the first source-drain metal layer in FIG. 67A, and FIG. 74 is a layout diagram of the second source-drain metal layer in FIG. 67A.

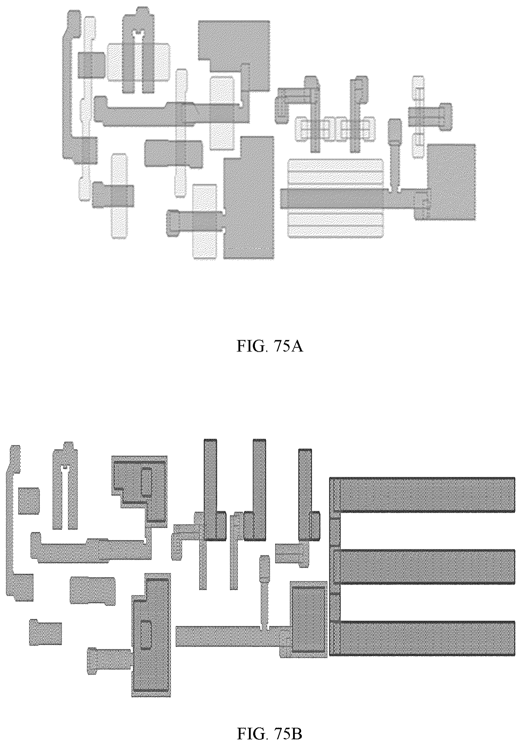

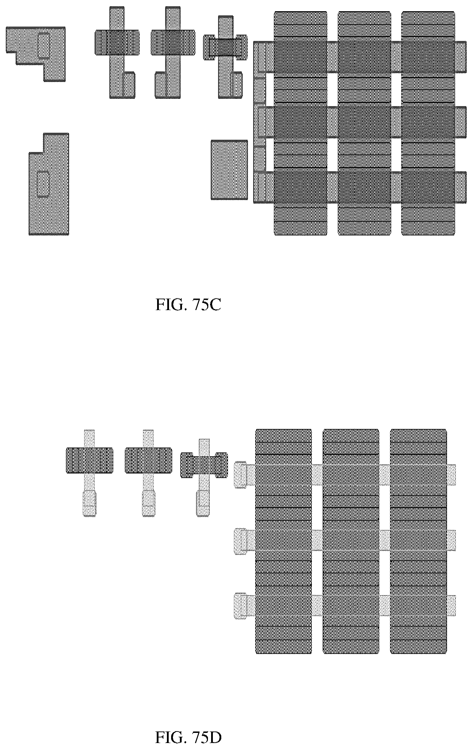

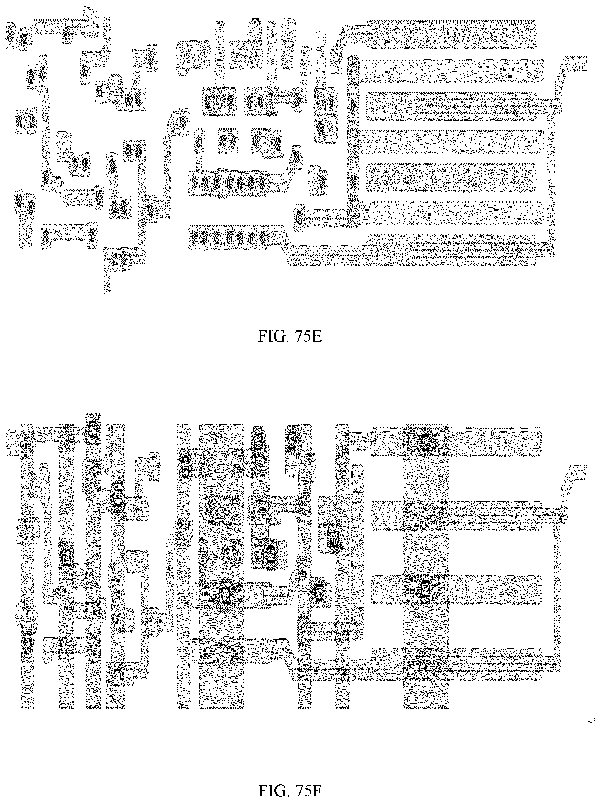

FIG. 75A is a layout diagram of the first semiconductor layer and the first gate metal layer in FIG. 67A, FIG. 75B is a layout diagram of the first gate metal layer and the second gate metal layer in FIG. 67A, FIG. 75C is a layout diagram of the second gate metal layer and the second semiconductor layer in FIG. 67A, FIG. 75D is a layout diagram of the third gate metal layer and the second semiconductor layer in FIG. 67A, FIG. 75E is a layout diagram of the third gate metal layer and the first source-drain metal layer in FIG. 67A, and FIG. 75F is a layout diagram of the first source-drain metal layer and the second source-drain metal layer in FIG. 67A.

In at least one embodiment of the display substrate shown in FIG. 67A, the first semiconductor layer, the first gate metal layer, the second gate metal layer, the second semiconductor layer, the third gate metal layer, the first source-drain metal layer and the second source-drain metal layer are arranged in sequence along the direction away from the base substrate.

The at least one embodiment of the display substrate shown in FIG. 67A is a display substrate manufactured using the LTPO process.

In FIGS. 68 and 71, AT1 is an active pattern of CT1, AT2 is an active pattern of CT2, AT3 is an active pattern of CT3, AT4 is an active pattern of CT4, AT5 is an active pattern of CT5, AT6 is an active pattern of CT6, AT7 is an active pattern of CT7, and AT8 is an active pattern of CT8;
A17 is the active pattern of T17, A18 is the active pattern of T18, A19 is the active pattern of T19, A20 is the active pattern of T20, A21 is the active pattern of T21, A22 is the active pattern of T22, A23 is the active pattern of T23, and A24 is the active pattern of T24.

In FIG. 69, CC11 is the first electrode plate of CC1, C61 is the first electrode plate of C6, and C71 is the first electrode plate of C7.

In FIG. 70, the one labeled CC12 is the second electrode plate of CC1, the one labeled C62 is the second electrode plate of C6, and the one labeled C72 is the second electrode plate of C7.

As shown in FIGS. 67A to 74, the first voltage lines include a first first voltage line V11, and the second voltage lines include a first second voltage line V12 and a second second voltage line V22 sequentially arranged in a direction away from the display area; an enable signal line EN is provided between the first second voltage line V12 and the second second voltage line V22;
The orthographic projection of V12 on the base substrate at least partially overlaps the orthographic projection of the active pattern AT6 of CT6 on the base substrate;
The orthographic projection of EN on the base substrate at least partially overlaps the orthographic projection of the first electrode plate CC11 of CC1 on the base substrate; the orthographic projection of EN on the base substrate at least partially overlaps the orthographic projection of the second electrode plate CC12 of CC1 on the base substrate;
The orthographic projection of V22 on the base substrate at least partially overlaps the orthographic projection of the active pattern AT7 of CT7 on the base substrate;
The orthographic projection of V11 on the base substrate at least partially overlaps the orthographic projection of the active pattern AT4 of CT4 on the base substrate; the orthographic projection of V11 on the base substrate at least partially overlaps the orthographic projection of the active pattern AT3 of CT3 on the base substrate; the orthographic projection of V11 on the base substrate at least partially overlaps the orthographic projection of the active pattern AT5 of CT5 on the base substrate.

As shown in FIGS. 67A to 74, the first voltage lines include a first first voltage line V11 and a second first voltage line V21 sequentially arranged in a direction away from the display area, and the second voltage lines include a first second voltage line V12, a second second voltage line V22, a third second voltage line V32, and a fourth second voltage line V42 sequentially arranged in a direction away from the display area;
The orthographic projection of V32 on the base substrate at least partially overlaps the orthographic projection of the first electrode plate C71 of C7 on the base substrate; the orthographic projection of V32 on the base substrate at least partially overlaps the orthographic projection of the second electrode plate C72 of C7 on the base substrate;
The orthographic projection of V21 on the base substrate at least partially overlaps the orthographic projection of the active pattern A23 of T23 on the base substrate;
The orthographic projection of V21 on the base substrate at least partially overlaps the orthographic projection of the first electrode plate C61 of C6 on the base substrate; the orthographic projection of V21 on the base substrate at least partially overlaps the orthographic projection of the second electrode plate C62 of C6 on the base substrate;
The orthographic projection of V42 on the base substrate at least partially overlaps the orthographic projection of the active pattern A17 of T17 on the base substrate;
The orthographic projection of V42 on the base substrate at least partially overlaps the orthographic projection of the active pattern A18 of T18 on the base substrate.

As shown in FIGS. 67A-74, CK3 and CB3 are arranged between V21 and V42;
The orthographic projection of CK3 on the base substrate at least partially overlaps the orthographic projection of the active pattern A20 of T20 on the base substrate; the orthographic projection of CK on the base substrate at least partially overlaps the orthographic projection of the active pattern A21 of T21 on the base substrate;
The orthographic projection of CB3 on the base substrate at least partially overlaps the orthographic projection of the active pattern A19 of T19 on the base substrate.

As shown in FIGS. 67A to 74, the active pattern AT6 of CT6 includes three independent active pattern portions;
The three mutually independent active pattern portions are spaced at a certain distance from each other to facilitate heat dissipation, so as to improve the performance of the transistor while ensuring the area of the active pattern.

The display device described in the embodiment of the present disclosure includes the above-mentioned display substrate.

The above is a preferred embodiment of the present disclosure. It should be pointed out that for ordinary skilled in the art, several improvements and modifications can be made without departing from the principles described in the present disclosure. These improvements and modifications should also be regarded as the scope of protection of the present disclosure.

## Claims

1. A driving circuit, comprising a driving signal generation circuit, a control signal generation circuit and a control circuit; wherein
the driving signal generation circuit is electrically connected to a first clock signal line and a second clock signal line respectively, and is configured to generate and output an nth stage of driving signal through an nth stage of driving signal output terminal under the control of a first clock signal provided by the first clock signal line and a second clock signal provided by the second clock signal line; n is a positive integer;
the control signal generation circuit is electrically connected to an enable signal line and a control signal terminal respectively, and is configured to output a control signal to the control signal terminal according to an enable signal provided by the enable signal line;
the control circuit is electrically connected with the control signal terminal and the nth stage of driving output terminal respectively, and is configured to output a signal to the nth stage of driving output terminal under the control of the control signal.

2. The driving circuit according to claim 1, further comprising an output inverting circuit; wherein
the output inverting circuit is electrically connected to the nth stage of driving signal output terminal, and is configured to invert the nth stage of driving signal to obtain and output an nth stage of inverted driving signal through an nth stage of inverted signal output terminal.

3. The driving circuit according to claim 1 or 2, wherein the control circuit comprises a first control circuit, a second control circuit and a first energy storage circuit;
the first control circuit is electrically connected to the control signal terminal, the nth stage of driving signal output terminal, a first control voltage line, a second control voltage line and a control output terminal respectively, and is configured to control the connection or disconnection between the control output terminal and the first control voltage line under the control of the control signal, control the connection or disconnection between the control output terminal and the first control voltage line under the control of the nth stage of driving signal output by the nth stage of driving signal output terminal, and control the connection or disconnection between the control output terminal and the second control voltage line under the control of the nth stage of driving signal and the control signal;
the second control circuit is electrically connected to the control output terminal, the nth stage of driving output terminal, a first voltage line and a second voltage line respectively, and is configured to control the connection or disconnection between the nth stage of driving output terminal and the first voltage line, and control the connection or disconnection between the nth stage of driving output terminal and the second voltage line under the control of a potential of the control output terminal;
the first energy storage circuit is electrically connected to the control output terminal and is configured to maintain the potential of the control output terminal.

4. The driving circuit according to claim 3, wherein the control circuit further comprises a second energy storage circuit;
the second energy storage circuit is electrically connected to the control signal terminal and is configured to maintain the potential of the control signal terminal.

5. The driving circuit according to claim 2, wherein:
the control signal generation circuit is also electrically connected to an (n-1)th stage of driving signal output terminal, an (n-1)th stage of inverted signal output terminal, the nth stage of driving signal output terminal and the nth stage of inverted signal output terminal, respectively, and is configured to control the connection or disconnection between the enable signal line and the control signal terminal under the control of an (n-1)th stage of driving signal, an (n-1)th stage of inverted driving signal, an (n-1)th stage of driving signal and an nth stage of inverted driving signal.

6. The driving circuit according to claim 1, wherein the control signal generation circuit is configured to invert the enable signal to generate an inverted enable signal, and output the inverted enable signal through the control signal terminal.

7. The driving circuit according to claim 3, wherein the first control circuit includes a first control transistor, a second control transistor, a third control transistor and a fourth control transistor; the second control circuit includes a fifth control transistor and a sixth control transistor; the first energy storage circuit includes a first capacitor; the first control voltage line is a first voltage line, the second control voltage line is a second voltage line;
a gate electrode of the first control transistor is electrically connected to the nth stage of driving signal output terminal, a first electrode of the first control transistor is electrically connected to the first control voltage line, and a second electrode of the first control transistor is electrically connected to the control output terminal;
a gate electrode of the second control transistor is electrically connected to the control signal terminal, a first electrode of the second control transistor is electrically connected to a second electrode of the fourth control transistor, and a second electrode of the second control transistor is electrically connected to the second control voltage line;
a gate electrode of the third control transistor is electrically connected to the control signal terminal, a first electrode of the third control transistor is electrically connected to the first control voltage line, and a second electrode of the third control transistor is electrically connected to the control output terminal;
a gate electrode of the fourth control transistor is electrically connected to the nth stage of driving signal output terminal, and a first electrode of the fourth control transistor is electrically connected to the control output terminal;
a gate electrode of the fifth control transistor is electrically connected to the control output terminal, a first electrode of the fifth control transistor is electrically connected to the first voltage line, and a second electrode of the fifth control transistor is electrically connected to the nth stage of driving output terminal;
a gate electrode of the sixth control transistor is electrically connected to the control output terminal, a first electrode of the sixth control transistor is electrically connected to the nth stage of driving output terminal, and a second electrode of the sixth control transistor is electrically connected to the second voltage line;
a first terminal of the first capacitor is electrically connected to the control output terminal, and a second terminal of the first capacitor is electrically connected to the second voltage line.

8. The driving circuit according to claim 3, wherein the first control circuit includes a first control transistor, a second control transistor, a third control transistor and a fourth control transistor; the second control circuit includes a fifth control transistor and a sixth control transistor; the first energy storage circuit includes a first capacitor; the first control voltage line is a second voltage line, and the second control voltage line is a first voltage line;
a gate electrode of the first control transistor is electrically connected to the control signal terminal, a first electrode of the first control transistor is electrically connected to a second electrode of the third control transistor, and a second electrode of the first control transistor is electrically connected to the control output terminal;
a gate electrode of the second control transistor is electrically connected to the control signal terminal, a first electrode of the second control transistor is electrically connected to the control output terminal, and a second electrode of the second control transistor is electrically connected to the second voltage line;
a gate electrode of the third control transistor is electrically connected to the nth stage of driving signal output terminal, and the first electrode of the third control transistor is electrically connected to the first voltage line;
a gate electrode of the fourth control transistor is electrically connected to the nth stage of driving signal output terminal, a first electrode of the fourth control transistor is electrically connected to the control output terminal, and a second electrode of the fourth control transistor is electrically connected to the second voltage line;
a gate electrode of the fifth control transistor is electrically connected to the control output terminal, a first electrode of the fifth control transistor is electrically connected to the first voltage line, and a second electrode of the fifth control transistor is electrically connected to the nth stage of driving output terminal;
a gate electrode of the sixth control transistor is electrically connected to the control output terminal, a first electrode of the sixth control transistor is electrically connected to the nth stage of driving output terminal, and a second electrode of the sixth control transistor is electrically connected to the second voltage line;
a first terminal of the first capacitor is electrically connected to the control output terminal, and a second terminal of the first capacitor is electrically connected to the second voltage line.

9. The driving circuit according to claim 4, wherein the second energy storage circuit comprises a second capacitor;
a first terminal of the second capacitor is electrically connected to the control signal terminal, and a second terminal of the second capacitor is electrically connected to the second voltage line.

10. The driving circuit according to claim 5, wherein the control signal generation circuit includes a seventh control transistor, an eighth control transistor, a ninth control transistor and a tenth control transistor;
a gate electrode of the seventh control transistor is electrically connected to the (n-1)th stage of driving signal output terminal, a first electrode of the seventh control transistor is electrically connected to the enable signal line, and a second electrode of the seventh control transistor is electrically connected to a first electrode of the tenth control transistor;
a gate electrode of the eighth control transistor is electrically connected to the (n-1)th stage of inverted signal output terminal, a first electrode of the eighth control transistor is electrically connected to the enable signal line, and a second electrode of the eighth control transistor is electrically connected to a first electrode of the ninth control transistor;
a gate electrode of the ninth control transistor is electrically connected to the nth stage of driving signal output terminal, the first electrode of the ninth control transistor is electrically connected to a first electrode of the tenth control transistor, and a second electrode of the ninth control transistor is electrically connected to the control signal terminal;
a gate electrode of the tenth control transistor is electrically connected to the nth stage of inverted signal output terminal, and a second electrode of the tenth control transistor is electrically connected to the control signal terminal;
the seventh control transistor and the tenth control transistor are both n-type transistors, and the eighth control transistor and the ninth control transistor are both p-type transistors; or,
the seventh control transistor and the tenth control transistor are both p-type transistors, and the eighth control transistor and the ninth control transistor are both n-type transistors.

11. The driving circuit according to claim 6, wherein the control signal generation circuit comprises a seventh control transistor and an eighth control transistor;
a gate electrode of the seventh control transistor is electrically connected to the enable signal line, a first electrode of the seventh control transistor is electrically connected to the first voltage line, and a second electrode of the seventh control transistor is electrically connected to the control signal terminal;
a gate electrode of the eighth control transistor is electrically connected to the enable signal line, a first electrode of the eighth control transistor is electrically connected to the control signal terminal, and a second electrode of the eighth control transistor is electrically connected to the second voltage line;
the seventh control transistor is a p-type transistor, and the eighth control transistor is an n-type transistor; or, the seventh control transistor is an n-type transistor, and the eighth control transistor is a p-type transistor.

12. The driving circuit according to claim 2, wherein the output inverting circuit comprises an eleventh control transistor and a twelfth control transistor;
a gate electrode of the eleventh control transistor is electrically connected to the nth stage of driving signal output terminal, a first electrode of the eleventh control transistor is electrically connected to the nth stage of inverted signal output terminal, and a second electrode of the eleventh control transistor is electrically connected to the second voltage line;
a gate electrode of the twelfth control transistor is electrically connected to the nth stage of driving signal output terminal, a first electrode of the twelfth control transistor is electrically connected to the first voltage line, and a second electrode of the twelfth control transistor is electrically connected to the nth stage of inverted signal output terminal.

13. The driving circuit according to claim 1, wherein the driving signal generation circuit includes a first node control circuit, a second node control circuit, a first output node control circuit, a second output node control circuit, a potential maintaining circuit and an output circuit; the first clock signal line includes a first first clock signal line, and the second clock signal line includes a first second clock signal line;
the first node control circuit is electrically connected to a first node, the first first clock signal line, a second voltage line, and a second output node, respectively, and is configured to control the connection between the first node and the second voltage line under the control of a first clock signal provided by the first first clock signal line, and to control the connection or disconnection between the first node and the first first clock signal line under the control of a potential of the second output node;
the second node control circuit is electrically connected to the first node, a first intermediate node, a first voltage line, a first second clock signal line, a second node, an input terminal and a second voltage line respectively, and is configured to control the first intermediate node to be connected to the first voltage line under the control of the potential of the first node, control the first intermediate node to be connected to the first second clock signal line under the control of a potential of the second node, and control the potential of the second node according to the potential of the first intermediate node, and control the input terminal to be connected to the second node under the control of the second clock signal provided by the first second clock signal line and the second voltage signal provided by the second voltage line;
the first output node control circuit is electrically connected to a first output node, the first node, the first second clock signal line, a second intermediate node, a second output node and a first voltage line respectively, and is configured to control the second intermediate node to be connected to the first second clock signal line under the control of the potential of the first node, control the potential of the second intermediate node according to the potential of the first node, control the second intermediate node to be connected to the first output node under the control of the second clock signal provided by the first second clock signal line, and control the first output node to be connected to the first voltage line under the control of the potential of the second output node;
the second output node control circuit is electrically connected to the first second clock signal line, the input terminal, the control voltage line, the first voltage line, the second node, and the second output node, respectively, and is configured to control the second output node to be connected to the input terminal under the control of the second clock signal provided by the first second clock signal line, control the potential of the second output node according to the potential of the second node, and control the second output node to be connected to the first voltage line under the control of the control voltage provided by the control voltage line;
the potential maintaining circuit is electrically connected to the first output node, and is configured to maintain the potential of the first output node;
the output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and control the connection between the nth stage of driving signal output terminal and the second voltage line under the control of the potential of the second output node.

14. The driving circuit according to claim 13, wherein the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the first first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the first first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the first first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
the second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the first second clock signal line, and a second electrode of the eighth transistor is electrically connected to the first intermediate node;
a gate electrode of the ninth transistor is electrically connected to the second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the first first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
the first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the first second clock signal line, and a second electrode of the twelfth transistor is electrically connected to the second intermediate node;
a gate electrode of the thirteenth transistor is electrically connected to the first second clock signal line, a first electrode of the thirteenth transistor is electrically connected to the second intermediate node, and a second electrode of the thirteenth transistor is electrically connected to the first output node;
a gate electrode of the fourteenth transistor is electrically connected to the first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and a second electrode plate of the fourth capacitor is electrically connected to the second intermediate node;
the potential maintaining circuit includes a fifth capacitor;
a first electrode plate of the fifth capacitor is electrically connected to the first output node, and a second electrode plate of the fifth capacitor is electrically connected to the first voltage line;
the output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
a gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

15. The driving circuit according to claim 3, wherein the driving signal generation circuit includes a first node control circuit, a second node control circuit, a first output node control circuit, a second output node control circuit, a potential maintaining circuit and an output circuit; the first clock signal line includes a second first clock signal line, and the second clock signal line includes a second second clock signal line;
the first node control circuit is electrically connected to the first node, the second first clock signal line, the second voltage line, and the second output node, respectively, and is configured to control the connection between the first node and the second voltage line under the control of the first clock signal provided by the second first clock signal line, and to control the connection or disconnection between the first node and the second first clock signal line under the control of the potential of the second output node;
the second node control circuit is electrically connected to the first node, the first intermediate node, the first voltage line, the second second clock signal line, the second node, the input terminal and the second voltage line respectively, and is configured to control the connection between the first intermediate node and the first voltage line under the control of the potential of the first node, control the connection between the first intermediate node and the second second clock signal line under the control of the potential of the second node, and control the potential of the second node according to the potential of the first intermediate node, and control the connection between the input terminal and the second node under the control of the second clock signal provided by the second second clock signal line and the second voltage signal provided by the second voltage line;
the first output node control circuit is electrically connected to the first output node, the first node, the second second clock signal line, the second intermediate node, the second output node and the first voltage line respectively, and is configured to control the second intermediate node to be connected to the second second clock signal line under the control of the potential of the first node, control the potential of the second intermediate node according to the potential of the first node, control the second intermediate node to be connected to the first output node under the control of the second clock signal provided by the second second clock signal line, and control the first output node to be connected to the first voltage line under the control of the potential of the second output node;
the second output node control circuit is electrically connected to the second second clock signal line, the input terminal, the control voltage line, the first voltage line, the second node, and the second output node, respectively, and is configured to control the second output node to be connected to the input terminal under the control of the second clock signal provided by the second second clock signal line, control the potential of the second output node according to the potential of the second node, and control the second output node to be connected to the first voltage line under the control of the control voltage provided by the control voltage line;
the potential maintaining circuit is electrically connected to the first output node, and is configured to maintain the potential of the first output node;
the output circuit is electrically connected to the first output node, the second output node, the first voltage line, the second voltage line and the nth stage of driving signal output terminal, respectively, and is configured to control the connection between the nth stage of driving signal output terminal and the first voltage line under the control of the potential of the first output node, and to control the connection between the nth stage of driving signal output terminal and the second voltage line under the control of the potential of the second output node.

16. The driving circuit according to claim 15, wherein the first node control circuit includes a first transistor, a second transistor and a third transistor; the second output node control circuit includes a fourth transistor, a fifth transistor, a sixth transistor and a seventh transistor;
a gate electrode of the first transistor is electrically connected to the second first clock signal line, a first electrode of the first transistor is electrically connected to the second voltage line, and a second electrode of the first transistor is electrically connected to a first electrode of the third transistor;
a gate electrode of the second transistor is electrically connected to a second electrode of the fourth transistor, a first electrode of the second transistor is electrically connected to the second first clock signal line, and a second electrode of the second transistor is electrically connected to a first electrode of the third transistor;
a gate electrode of the third transistor is electrically connected to the second voltage line, and a second electrode of the third transistor is electrically connected to the first node;
a gate electrode of the fourth transistor is electrically connected to the second first clock signal line, and a first electrode of the fourth transistor is electrically connected to the input terminal;
a gate electrode of the fifth transistor is electrically connected to the second voltage line, a first electrode of the fifth transistor is electrically connected to a second electrode of the fourth transistor, and a second electrode of the fifth transistor is electrically connected to the second output node;
a gate electrode of the sixth transistor and a first electrode of the sixth transistor are both electrically connected to the second node, and a second electrode of the sixth transistor is electrically connected to the second output node;
a gate electrode of the seventh transistor is electrically connected to the control voltage line, a first electrode of the seventh transistor is electrically connected to the first voltage line, and a second electrode of the seventh transistor is electrically connected to a first electrode of the fifth transistor;
the second node control circuit includes an eighth transistor, a ninth transistor, a tenth transistor, an eleventh transistor and a third capacitor;
a gate electrode of the eighth transistor is electrically connected to the second node, a first electrode of the eighth transistor is electrically connected to the second second clock signal line, and a second electrode of the eighth transistor is electrically connected to the first intermediate node;
a gate electrode of the ninth transistor is electrically connected to a second electrode of the first transistor, a first electrode of the ninth transistor is electrically connected to the first voltage line, and a second electrode of the ninth transistor is electrically connected to the first intermediate node;
a gate electrode of the tenth transistor is electrically connected to the second first clock signal line, a first electrode of the tenth transistor is electrically connected to the input terminal, and a second electrode of the tenth transistor is electrically connected to a first electrode of the eleventh transistor;
a gate electrode of the eleventh transistor is electrically connected to the second voltage line, and a second electrode of the eleventh transistor is electrically connected to the second node;
a first electrode plate of the third capacitor is electrically connected to the second node, and a second electrode plate of the third capacitor is electrically connected to the first intermediate node;
the first output node control circuit includes a twelfth transistor, a thirteenth transistor, a fourteenth transistor and a fourth capacitor;
a gate electrode of the twelfth transistor is electrically connected to the first node, a first electrode of the twelfth transistor is electrically connected to the second second clock signal line, and a second electrode of the twelfth transistor is electrically connected to the second intermediate node;
a gate electrode of the thirteenth transistor is electrically connected to the second second clock signal line, a first electrode of the thirteenth transistor is electrically connected to the second intermediate node, and a second electrode of the thirteenth transistor is electrically connected to the first output node;
a gate electrode of the fourteenth transistor is electrically connected to a first electrode of the fifth transistor, a first electrode of the fourteenth transistor is electrically connected to the first voltage line, and a second electrode of the fourteenth transistor is electrically connected to the first output node;
a first electrode plate of the fourth capacitor is electrically connected to the first node, and the second electrode plate of the fourth capacitor is electrically connected to the second intermediate node;
the potential maintaining circuit includes a fifth capacitor;
a first electrode plate of the fifth capacitor is electrically connected to the first output node, and a second electrode plate of the fifth capacitor is electrically connected to the first voltage line;
the output circuit includes a fifteenth transistor and a sixteenth transistor;
a gate electrode of the fifteenth transistor is electrically connected to the first output node, a first electrode of the fifteenth transistor is electrically connected to the first voltage line, and a second electrode of the fifteenth transistor is electrically connected to the nth stage of driving signal output terminal;
a gate electrode of the sixteenth transistor is electrically connected to the second output node, a first electrode of the sixteenth transistor is electrically connected to the nth stage of driving signal output terminal, and a second electrode of the sixteenth transistor is electrically connected to the second voltage line.

17. The driving circuit according to claim 3, wherein the driving signal generation circuit includes a first output node control circuit, a second output node control circuit, a third energy storage circuit and an output circuit; the first clock signal line includes a third first clock signal line, and the second clock signal line includes a third second clock signal line;
the first output node control circuit is electrically connected to the third first clock signal line, the second voltage line and the second output node respectively, and is configured to control the first output node to be connected to the second voltage line under the control of the first clock signal provided by the third first clock signal line, and to control the first output node to be connected to the third first clock signal line under the control of the potential of the second output node, and to maintain the potential of the first output node;
the second output node control circuit is electrically connected to the second output node, the third first clock signal line, the input terminal, the third second clock signal line, the first output node and the first voltage line respectively, and is configured to control the second output node to be connected to the input terminal under the control of the first clock signal, and to control the second output node to be connected to the first voltage line under the control of the potential of the first output node and the second clock signal provided by the third second clock signal line;
a first terminal of the third energy storage circuit is electrically connected to the second output node, a second terminal of the third energy storage circuit is electrically connected to the nth stage of driving signal output terminal, and the third energy storage circuit is configured to store electric energy;
the output circuit is electrically connected to the first output node, the second output node, the first voltage line, the second clock signal and the nth stage of driving signal output terminal, respectively, and is configured to control the connection between the nth stage of driving signal output terminal and the first voltage line under the control of the potential of the first output node, and to control the connection between the nth stage of driving signal output terminal and the third second clock signal line under the control of the potential of the second output node.

18. The driving circuit according to claim 17, wherein the first output node control circuit includes a seventeenth transistor, an eighteenth transistor and a sixth capacitor;
a gate electrode of the seventeenth transistor is electrically connected to the third first clock signal line, a first electrode of the seventeenth transistor is electrically connected to the second voltage line, and a second electrode of the seventeenth transistor is electrically connected to the first output node;
a gate electrode of the eighteenth transistor is electrically connected to the second output node, a first electrode of the eighteenth transistor is electrically connected to the third first clock signal line, and a second electrode of the eighteenth transistor is electrically connected to the first output node;
a first electrode plate of the sixth capacitor is electrically connected to the first output node, and a second electrode plate of the sixth capacitor is electrically connected to the first voltage line;
the second output node control circuit includes a nineteenth transistor, a twentieth transistor, and a twenty first transistor; the third energy storage circuit includes a seventh capacitor;
a gate electrode of the nineteenth transistor is electrically connected to the third first clock signal line, a first electrode of the nineteenth transistor is electrically connected to the input terminal, and a second electrode of the nineteenth transistor is electrically connected to the second output node;
a gate electrode of the twentieth transistor is electrically connected to the first output node, a first electrode of the twentieth transistor is electrically connected to the first voltage line, and a second electrode of the twentieth transistor is electrically connected to a first electrode of the twenty first transistor;
a gate electrode of the twenty first transistor is electrically connected to the third second clock signal line, and a second electrode of the twenty first transistor is electrically connected to the second output node;
a first electrode plate of the seventh capacitor is electrically connected to the second output node, and a second electrode plate of the seventh capacitor is electrically connected to the nth stage of driving signal output terminal;
the output circuit includes a twenty second transistor and a twenty third transistor;
a gate electrode of the twenty second transistor is electrically connected to the first output node, a first electrode of the twenty second transistor is electrically connected to the first voltage line, and a second electrode of the twenty second transistor is electrically connected to the nth stage of driving signal output terminal;
a gate electrode of the twenty third transistor is electrically connected to the second output node, a first electrode of the twenty third transistor is electrically connected to the nth stage of driving signal output terminal, and a second electrode of the twenty third transistor is electrically connected to the third second clock signal line;
the driving circuit further includes a twenty fourth transistor;
a second electrode of the twenty first transistor is electrically connected to the second output node through the twenty fourth transistor; a gate electrode of the twenty fourth transistor is electrically connected to the second voltage line, a first electrode of the twenty fourth transistor is electrically connected to a second electrode of the twenty first transistor, and a second electrode of the twenty fourth transistor is electrically connected to the second output node.

19. A display device comprising the display substrate according to any one of claims 1 to 18.
